# EUROPEAN PATENT APPLICATION

(11) **EP 1 107 139 A2**
(43) Date of publication of application: **13.06.2001**
(21) Application number: 00126216.1
(22) Date of filing: 30.11.2000
(51) Int. Cl.: G06F 17/50

(54) **Power model for EMI simulation of semiconductor integrated circuit, method of designing the power model, computer program, and storage medium storing the same**

(30) Priority: 30.11.1999 JP 33892299
(71) Applicant: NEC CORPORATION, Tokyo (JP)
(72) Inventor: Ogawa, Masashi, Minato-ku, Tokyo (JP); Wabuka, Hiroshi, Minato-ku, Tokyo (JP)
(74) Representative: Betten & Resch

(57) **Abstract**

The present invention provides a power model for a semiconductor integrated circuit, wherein the power model comprises a logic gate circuit part representing an operating part of the semiconductor integrated circuit and an equivalent internal capacitive part representing a non-operating part of the semiconductor integrated circuit.

## Description

The present invention relates to a power model for an electro-magnetic interference simulation to a semiconductor integrated circuit and a method of designing the power model as well as an electro-magnetic interference simulator having the power model, and a power model preparation computer program for generating the power model and a storage medium for storing the power model preparation computer program and further a power model design support system for designing the power model, and more particularly to a transistor description large scale integration power model for an electro-magnetic interference simulation to a semiconductor integrated circuit and a method of designing the transistor description large scale integration power model as well as an electro-magnetic interference simulator having the transistor description large scale integration power model, and a transistor description large scale integration power model preparation computer program for generating the power model and a storage medium for storing the transistor description large scale integration power model preparation computer program and further a transistor description large scale integration power model design support system for designing the transistor description large scale integration power model.

The conventional techniques relative to the above are disclosed in the following four documents, for example, Nikkei Electronics 1998,4-6, April 6, 1998, p. 143, 111, (hereinafter referred to as a first applicant's admitted prior art), and IEC TC93 New York Item Proposal, May 15, 1997 entitled "Models of Integrated Circuits for EMI Behavioral Simulation" (hereinafter referred to as a second applicant's admitted prior art), and Japanese laid-open patent publication No. 10-54865 (hereinafter referred to as a third applicant's admitted prior art), and Japanese laid-open patent publication No. 11-120214 (hereinafter referred to as a fourth applicant's admitted prior art).

In order to suppress an electromagnetic radiation noise from being generated from electric, electronic and electron devices, it is effective to take certain countermeasures against the generation of the electromagnetic radiation noise in the design step. For this reason, a major of circuit designers introduced an electro-magnetic interference simulator for their design work.

Actually, however, it often appears that the actually measured value does not correspond to the simulated value. One cause is that the most of the simulators does not analyze the power system of the circuit. An input/output buffer information specification (IBIS) model is one of the typical device models to be used in the electro-magnetic interference (EMI) simulator. The input/output buffer information specification (IBIS) model are that the input buffer and the output buffer are modeled. The electro-magnetic interference (EMI) simulator is based upon a simulation program with integrated circuit emphasis (SPICE) which is one of the circuit simulators, wherein models of the circuit elements are incorporated to calculate current values, so that a radiation electro-magnetic field is calculated from the current values.

The conventional electro-magnetic interference (EMI) simulation model for the large scale integrated circuit depends upon the signal-base analysis of the large scale integrated circuit with excluding power terminals and ground terminals from the circuit elements.

The power of the large scale integrated circuit is connected not only to the input/output buffers but also to internal circuits not directly relative to signal terminals, wherein currents flowing through the internal circuits include high frequency components, for which reason it is undesirable to ignore the radiation electro-magnetic field due to the power current. In order to analyze the electro-magnetic interference (EMI) of the electric, electronic and electron devices, it is essential to analyze the power current of the printed board for analysis of the radiation electro-magnetic field due to the power current.

In order to analyze the electro-magnetic interference (EMI) on the printed board, a model of the large scale integrated circuit mounted on the printed board is necessary in addition to a transmission lines of the printed board. The format of the large scale integrated circuit model is classified into a transistor description format and an operational level description format. The transistor description format is that the internal circuit configurations of the large scale integrated circuit are accurately described with transistor models, interconnection resistance models and capacitance models. The transistor description format is generally used for designing the large scale integrated circuit. The operational level description format is that the transistor description format is simplified. The operational level description format is generally used for noise certification of the printed board. The above described input/output buffer information specification (IBIS) model is described in the operational level description format. The analysis of the radiation electromagnetic field from the power current will be described in the above two different formats.

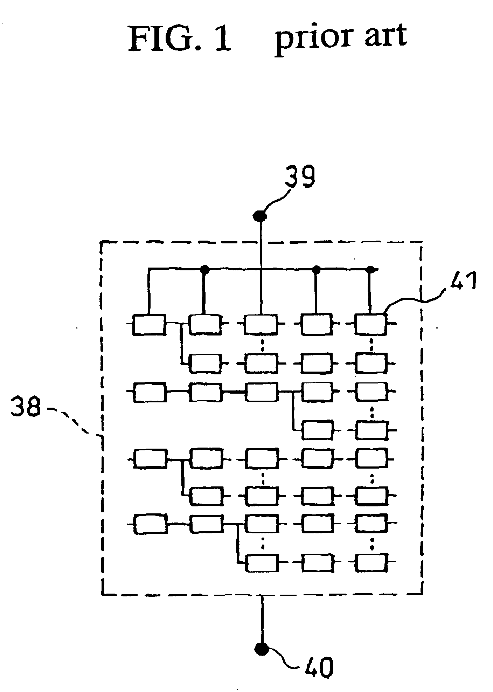

The transistor description formation is used to find the power current for analysis of the radiation electromagnetic field. It is necessary to analyze the entire circuit configurations of the large scale integrated circuit even the circuit scale is tremendously large. FIG. 1 is a schematic view illustrative of an equivalent circuit of a conventional power model in the transistor description format for the electro-magnetic interference (EMI) simulation of the semiconductor integrated circuit. The power model 38 in the transistor description format for the electro-magnetic interference (EMI) simulation of the semiconductor integrated circuit has a first power terminal 39, a second power terminal 40, and arrays of transistor blocks 40. A relatively small circuit scale, for example, a mask programmable read only memory needs about 5,000 transistors. A relatively large circuit scale, for example, a micro processor unit needs not less than about 1,000,000 transistors.

If, in accordance with the traditional signal-base analysis, the analysis only to the signal terminals is made, it is possible that the circuit models of the large scale integrated circuit is simplified into the input/output buffers only. Notwithstanding, in accordance with the analysis in the transistor description format, it is impossible to omit the circuits because all of the circuits are connected directly or indirectly to the power terminals. For this reason, a total amount of calculations by the electro-magnetic interference (EMI) simulator is tremendously larger than the traditional signal-base analysis. This makes it difficult or impossible to conduct the analysis. Further, it is necessary for the user to receive the large scale integrated circuit model from the maker who manufactures the large scale integrated circuit. Notwithstanding, the transistor description format model includes many confidential informations of the maker, for example, informations about transistor structure, manufacturing processes, and internal circuit configurations of the large scale integrated circuit. The maker usually hesitates to provide the user with the transistor description format model.

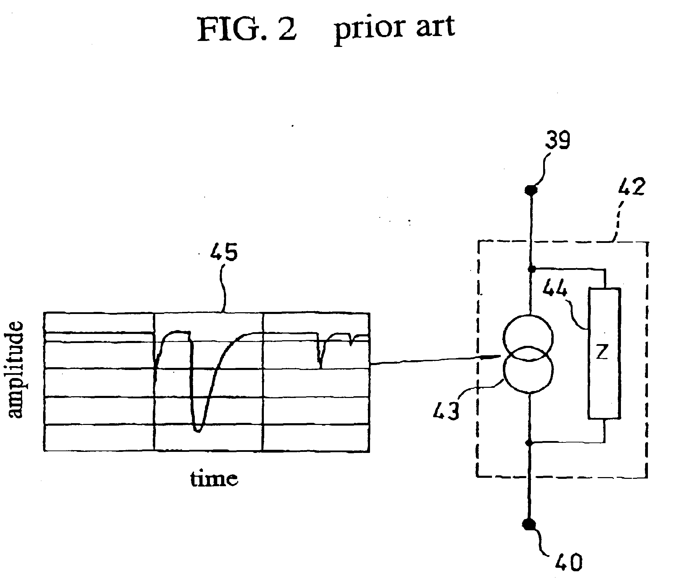

The following model was proposed for analysis of the radiation electromagnetic field in the operational level description format. FIG. 2 is a schematic view illustrative of an equivalent circuit of a conventional power model in the operational level description format for the electro-magnetic interference (EMI) simulation of the semiconductor integrated circuit, wherein the model comprises a current source and an impedance connected to the current source. A power model 42 for the electro-magnetic interference (EMI) simulation of the large scale integrated circuit has a first power terminal 39, a second power terminal 40, a current source 43 connected between the first and second power terminals 39 and 40, and an impedance 44 connected in parallel to the current source 43 and between the first and second power terminals 39 and 40, wherein the impedance 44 is connected across the current source 43. A display 45 displays a power current waveform from the current source, wherein a vertical axis represents an amplitude and a horizontal axis represents time. This method is, however, engaged with the following problems.

The internal impedance of the power terminal of the large scale integrated circuit varies depending upon inputs of signals and voltages of the power terminals. The variations in the internal impedance or resistance makes complicated current waveforms. In order to find a power current waveform of the power current, it is necessary to measure currents flowing from the power terminals in the actual circuit and convert the measured current values into the current waveform. The conversion method of converting the measured current values into the current waveform is not so difficult because the analysis in a frequency region causes that as the frequency is constant, the impedance is also constant.

However, if the analysis is made in the time region, then the impedance varies over time and not constant, whereby the conversion method is very complicated. It is difficult to find the current waveform of the current source on the basis of the time region.

If the current waveform is actually measured for finding the current waveform of the large scale integrated circuit, the current waveform includes informations about impedance of the DC power circuit. The impedance in the circuit is also present in the model, for which reason the effect of the impedance is doubly considered, whereby the obtainable current waveform is made inaccurate.

If in order to find the accurate current value of the power terminal, the simulation is made in accordance with the transistor description format model, then the above described problems are also raised.

In summery to the above descriptions, the first problem is that the conventional transistor description format large scale integrated circuit model is incapable of or is hard to the electro-magnetic interference (EMI) simulation to the power system of the large scale integrated circuit, because the circuit scale of the large scale integrated circuit is tremendously large and it is difficult to omit the circuits for conducting the simulation as the analysis to the signal terminals.

The second problem is that the operational level description format large scale integrated circuit model is very hard to conduct the electro-magnetic interference (EMI) simulation in the time region, because the internal impedance of the large scale integrated circuit varies over time or in the time region, whereby it is extremely difficult to represent the current waveform of the power source of the operational level description format large scale integrated circuit model.

The third problem is that the conventional electro-magnetic interference (EMI) simulation conducts the analysis in the inaccurate state, because as the large scale integrated circuit is in the actual operation state, only parts of the large scale integrated circuit are operated. Namely, the analysis is made depending upon the actually operated parts of the large scale integrated circuit but not entire of the circuit.

In the above circumstances, it had been required to develop a novel invention free from the above problem.

Accordingly, it is an object of the present invention to provide a novel power model for an electro-magnetic interference simulation to a semiconductor integrated circuit free from the above problems.

It is a further object of the present invention to provide a novel power model for an electro-magnetic interference simulation to a semiconductor integrated circuit, wherein the power model allows an extremely accurate electro-magnetic interference simulation from a power system of a printed board.

It is a still further object of the present invention to provide a novel power model for an electro-magnetic interference simulation to a semiconductor integrated circuit, wherein the power model makes it easy to conduct an extremely accurate electro-magnetic interference simulation from a power system of a printed board.

It is yet a further object of the present invention to provide a novel power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

It is a further more object of the present invention to provide a novel power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

It is moreover object of the present invention to provide a novel method of designing a power model for an electro-magnetic interference simulation to a semiconductor integrated circuit free from the above problems.

It is still more object of the present invention to provide a novel method of designing a power model for an electro-magnetic interference simulation to a semiconductor integrated circuit, wherein the method allows an extremely accurate electro-magnetic interference simulation from a power system of a printed board.

It is yet more object of the present invention to provide a novel method of designing a power model for an electro-magnetic interference simulation to a semiconductor integrated circuit, wherein the method makes it easy to conduct an extremely accurate electro-magnetic interference simulation from a power system of a printed board.

It is still further more object of the present invention to provide a novel method of designing a power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

It is yet further more object of the present invention to provide a novel method of designing a power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

It is another object of the present invention to provide a novel electro-magnetic interference simulator using a power model for an electro-magnetic interference simulation to a semiconductor integrated circuit free from the above problems.

It is further another object of the present invention to provide a novel electro-magnetic interference simulator using a power model for an electro-magnetic interference simulation to a semiconductor integrated circuit, wherein the electro-magnetic interference simulator allows an extremely accurate electro-magnetic interference simulation from a power system of a printed board.

It is still another object of the present invention to provide a novel electro-magnetic interference simulator using a power model for an electro-magnetic interference simulation to a semiconductor integrated circuit, wherein the electro-magnetic interference simulator makes it easy to conduct an extremely accurate electro-magnetic interference simulation from a power system of a printed board.

It is yet another object of the present invention to provide a novel electro-magnetic interference simulator using a power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

It is more another object of the present invention to provide a novel electro-magnetic interference simulator using a power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

It is a still further another object of the present invention to provide a novel power model preparation computer program for preparing a power model for an electro-magnetic interference simulation to a semiconductor integrated circuit free from the above problems.

It is a yet further another object of the present invention to provide a novel power model preparation computer program for preparing a power model for an electro-magnetic interference simulation to a semiconductor integrated circuit, wherein the power model preparation computer program allows an extremely accurate electro-magnetic interference simulation from a power system of a printed board.

It is furthermore another object of the present invention to provide a novel power model preparation computer program for preparing a power model for an electro-magnetic interference simulation to a semiconductor integrated circuit, wherein the power model preparation computer program makes it easy to conduct an extremely accurate electro-magnetic interference simulation from a power system of a printed board.

It is moreover another object of the present invention to provide a novel power model preparation computer program for preparing a power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

It is still moreover another object of the present invention to provide a novel power model preparation computer program for preparing a power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

It is an additional object of the present invention to provide a novel storage medium for storing a power model preparation computer program for preparing a power model for an electro-magnetic interference simulation to a semiconductor integrated circuit free from the above problems.

It is a further additional object of the present invention to provide a novel storage medium for storing a power model preparation computer program for preparing a power model for an electro-magnetic interference simulation to a semiconductor integrated circuit, wherein the power model preparation computer program allows an extremely accurate electro-magnetic interference simulation from a power system of a printed board.

It is a still further additional object of the present invention to provide a novel storage medium for storing a power model preparation computer program for preparing a power model for an electro-magnetic interference simulation to a semiconductor integrated circuit, wherein the power model preparation computer program makes it easy to conduct an extremely accurate electro-magnetic interference simulation from a power system of a printed board.

It is yet a further additional object of the present invention to provide a novel storage medium for storing a power model preparation computer program for preparing a power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

It is a further more additional object of the present invention to provide a novel storage medium for storing a power model preparation computer program for preparing a power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

It is also an additional object of the present invention to provide a novel power model design support system for supporting a design for a power model for an electro-magnetic interference simulation to a semiconductor integrated circuit free from the above problems.

It is also an additional object of the present invention to provide a novel power model design support system for supporting a design for a power model for an electro-magnetic interference simulation to a semiconductor integrated circuit, wherein the power model allows an extremely accurate electro-magnetic interference simulation from a power system of a printed board.

It is also an additional object of the present invention to provide a novel power model design support system for supporting a design for a power model for an electro-magnetic interference simulation to a semiconductor integrated circuit, wherein the power model makes it easy to conduct an extremely accurate electro-magnetic interference simulation from a power system of a printed board.

It is also an additional object of the present invention to provide a novel power model design support system for supporting a design for a power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

It is also an additional object of the present invention to provide a novel power model design support system for supporting a design for a power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

The novel electro-magnetic interference (EMI) simulation model in accordance with the present invention is represented in the transistor description format for conducting the simulation to the radiation electro-magnetic field generated on the printed board. This transistor description format large scale integrated circuit power model is largely reduced in the number of transistors constituting this model. The electro-magnetic interference (EMI) simulator utilizes this transistor description format large scale integrated circuit power model to find a power current which flows on an interconnection of a printed board. This transistor description format large scale integrated circuit power model is prepared by extracting operating parts from a net-list for the large scale integrated circuit to reduce the number of transistors constituting this model. Non-operating parts of the large scale integrated circuit are simplified to be incorporated into the model. Namely, the transistor description format large scale integrated circuit power model includes the operating parts extracted from the net-list and the simplified non-operating parts, so that all of the parts of the large scale integrated circuit are utilized to prepare the transistor description format large scale integrated circuit power model.

The above and other objects, features and advantages of the present invention will be apparent from the following descriptions.

Preferred embodiments according to the present invention will be described in detail with reference to the accompanying drawings.

FIG. 1 is a schematic view illustrative of an equivalent circuit of a conventional power model in the transistor description format for the electro-magnetic interference (EMI) simulation of the semiconductor integrated circuit.

FIG. 2 is a schematic view illustrative of an equivalent circuit of a conventional power model in the operational level description format for the electro-magnetic interference (EMI) simulation of the semiconductor integrated circuit.

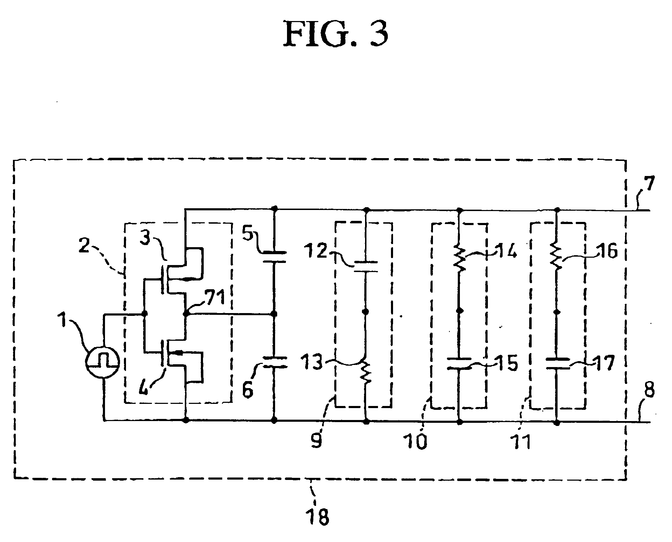

FIG. 3 is a circuit diagram illustrative of a first novel power model for an electro-magnetic interference simulation to a semiconductor integrated circuit in a first embodiment in accordance with the present invention.

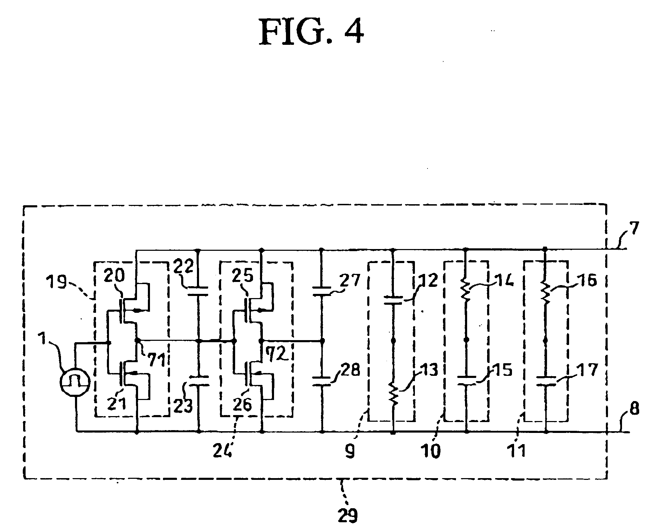

FIG. 4 is a circuit diagram illustrative of a second novel power model for an electro-magnetic interference simulation to a semiconductor integrated circuit in a second embodiment in accordance with the present invention.

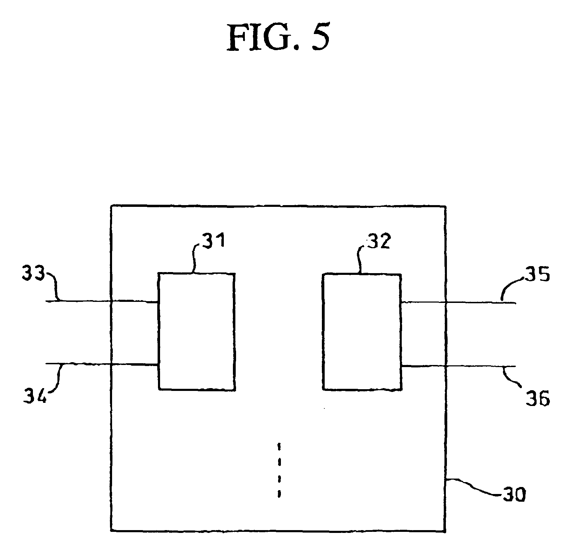

FIG. 5 is a circuit diagram illustrative of a third novel power model for an electro-magnetic interference simulation to a semiconductor integrated circuit in a third embodiment in accordance with the present invention.

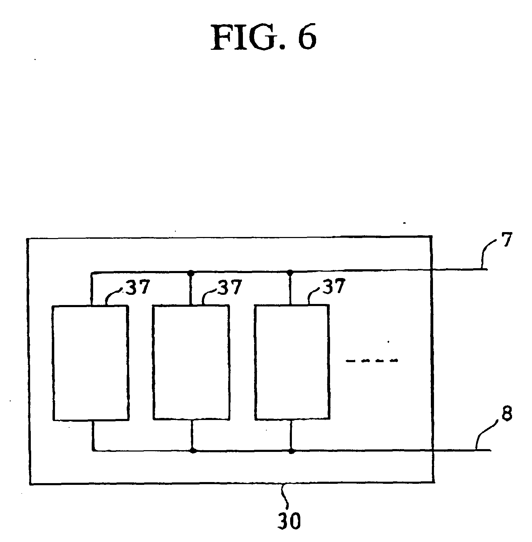

FIG. 6 is a circuit diagram illustrative of a fourth novel power model for an electro-magnetic interference simulation to a semiconductor integrated circuit in a fourth embodiment in accordance with the present invention.

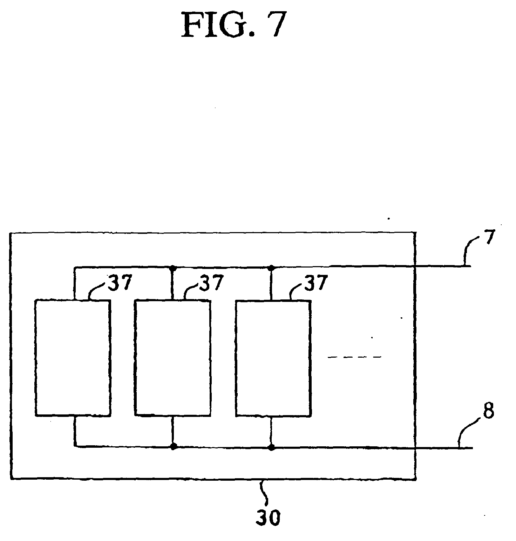

FIG. 7 is a circuit diagram illustrative of a fifth novel power model for an electro-magnetic interference simulation to a semiconductor integrated circuit in a fifth embodiment in accordance with the present invention.

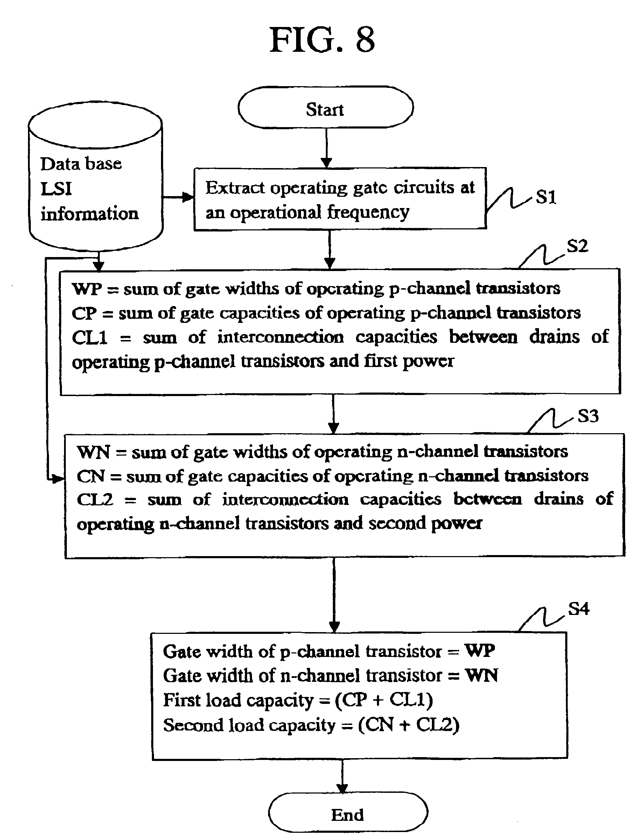

FIG. 8 is flow chart illustrative of novel processes for modeling internal circuit configurations of a semiconductor integrated circuit into a single gate circuit, wherein the novel processes are involved in a first novel method of designing a power model for an electro-magnetic interference simulation to a semiconductor integrated circuit in a sixth embodiment in accordance with the present invention.

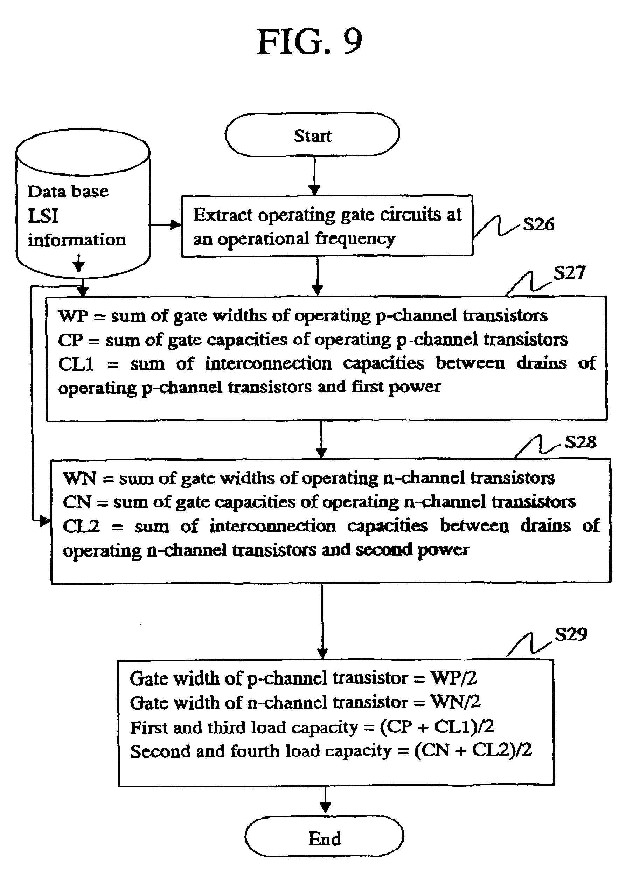

FIG. 9 is flow chart illustrative of novel processes for modeling internal circuit configurations of a semiconductor integrated circuit into two-stage gate circuits, wherein the novel processes are involved in the first novel method of designing a power model for an electro-magnetic interference simulation to a semiconductor integrated circuit in a seventh embodiment in accordance with the present invention.

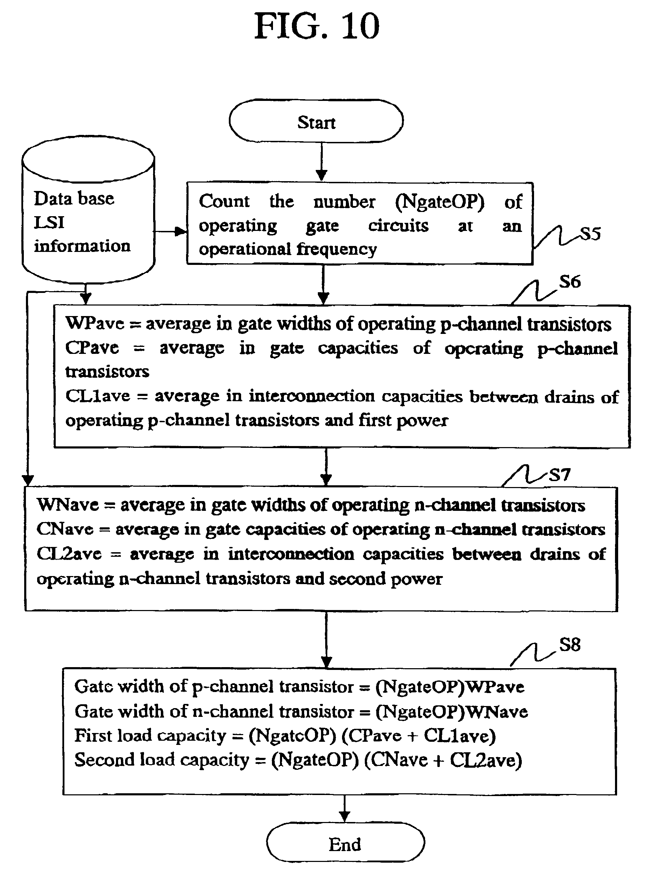

FIG. 10 is flow chart illustrative of novel processes for modeling internal circuit configurations of a semiconductor integrated circuit into a single gate circuit, wherein the novel processes are involved in a second novel method of designing a power model for an electro-magnetic interference simulation to a semiconductor integrated circuit in an eighth embodiment in accordance with the present invention.

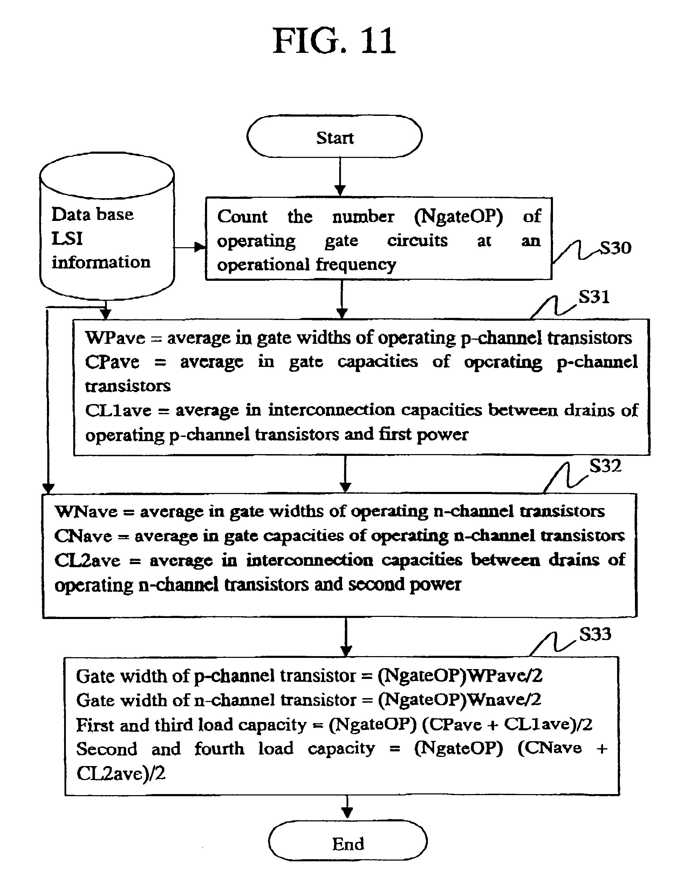

FIG. 11 is flow chart illustrative of novel processes for modeling internal circuit configurations of a semiconductor integrated circuit into two-stage gate circuits, wherein the novel processes are involved in a second novel method of designing a power model for an electro-magnetic interference simulation to a semiconductor integrated circuit in a ninth embodiment in accordance with the present invention.

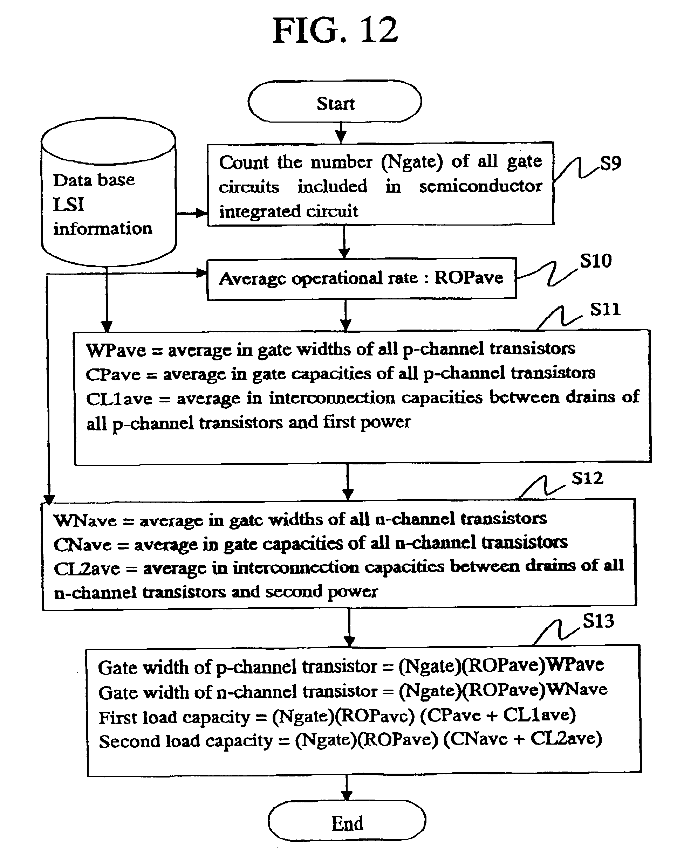

FIG. 12 is flow chart illustrative of novel processes for modeling internal circuit configurations of a semiconductor integrated circuit into a single gate circuit, wherein the novel processes are involved in a third novel method of designing a power model for an electro-magnetic interference simulation to a semiconductor integrated circuit in a tenth embodiment in accordance with the present invention.

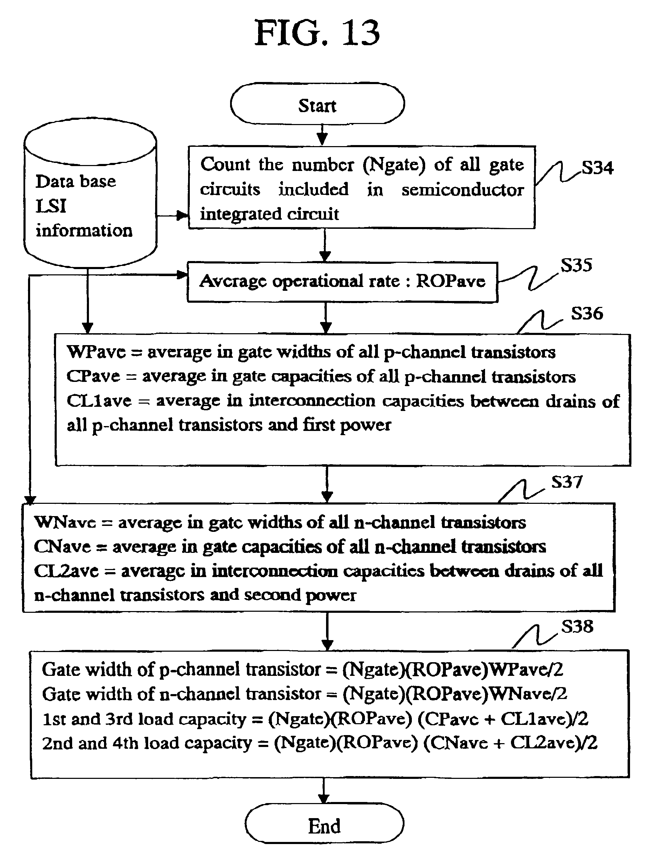

FIG. 13 is flow chart illustrative of novel processes for modeling internal circuit configurations of a semiconductor integrated circuit into two-stage gate circuits, wherein the novel processes are involved in a third novel method of designing a power model for an electro-magnetic interference simulation to a semiconductor integrated circuit in an eleventh embodiment in accordance with the present invention.

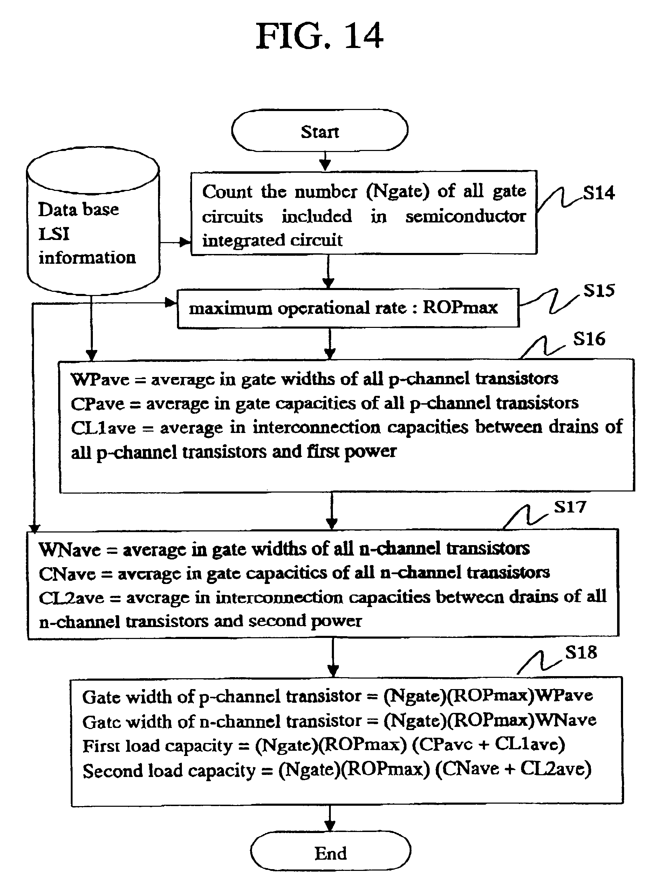

FIG. 14 is flow chart illustrative of novel processes for modeling internal circuit configurations of a semiconductor integrated circuit into a single gate circuit, wherein the novel processes are involved in a fourth novel method of designing a power model for an electro-magnetic interference simulation to a semiconductor integrated circuit in a twelfth embodiment in accordance with the present invention.

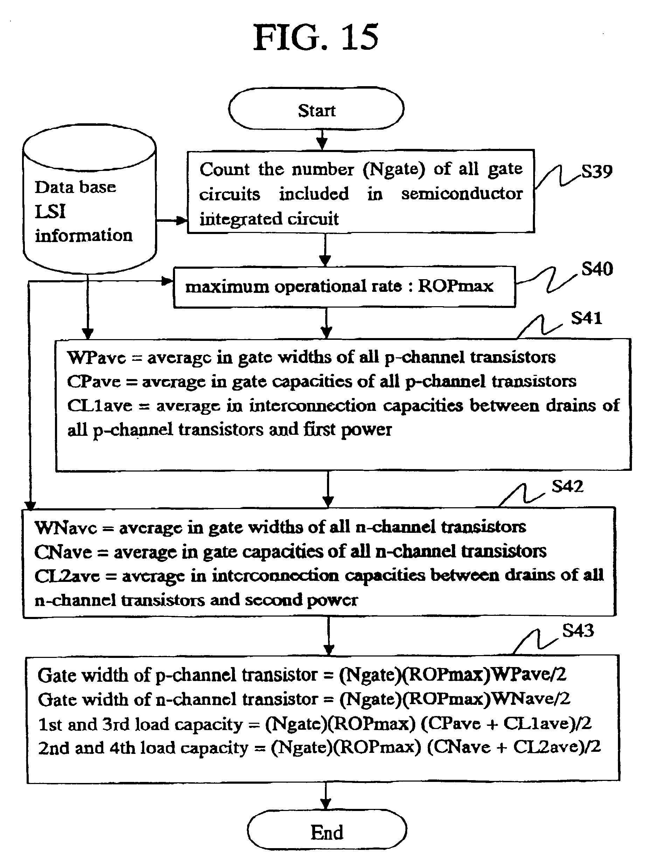

FIG. 15 is flow chart illustrative of novel processes for modeling internal circuit configurations of a semiconductor integrated circuit into two-stage gate circuits, wherein the novel processes are involved in a fourth novel method of designing a power model for an electro-magnetic interference simulation to a semiconductor integrated circuit in a thirteenth embodiment in accordance with the present invention.

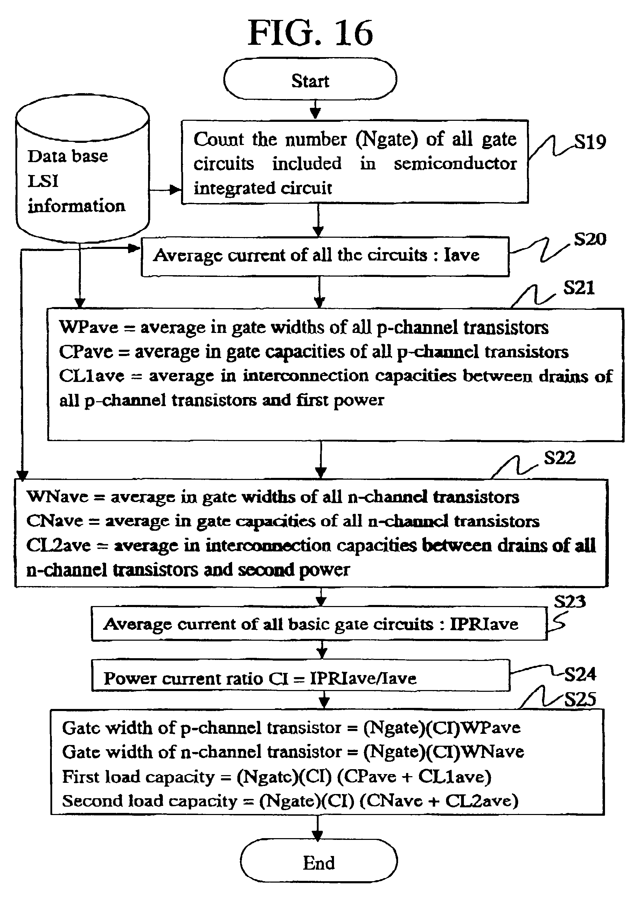

FIG. 16 is flow chart illustrative of novel processes for modeling internal circuit configurations of a semiconductor integrated circuit into a single gate circuit, wherein the novel processes are involved in a fifth novel method of designing a power model for an electro-magnetic interference simulation to a semiconductor integrated circuit in a fourteenth embodiment in accordance with the present invention.

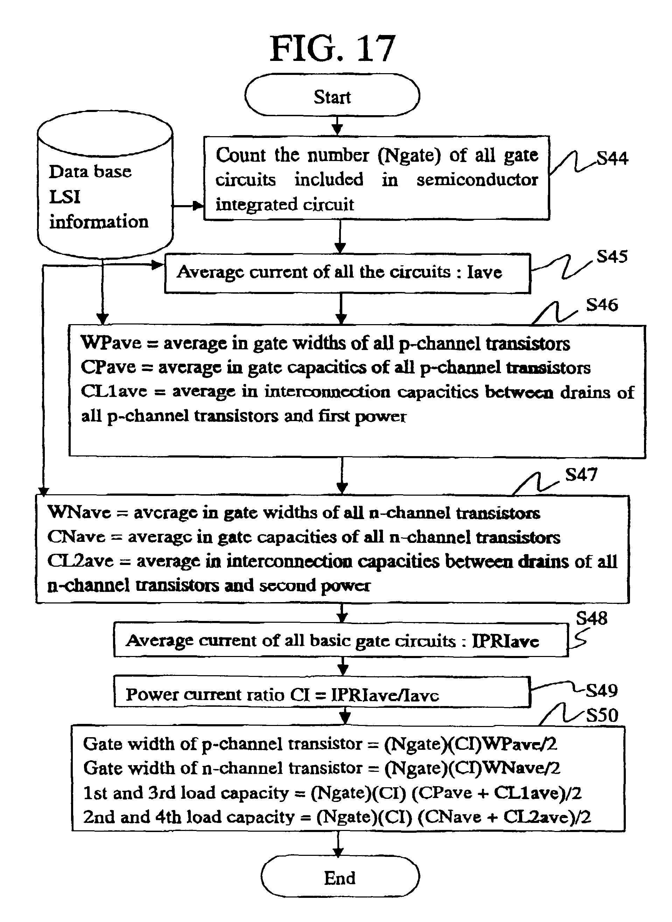

FIG. 17 is flow chart illustrative of novel processes for modeling internal circuit configurations of a semiconductor integrated circuit into two stage gate circuits, wherein the novel processes are involved in a fifth novel method of designing a power model for an electro-magnetic interference simulation to a semiconductor integrated circuit in a fifteenth embodiment in accordance with the present invention.

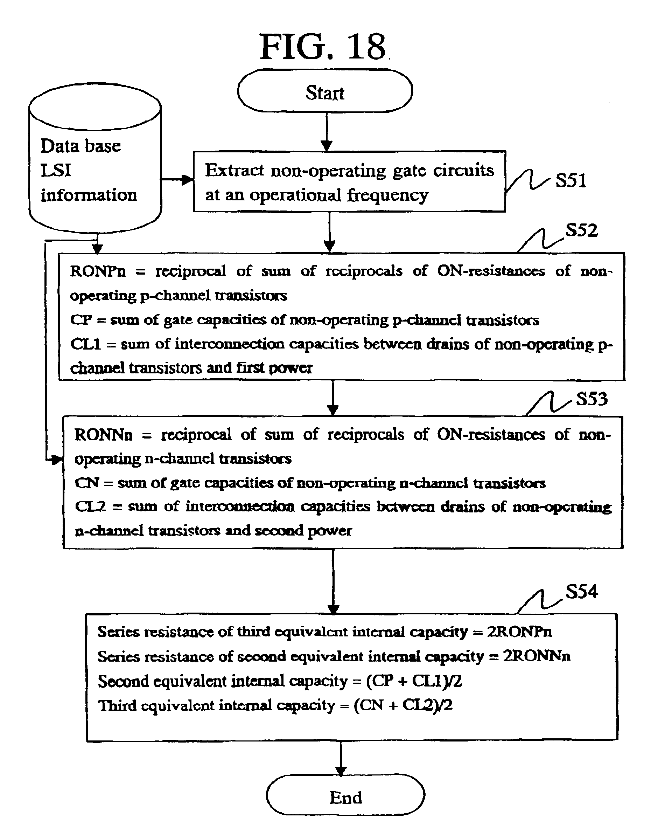

FIG. 18 is flow chart illustrative of novel processes for modeling internal circuit configurations of a semiconductor integrated circuit into an equivalent internal capacitive part, wherein the novel processes are involved in the first novel method of designing a power model for an electro-magnetic interference simulation to a semiconductor integrated circuit in a sixteenth embodiment in accordance with the present invention.

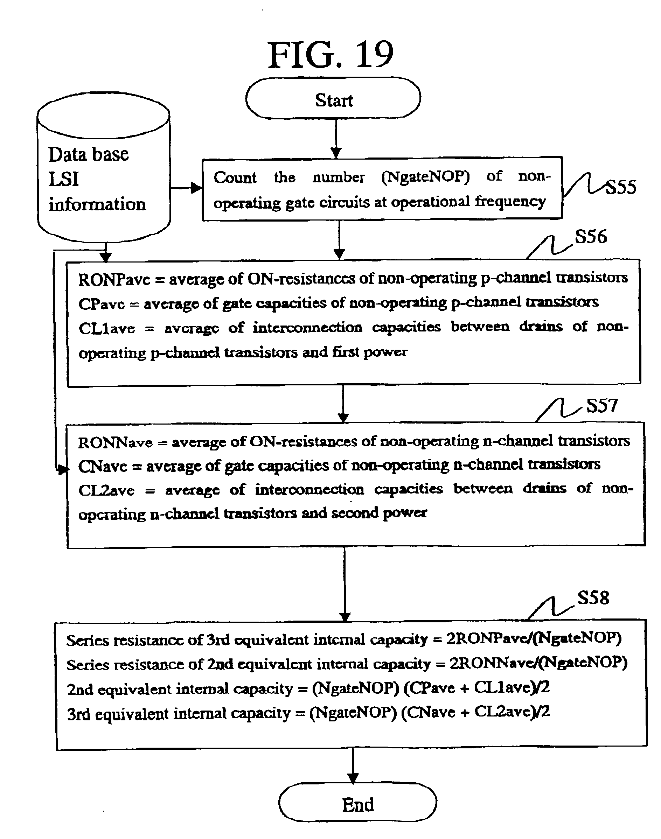

FIG. 19 is flow chart illustrative of novel processes for modeling internal circuit configurations of a semiconductor integrated circuit into an equivalent internal capacitive part, wherein the novel processes are involved in the second novel method of designing a power model for an electro-magnetic interference simulation to a semiconductor integrated circuit in a seventeenth embodiment in accordance with the present invention.

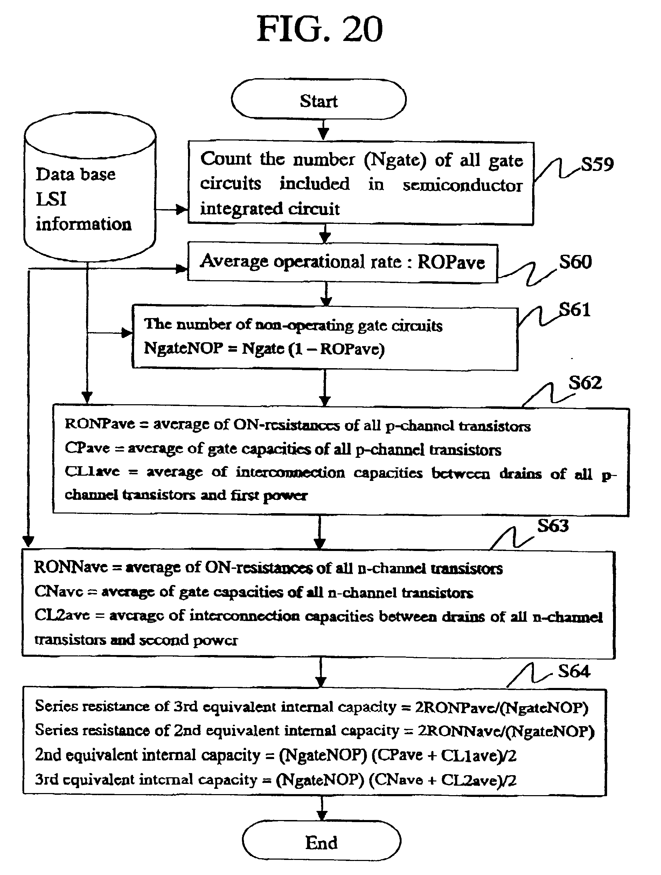

FIG. 20 is flow chart illustrative of novel processes for modeling internal circuit configurations of a semiconductor integrated circuit into an equivalent internal capacitive part, wherein the novel processes are involved in the third novel method of designing a power model for an electro-magnetic interference simulation to a semiconductor integrated circuit in an eighteenth embodiment in accordance with the present invention.

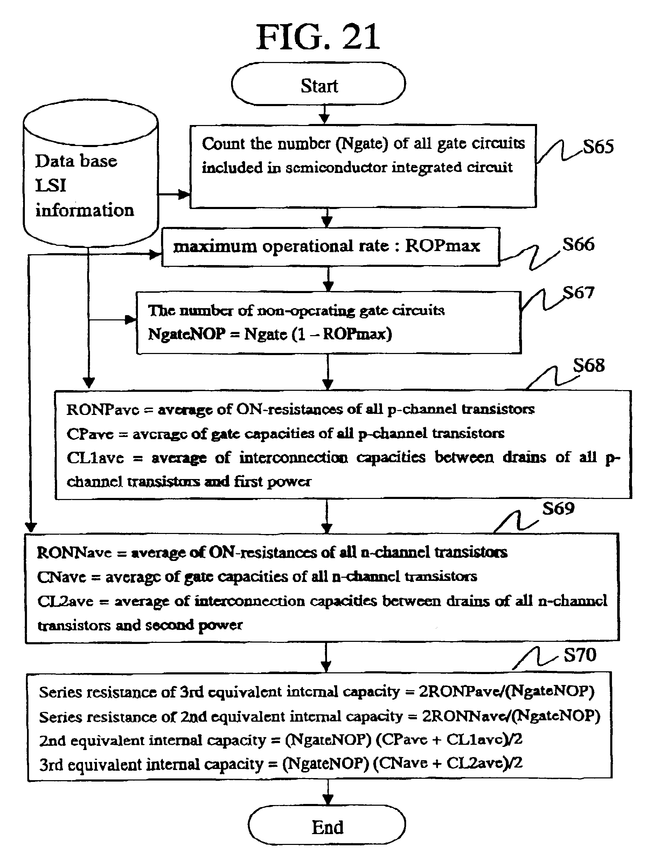

FIG. 21 is flow chart illustrative of novel processes for modeling internal circuit configurations of a semiconductor integrated circuit into an equivalent internal capacitive part, wherein the novel processes are involved in the fourth novel method of designing a power model for an electro-magnetic interference simulation to a semiconductor integrated circuit in a nineteenth embodiment in accordance with the present invention.

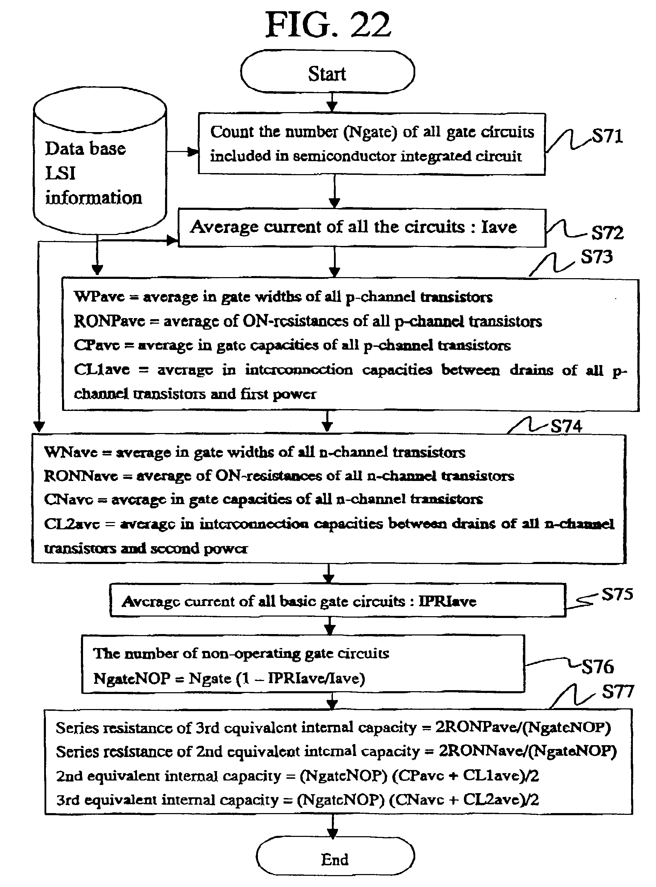

FIG. 22 is flow chart illustrative of novel processes for modeling internal circuit configurations of a semiconductor integrated circuit into an equivalent internal capacitive part, wherein the novel processes are involved in the fifth novel method of designing a power model for an electro-magnetic interference simulation to a semiconductor integrated circuit in a twentieth embodiment in accordance with the present invention.

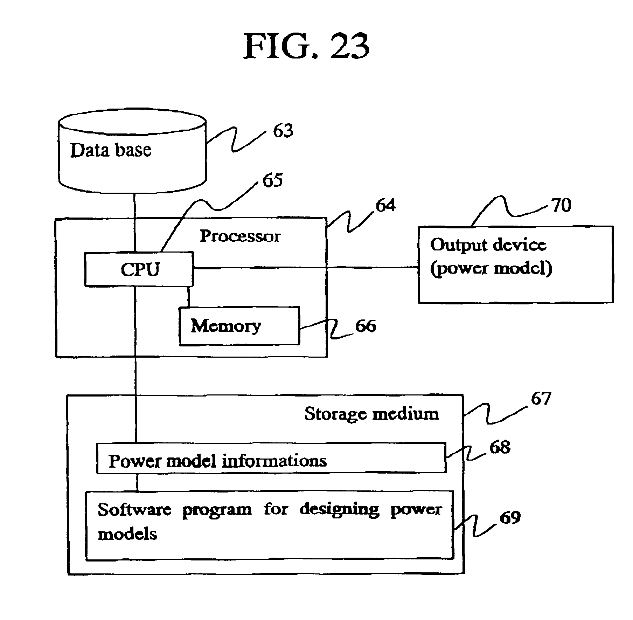

FIG. 23 is a block diagram illustrative of a support system for designing a power model in a twenty first embodiment according to the present invention.

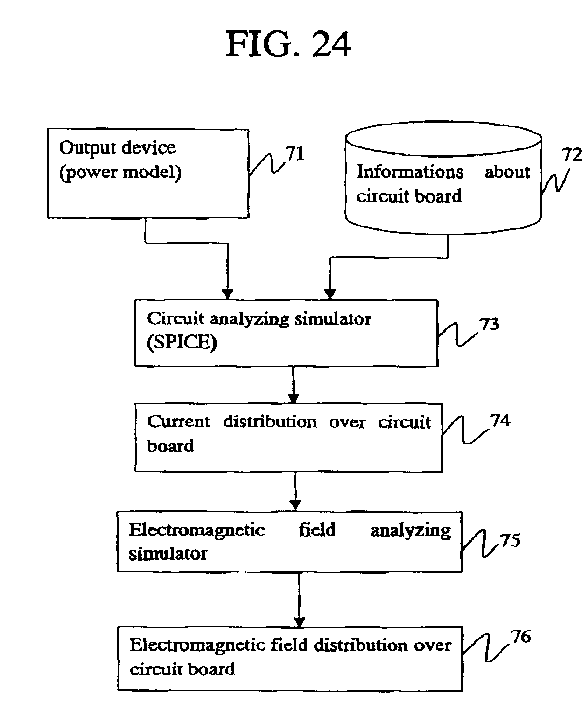

FIG. 24 is a flow chart illustrative of the electromagnetic interference simulation to the semiconductor integrated circuit by use of a simulator on the basis of the first and second novel power models shown in FIGS. 3 and 4 and prepared by the first, second, third, fourth and fifth design methods executed by the supporting system shown in FIG. 23.

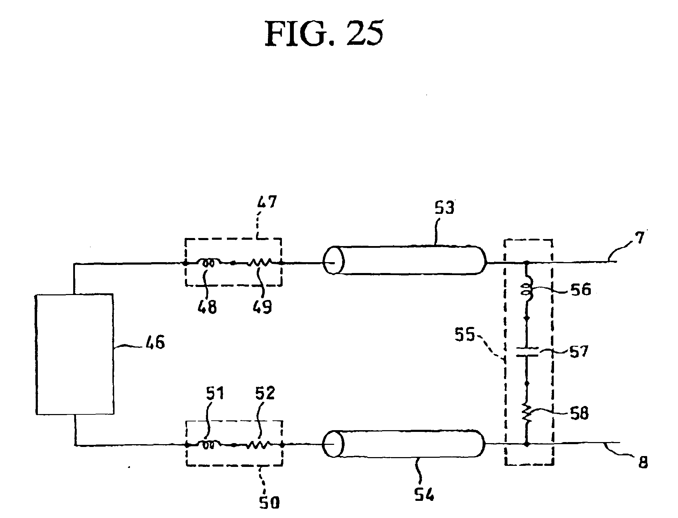

FIG. 25 is a circuit diagram illustrative of a modeled circuit board connected to the novel power model for the electromagnetic interference simulation in accordance with the present invention.

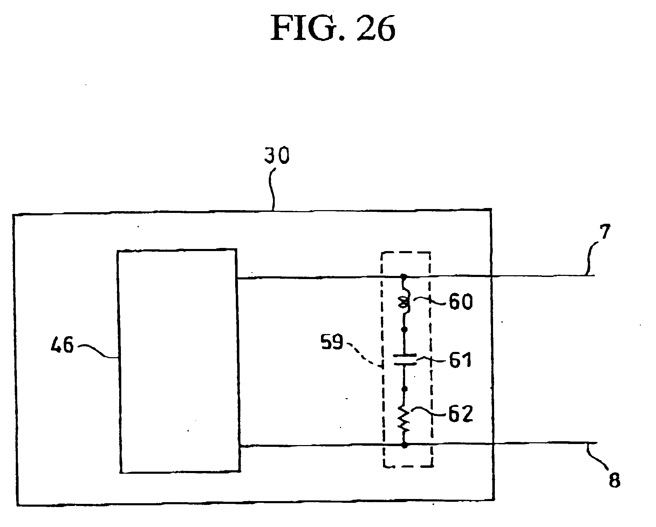

FIG. 26 is a circuit diagram illustrative of a modeled semiconductor integrated circuit for the electromagnetic interference simulation in accordance with the present invention.

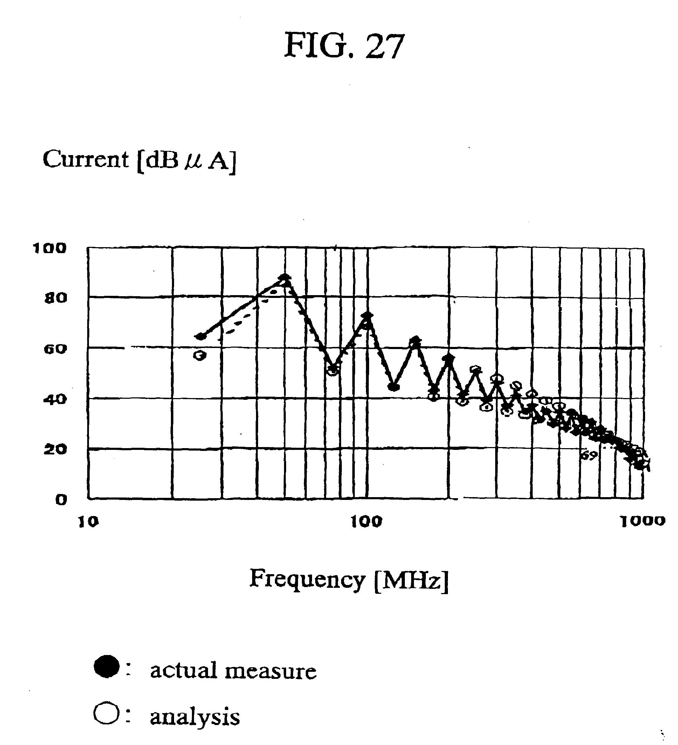

FIG. 27 is a diagram illustrative of variations in currents over frequency to show frequency spectrums which has been transformed by Fouriertransform from a current waveform which represents variation in current over time at a fixed point of a circuit board, wherein ● represents an actually measured value, whilst ○ represents an analyzed value.

The novel electro-magnetic interference (EMI) simulation model in accordance with the present invention is represented in the transistor description format for conducting the simulation to the radiation electro-magnetic field generated on the printed board. This transistor description format large scale integrated circuit power model is largely reduced in the number of transistors constituting this model. The electro-magnetic interference (EMI) simulator utilizes this transistor description format large scale integrated circuit power model to find a power current which flows on an interconnection of a printed board. This transistor description format large scale integrated circuit power model is prepared by extracting operating parts from a net-list for the large scale integrated circuit to reduce the number of transistors constituting this model. Non-operating parts of the large scale integrated circuit are simplified to be incorporated into the model. Namely, the transistor description format large scale integrated circuit power model includes the operating parts extracted from the net-list and the simplified non-operating parts, so that all of the parts of the large scale integrated circuit are utilized to prepare the transistor description format large scale integrated circuit power model.

In accordance with the present invention, the power system of the large scale integrated circuit is modeled into an inverter circuit and an equivalent capacity. As compared to the conventional transistor description format large scale integrated circuit power model, a calculation load to the electro-magnetic interference (EMI) simulator is reduced, thereby making it easy to conduct the power current analysis. The non-operating parts of the large scale integrated circuit are considered on the electro-magnetic interference (EMI) simulation, whereby the large scale integrated circuit model shows similar operations or behaviors to the actual operations or behaviors of the actual large scale integrated circuit. This makes it possible to find a highly accurate power current of the large scale integrated circuit. Since the confidential detailed informations about the internal circuit configurations of the large scale integrated circuit and the device structures are not included in this transistor description format large scale integrated circuit power model, the maker who manufactures the large scale integrated circuit is likely to show this transistor description format large scale integrated circuit power model to the user with keeping the detailed informations to be confidential.

The first present invention provides a power model for a semiconductor integrated circuit, wherein the power model comprises a logic gate circuit part representing an operating part of the semiconductor integrated circuit and an equivalent internal capacitive part representing a non-operating part of the semiconductor integrated circuit.

It is also preferable that the power model is independently provided for each of plural power systems which are independent from each other and included in the semiconductor integrated circuit.

It is also preferable that internal circuit configurations of the semiconductor integrated circuit are divided into plural blocks on the basis of arrangement informations, and the power model is provided for each of the plural blocks.

It is also preferable that internal circuit configurations of the semiconductor integrated circuit are divided into plural groups, each of the plural groups comprises a same timing group which includes logic gate circuits having individual signal transmission delay times fallen in a group-belonging predetermined time range which belongs to each of the plural groups, and the power model is provided for each of the plural groups.

It is also preferable that the power model further comprises a signal source connected to the logic gate circuit part for supplying a frequency-fixed signal to the logic gate circuit part, so that the logic gate circuit part represents operating state parts of the semiconductor integrated circuit in accordance with the frequency-fixed signal, and the equivalent internal capacitive part represents non-operating state parts of the semiconductor integrated circuit.

It is also preferable that the equivalent internal capacitive part further represents operating-irrelevant fixed parts of the semiconductor integrated circuit.

It is also preferable that the logic gate circuit part is connected between first and second powers, and the equivalent internal capacitive part is also connected between the first and second powers.

It is also preferable that the logic gate circuit part further comprises a single pair of an inverter circuit and a load capacitive element, and the inverter circuit is connected between the first and second powers and the load capacitive element is also connected between the first and second powers, and the load capacitive element is placed between the inverter circuit and the equivalent internal capacitive part.

It is also preferable that the load capacitive element comprises a series connection of a first load capacitance and a second load capacitance between the first and second powers, and an intermediate point between the first and second load capacitances is connected to an output terminal of the inverter circuit.

It is also preferable that the equivalent internal capacitive part further comprises at least an equivalent internal capacitive element connected between the first and second powers.

It is also preferable that a plurality of the equivalent internal capacitive element is connected between the first and second powers, and the equivalent internal capacitive element comprises a series connection of a capacitance and a resistance between the first and second powers.

It is also preferable that the inverter circuit comprises a series connection of a p-channel MOS field effect transistor and an n-channel MOS field effect transistor, and gate electrodes of the p-channel and n-channel MOS field effect transistors are connected to a clock signal source for applying a clock signal to the gate electrodes of the p-channel and n-channel MOS field effect transistors.

It is also preferable that the logic gate circuit part further comprises plural pairs of an inverter circuit and a load capacitive element, and the inverter circuit is connected between the first and second powers and the load capacitive element is also connected between the first and second powers, and in each pair, the load capacitive element is placed closer to the equivalent internal capacitive part than the inverter circuit.

It is also preferable that the load capacitive element comprises a series connection of a first load capacitance and a second load capacitance between the first and second powers, and an intermediate point between the first and second load capacitances is connected to an output terminal of the inverter circuit.

It is also preferable that the equivalent internal capacitive part further comprises at least an equivalent internal capacitive element connected between the first and second powers.

It is also preferable that a plurality of the equivalent internal capacitive element is connected between the first and second powers, and the equivalent internal capacitive element comprises a series connection of a capacitance and a resistance between the first and second powers.

It is also preferable that the inverter circuit comprises a series connection of a p-channel MOS field effect transistor and an n-channel MOS field effect transistor, and gate electrodes of the p-channel and n-channel MOS field effect transistors are connected to a clock signal source for applying a clock signal to the gate electrodes of the p-channel and n-channel MOS field effect transistors.

It is also preferable that the equivalent internal capacitive part is placed between the logic gate circuit part and a power system side.

It is also preferable that the power model is deigned for simulation to a current distribution over a circuit board on which the semiconductor integrated circuit is mounted.

It is also preferable that the power model is deigned for an electro-magnetic interference simulation to an electromagnetic field distribution over a circuit board on which the semiconductor integrated circuit is mounted.

The second present invention provides a method of designing a power model for a semiconductor integrated circuit. The power model comprises a logic gate circuit part and an equivalent internal capacitive part, wherein operating-related informations of all gate circuits constituting the semiconductor integrated circuit are utilized in first sequential processes to prepare the logic gate circuit part of the power model, and wherein non-operating-related informations of the all gate circuits constituting the semiconductor integrated circuit are utilized in second sequential processes separated from the first sequential processes to prepare the equivalent internal capacitive part of the power model.

It is also preferable that in the first sequential processes, informations about gate widths of operating-state p-channel transistors in the operating-state of the constituting gate circuits are utilized to decide a gate width of a model p-channel transistor; informations about gate widths of operating-state n-channel transistors in the operating-state of the constituting gate circuits are utilized to decide a gate width of a model n-channel transistor; informations about gate capacities of the operating-state p-channel transistors in the operating-state of the constituting gate circuits and about interconnection capacitances between the operating-state p-channel transistors and a first power are utilized to decide a model first load capacity; and informations about gate capacities of the operating-state n-channel transistors in the operating-state of the constituting gate circuits and about interconnection capacitances between the operating-state n-channel transistors and a second power are utilized to decide a model second load capacity, whereby the logic gate circuit part comprising at least a pair of p-channel and n-channel transistors and at least a pair of first and second load capacities is designed.

It is also preferable that a sum of gate widths of the operating-state p-channel transistors in the operating-state of the constituting gate circuits is defined to be a gate width of a model p-channel transistor; a sum of gate widths of operating-state n-channel transistors in the operating-state of the constituting gate circuits is defined to be a gate width of a model n-channel transistor; a sum of gate capacitances of the operating-state p-channel transistors and interconnection capacitances between the operating-state p-channel transistors and the first power is defined to be a model first load capacity; and a sum of gate capacitances of the operating-state n-channel transistors and interconnection capacitances between the operating-state n-channel transistors and the second power is defined to be a model second load capacity, whereby the logic gate circuit part comprising a single pair of p-channel and n-channel transistors and a single pair of first and second load capacities is designed.

It is also preferable that a half of a sum of gate widths of the operating-state p-channel transistors in the operating-state of the constituting gate circuits is defined to be a gate width of a model p-channel transistor; a half of a sum of gate widths of operating-state n-channel transistors in the operating-state of the constituting gate circuits is defined to be a gate width of a model n-channel transistor; a half of a sum of gate capacitances of the operating-state p-channel transistors and interconnection capacitances between the operating-state p-channel transistors and the first power is defined to be a model first load capacity; and a half of a sum of gate capacitances of the operating-state n-channel transistors and interconnection capacitances between the operating-state n-channel transistors and the second power is defined to be a model second load capacity, whereby the logic gate circuit part comprising two pairs of p-channel and n-channel transistors and two pairs of first and second load capacities is designed.

It is also preferable that a product of the number of the operating-state gate circuits and an averaged value of gate widths of the operating-state p-channel transistors in the operating-state of the constituting gate circuits is defined to be a gate width of a model p-channel transistor; a product of the number of the operating-state gate circuits and an averaged value of gate widths of operating-state n-channel transistors in the operating-state of the constituting gate circuits is defined to be a gate width of a model n-channel transistor; a product of the number of the operating-state gate circuits and a sum of both a first averaged value of gate capacitances of the operating-state p-channel transistors and a second averaged value of interconnection capacitances between the operating-state p-channel transistors and the first power is defined to be a model first load capacity; and a product of the number of the operating-state gate circuits and a sum of both a first averaged value of gate capacitances of the operating-state n-channel transistors and a second averaged value of interconnection capacitances between the operating-state n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the operating-state gate circuits and an averaged value of gate widths of the operating-state p-channel transistors in the operating-state of the constituting gate circuits is defined to be a gate width of a model p-channel transistor; a half of a product of the number of the operating-state gate circuits and an averaged value of gate widths of operating-state n-channel transistors in the operating-state of the constituting gate circuits is defined to be a gate width of a model n-channel transistor; a half of a product of the number of the operating-state gate circuits and a sum of both a first averaged value of gate capacitances of the operating-state p-channel transistors and a second averaged value of interconnection capacitances between the operating-state p-channel transistors and the first power is defined to be a model first load capacity; and a half of a product of the number of the operating-state gate circuits and a sum of both a first averaged value of gate capacitances of the operating-state n-channel transistors and a second averaged value of interconnection capacitances between the operating-state n-channel transistors and the second power is defined to be a model second load capacity, whereby the logic gate circuit part comprising two pairs of p-channel and n-channel transistors and two pairs of first and second load capacities is designed.

It is also preferable that in the first sequential processes, informations about gate widths of all p-channel transistors of the constituting gate circuits and an information about operational rate of operating-state p-channel transistors in the operating-state are utilized to decide a gate width of a model p-channel transistor; informations about gate widths of all n-channel transistors of the constituting gate circuits and an information about operational rate of operating-state n-channel transistors in the operating-state are utilized to decide a gate width of a model n-channel transistor; informations about gate capacities of the all p-channel transistors of the constituting gate circuits and informations about interconnection capacitances between the all p-channel transistors and a first power and informations about the operational rate are utilized to decide a model first load capacity; and informations about gate capacities of the all n-channel transistors of the constituting gate circuits and informations about interconnection capacitances between the all n-channel transistors and a second power and informations about the operational rate are utilized to decide a model second load capacity, whereby the logic gate circuit part comprising at least a pair of p-channel and n-channel transistors and at least a pair of first and second load capacities is designed.

It is also preferable that a product of the number of the all gate circuits, an average operational rate of the gate circuits, and an averaged value of gate widths of the all p-channel transistors in the all of the constituting gate circuits is defined to be a gate width of a model p-channel transistor; a product of the number of the all gate circuits, an average operational rate of the gate circuits, and an averaged value of gate widths of all n-channel transistors in the all of the constituting gate circuits is defined to be a gate width of a model n-channel transistor; a product of the number of the all gate circuits, an average operational rate of the gate circuits, and a sum of both a first averaged value of gate capacitances of the all p-channel transistors and a second averaged value of interconnection capacitances between the all p-channel transistors and the first power is defined to be a model first load capacity; and a product of the number of the all gate circuits, an average operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the all gate circuits, an average operational rate of the gate circuits, and an averaged value of gate widths of the all p-channel transistors in the all of the constituting gate circuits is defined to be a gate width of a model p-channel transistor; a half of a product of the number of the all gate circuits, an average operational rate of the gate circuits, and an averaged value of gate widths of all n-channel transistors in the all of the constituting gate circuits is defined to be a gate width of a model n-channel transistor; a half of a product of the number of the all gate circuits, an average operational rate of the gate circuits, and a sum of both a first averaged value of gate capacitances of the all p-channel transistors and a second averaged value of interconnection capacitances between the all p-channel transistors and the first power is defined to be a model first load capacity; and a half of a product of the number of the all gate circuits, an average operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising two pairs of p-channel and n-channel transistors and two pairs of first and second load capacities is designed.

It is also preferable that a product of the number of the all gate circuits, a maximum operational rate of the gate circuits, and an averaged value of gate widths of the all p-channel transistors in the all of the constituting gate circuits is defined to be a gate width of a model p-channel transistor; a product of the number of the all gate circuits, the maximum operational rate of the gate circuits, and an averaged value of gate widths of all n-channel transistors in the all of the constituting gate circuits is defined to be a gate width of a model n-channel transistor; a product of the number of the all gate circuits, the maximum operational rate of the gate circuits, and a sum of both a first averaged value of gate capacitances of the all p-channel transistors and a second averaged value of interconnection capacitances between the all p-channel transistors and the first power is defined to be a model first load capacity; and a product of the number of the all gate circuits, the maximum operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the all gate circuits, a maximum operational rate of the gate circuits, and an averaged value of gate widths of the all p-channel transistors in the all of the constituting gate circuits is defined to be a gate width of a model p-channel transistor; a half of a product of the number of the all gate circuits, the maximum operational rate of the gate circuits, and an averaged value of gate widths of all n-channel transistors in the all of the constituting gate circuits is defined to be a gate width of a model n-channel transistor; a half of a product of the number of the all gate circuits, the maximum operational rate of the gate circuits, and a sum of both a first averaged value of gate capacitances of the all p-channel transistors and a second averaged value of interconnection capacitances between the all p-channel transistors and the first power is defined to be a model first load capacity; and a half of a product of the number of the all gate circuits, the maximum operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising two pairs of p-channel and n-channel transistors and two pairs of first and second load capacities is designed.

It is also preferable that in the first sequential processes, informations about gate widths of all p-channel transistors of the constituting gate circuits and informations about currents of basic gate circuits and the constituting gate circuits are utilized to decide a gate width of a model p-channel transistor; informations about gate widths of all n-channel transistors of the constituting gate circuits and informations about currents of basic gate circuits and the constituting gate circuits are utilized to decide a gate width of a model n-channel transistor; informations about gate capacities of the all p-channel transistors of the constituting gate circuits and informations about interconnection capacitances between the all p-channel transistors and a first power and informations about currents of basic gate circuits and the constituting gate circuits are utilized to decide a model first load capacity; and informations about gate capacities of the all n-channel transistors of the constituting gate circuits and informations about interconnection capacitances between the all n-channel transistors and a second power and informations about currents of basic gate circuits and the constituting gate circuits are utilized to decide a model second load capacity, whereby the logic gate circuit part comprising at least a pair of p-channel and n-channel transistors and at least a pair of first and second load capacities is designed.

It is also preferable that a product of the number of the all gate circuits, and a power current ratio of an averaged current value of the basic gate circuits to an averaged current value of the constituting gate circuits, and an averaged value of gate widths of the all p-channel transistors in the all of the constituting gate circuits is defined to be a gate width of a model p-channel transistor; a product of the number of the all gate circuits, the power current ratio, and an averaged value of gate widths of all n-channel transistors in the all of the constituting gate circuits is defined to be a gate width of a model n-channel transistor; a product of the number of the all gate circuits, the power current ratio, and a sum of both a first averaged value of gate capacitances of the all p-channel transistors and a second averaged value of interconnection capacitances between the all p-channel transistors and the first power is defined to be a model first load capacity; and a product of the number of the all gate circuits, the power current ratio, and a sum of both a first averaged value of gate capacitances of the all n-channel transistors and a second averaged value of interconnection capacitances between the all n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the all gate circuits, and a power current ratio of an averaged current value of the basic gate circuits to an averaged current value of the constituting gate circuits, and an averaged value of gate widths of the all p-channel transistors in the all of the constituting gate circuits is defined to be a gate width of a model p-channel transistor; a half of a product of the number of the all gate circuits, the power current ratio, and an averaged value of gate widths of all n-channel transistors in the all of the constituting gate circuits is defined to be a gate width of a model n-channel transistor; a half of a product of the number of the all gate circuits, the power current ratio, and a sum of both a first averaged value of gate capacitances of the all p-channel transistors and a second averaged value of interconnection capacitances between the all p-channel transistors and the first power is defined to be a model first load capacity; and a half of a product of the number of the all gate circuits, the power current ratio, and a sum of both a first averaged value of gate capacitances of the all n-channel transistors and a second averaged value of interconnection capacitances between the all n-channel transistors and the second power is defined to be a model second load capacity, whereby the logic gate circuit part comprising two pairs of p-channel and n-channel transistors and two pairs of first and second load capacities is designed.

It is also preferable that in the second sequential processes, informations about ON-resistances of non-operating-state transistors in the non-operating-state of the constituting gate circuits are utilized to decide an ON-resistance of an equivalent internal capacity; and informations about gate capacities of the non-operating-state transistors in the non-operating-state of the constituting gate circuits and about interconnection capacitances between the operating-state transistors and a power are utilized to decide the equivalent internal capacity, whereby the equivalent internal capacitive part comprising at least the equivalent internal capacity is designed.

It is also preferable that a double of a reciprocal of a sum of reciprocals of ON-resistances of non-operating p-channel transistors in the non-operating state is defined to be an ON-resistance of a third equivalent internal capacity; a double of a reciprocal of a sum of reciprocals of ON-resistances of non-operating n-channel transistors in the non-operating state is defined to be an ON-resistance of a second equivalent internal capacity; an arithmetic mean of a sum of gate capacities of the non-operating p-channel transistors and a sum of interconnection capacities between the non-operating p-channel transistors and a first power is defined to be the second equivalent internal capacity; and an arithmetic mean of a sum of gate capacities of the non-operating n-channel transistors and a sum of interconnection capacities between the non-operating n-channel transistors and a second power is defined to be the third equivalent internal capacity, whereby the equivalent internal capacitive part comprising at least the equivalent internal capacity is designed.

It is also preferable that a double of a product of an averaged value of ON-resistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that in the second sequential processes, informations about an averaged value of ON-resistances of all transistors included in the constituting gate circuits and the number of non-operating gate circuits are utilized to decide an ON-resistance of an equivalent internal capacity; and informations about an averaged value of gate capacities of the non-operating-state transistors in the non-operating-state of the constituting gate circuits, and the number of non-operating gate circuits as well as informations about an averaged value of interconnection capacitances between the operating-state transistors and a power are utilized to decide the equivalent internal capacity, whereby the equivalent internal capacitive part comprising at least the equivalent internal capacity is designed.

It is also preferable that the number of non-operating gate circuits in the non-operating state is defined to be a product of a total number of the constituting logic gate included in the semiconductor integrated circuit and a remainder by subtracting an average operational rate from 1; a double of a product of an averaged value of ON-resistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that the number of non-operating gate circuits in the non-operating state is defined to be a product of a total number of the constituting logic gate included in the semiconductor integrated circuit and a remainder by subtracting a maximum operational rate from 1; a double of a product of an averaged value of ON-resistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that informations about an averaged value of ON-resistances of all transistors included in the constituting gate circuits and informations about currents of basic gate circuits and the constituting gate circuits are utilized to decide an ON-resistance of an equivalent internal capacity; and informations about an averaged value of gate capacities of the non-operating-state transistors in the non-operating-state of the constituting gate circuits, and informations about currents of basic gate circuits and the constituting gate circuits as well as informations about an averaged value of interconnection capacitances between the operating-state transistors and a power are utilized to decide the equivalent internal capacity, whereby the equivalent internal capacitive part comprising at least the equivalent internal capacity is designed.

It is also preferable that the number of non-operating gate circuits in the non-operating state is defined to be a product of the total number of the constituting gate circuits included in the semiconductor integrated circuit and a power current ratio which is defined to be a ratio of an averaged current value of all of basic gate circuits to an averaged current value of all of the constituting gate circuits; a double of a product of an averaged value of ON-resistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that the equivalent internal capacitive part is placed between the logic gate circuit part and a power system side.

It is also preferable that the power model is deigned for simulation to a current distribution over a circuit board on which the semiconductor integrated circuit is mounted.

It is also preferable that the power model is deigned for an electro-magnetic interference simulation to an electromagnetic field distribution over a circuit board on which the semiconductor integrated circuit is mounted.

The third present invention provides a storage medium for storing a computer program for designing a power model for a semiconductor integrated circuit, and the power model comprises a logic gate circuit part and an equivalent internal capacitive part, wherein operating-related informations of all gate circuits constituting the semiconductor integrated circuit are utilized in first sequential processes to prepare the logic gate circuit part of the power model, and wherein non-operating-related informations of the all gate circuits constituting the semiconductor integrated circuit are utilized in second sequential processes separated from the first sequential processes to prepare the equivalent internal capacitive part of the power model.

It is also preferable that in the first sequential processes, informations about gate widths of operating-state p-channel transistors in the operating-state of the constituting gate circuits are utilized to decide a gate width of a model p-channel transistor; informations about gate widths of operating-state n-channel transistors in the operating-state of the constituting gate circuits are utilized to decide a gate width of a model n-channel transistor; informations about gate capacities of the operating-state p-channel transistors in the operating-state of the constituting gate circuits and about interconnection capacitances between the operating-state p-channel transistors and a first power are utilized to decide a model first load capacity; and informations about gate capacities of the operating-state n-channel transistors in the operating-state of the constituting gate circuits and about interconnection capacitances between the operating-state n-channel transistors and a second power are utilized to decide a model second load capacity, whereby the logic gate circuit part comprising at least a pair of p-channel and n-channel transistors and at least a pair of first and second load capacities is designed.

It is also preferable that a sum of gate widths of the operating-state p-channel transistors in the operating-state of the constituting gate circuits is defined to be a gate width of a model p-channel transistor; a sum of gate widths of operating-state n-channel transistors in the operating-state of the constituting gate circuits is defined to be a gate width of a model n-channel transistor; a sum of gate capacitances of the operating-state p-channel transistors and interconnection capacitances between the operating-state p-channel transistors and the first power is defined to be a model first load capacity; and a sum of gate capacitances of the operating-state n-channel transistors and interconnection capacitances between the operating-state n-channel transistors and the second power is defined to be a model second load capacity, whereby the logic gate circuit part comprising a single pair of p-channel and n-channel transistors and a single pair of first and second load capacities is designed.

It is also preferable that a half of a sum of gate widths of the operating-state p-channel transistors in the operating-state of the constituting gate circuits is defined to be a gate width of a model p-channel transistor; a half of a sum of gate widths of operating-state n-channel transistors in the operating-state of the constituting gate circuits is defined to be a gate width of a model n-channel transistor; a half of a sum of gate capacitances of the operating-state p-channel transistors and interconnection capacitances between the operating-state p-channel transistors and the first power is defined to be a model first load capacity; and a half of a sum of gate capacitances of the operating-state n-channel transistors and interconnection capacitances between the operating-state n-channel transistors and the second power is defined to be a model second load capacity, whereby the logic gate circuit part comprising two pairs of p-channel and n-channel transistors and two pairs of first and second load capacities is designed.

It is also preferable that a product of the number of the operating-state gate circuits and an averaged value of gate widths of the operating-state p-channel transistors in the operating-state of the constituting gate circuits is defined to be a gate width of a model p-channel transistor; a product of the number of the operating-state gate circuits and an averaged value of gate widths of operating-state n-channel transistors in the operating-state of the constituting gate circuits is defined to be a gate width of a model n-channel transistor; a product of the number of the operating-state gate circuits and a sum of both a first averaged value of gate capacitances of the operating-state p-channel transistors and a second averaged value of interconnection capacitances between the operating-state p-channel transistors and the first power is defined to be a model first load capacity; and a product of the number of the operating-state gate circuits and a sum of both a first averaged value of gate capacitances of the operating-state n-channel transistors and a second averaged value of interconnection capacitances between the operating-state n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the operating-state gate circuits and an averaged value of gate widths of the operating-state p-channel transistors in the operating-state of the constituting gate circuits is defined to be a gate width of a model p-channel transistor; a half of a product of the number of the operating-state gate circuits and an averaged value of gate widths of operating-state n-channel transistors in the operating-state of the constituting gate circuits is defined to be a gate width of a model n-channel transistor; a half of a product of the number of the operating-state gate circuits and a sum of both a first averaged value of gate capacitances of the operating-state p-channel transistors and a second averaged value of interconnection capacitances between the operating-state p-channel transistors and the first power is defined to be a model first load capacity; and a half of a product of the number of the operating-state gate circuits and a sum of both a first averaged value of gate capacitances of the operating-state n-channel transistors and a second averaged value of interconnection capacitances between the operating-state n-channel transistors and the second power is defined to be a model second load capacity, whereby the logic gate circuit part comprising two pairs of p-channel and n-channel transistors and two pairs of first and second load capacities is designed.

It is also preferable that in the first sequential processes, informations about gate widths of all p-channel transistors of the constituting gate circuits and an information about operational rate of operating-state p-channel transistors in the operating-state are utilized to decide a gate width of a model p-channel transistor; informations about gate widths of all n-channel transistors of the constituting gate circuits and an information about operational rate of operating-state n-channel transistors in the operating-state are utilized to decide a gate width of a model n-channel transistor; informations about gate capacities of the all p-channel transistors of the constituting gate circuits and informations about interconnection capacitances between the all p-channel transistors and a first power and informations about the operational rate are utilized to decide a model first load capacity; and informations about gate capacities of the all n-channel transistors of the constituting gate circuits and informations about interconnection capacitances between the all n-channel transistors and a second power and informations about the operational rate are utilized to decide a model second load capacity, whereby the logic gate circuit part comprising at least a pair of p-channel and n-channel transistors and at least a pair of first and second load capacities is designed.

It is also preferable that a product of the number of the all gate circuits, an average operational rate of the gate circuits, and an averaged value of gate widths of the all p-channel transistors in the all of the constituting gate circuits is defined to be a gate width of a model p-channel transistor; a product of the number of the all gate circuits, an average operational rate of the gate circuits, and an averaged value of gate widths of all n-channel transistors in the all of the constituting gate circuits is defined to be a gate width of a model n-channel transistor; a product of the number of the all gate circuits, an average operational rate of the gate circuits, and a sum of both a first averaged value of gate capacitances of the all p-channel transistors and a second averaged value of interconnection capacitances between the all p-channel transistors and the first power is defined to be a model first load capacity; and a product of the number of the all gate circuits, an average operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the all gate circuits, an average operational rate of the gate circuits, and an averaged value of gate widths of the all p-channel transistors in the all of the constituting gate circuits is defined to be a gate width of a model p-channel transistor; a half of a product of the number of the all gate circuits, an average operational rate of the gate circuits, and an averaged value of gate widths of all n-channel transistors in the all of the constituting gate circuits is defined to be a gate width of a model n-channel transistor; a half of a product of the number of the all gate circuits, an average operational rate of the gate circuits, and a sum of both a first averaged value of gate capacitances of the all p-channel transistors and a second averaged value of interconnection capacitances between the all p-channel transistors and the first power is defined to be a model first load capacity; and a half of a product of the number of the all gate circuits, an average operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising two pairs of p-channel and n-channel transistors and two pairs of first and second load capacities is designed.

It is also preferable that a product of the number of the all gate circuits, a maximum operational rate of the gate circuits, and an averaged value of gate widths of the all p-channel transistors in the all of the constituting gate circuits is defined to be a gate width of a model p-channel transistor; a product of the number of the all gate circuits, the maximum operational rate of the gate circuits, and an averaged value of gate widths of all n-channel transistors in the all of the constituting gate circuits is defined to be a gate width of a model n-channel transistor; a product of the number of the all gate circuits, the maximum operational rate of the gate circuits, and a sum of both a first averaged value of gate capacitances of the all p-channel transistors and a second averaged value of interconnection capacitances between the all p-channel transistors and the first power is defined to be a model first load capacity; and a product of the number of the all gate circuits, the maximum operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the all gate circuits, a maximum operational rate of the gate circuits, and an averaged value of gate widths of the all p-channel transistors in the all of the constituting gate circuits is defined to be a gate width of a model p-channel transistor; a half of a product of the number of the all gate circuits, the maximum operational rate of the gate circuits, and an averaged value of gate widths of all n-channel transistors in the all of the constituting gate circuits is defined to be a gate width of a model n-channel transistor; a half of a product of the number of the all gate circuits, the maximum operational rate of the gate circuits, and a sum of both a first averaged value of gate capacitances of the all p-channel transistors and a second averaged value of interconnection capacitances between the all p-channel transistors and the first power is defined to be a model first load capacity; and a half of a product of the number of the all gate circuits, the maximum operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising two pairs of p-channel and n-channel transistors and two pairs of first and second load capacities is designed.

It is also preferable that in the first sequential processes, informations about gate widths of all p-channel transistors of the constituting gate circuits and informations about currents of basic gate circuits and the constituting gate circuits are utilized to decide a gate width of a model p-channel transistor; informations about gate widths of all n-channel transistors of the constituting gate circuits and informations about currents of basic gate circuits and the constituting gate circuits are utilized to decide a gate width of a model n-channel transistor; informations about gate capacities of the all p-channel transistors of the constituting gate circuits and informations about interconnection capacitances between the all p-channel transistors and a first power and informations about currents of basic gate circuits and the constituting gate circuits are utilized to decide a model first load capacity; and informations about gate capacities of the all n-channel transistors of the constituting gate circuits and informations about interconnection capacitances between the all n-channel transistors and a second power and informations about currents of basic gate circuits and the constituting gate circuits are utilized to decide a model second load capacity, whereby the logic gate circuit part comprising at least a pair of pchannel and n-channel transistors and at least a pair of first and second load capacities is designed.

It is also preferable that a product of the number of the all gate circuits, and a power current ratio of an averaged current value of the basic gate circuits to an averaged current value of the constituting gate circuits, and an averaged value of gate widths of the all p-channel transistors in the all of the constituting gate circuits is defined to be a gate width of a model p-channel transistor; a product of the number of the all gate circuits, the power current ratio, and an averaged value of gate widths of all n-channel transistors in the all of the constituting gate circuits is defined to be a gate width of a model n-channel transistor; a product of the number of the all gate circuits, the power current ratio, and a sum of both a first averaged value of gate capacitances of the all p-channel transistors and a second averaged value of interconnection capacitances between the all p-channel transistors and the first power is defined to be a model first load capacity; and a product of the number of the all gate circuits, the power current ratio, and a sum of both a first averaged value of gate capacitances of the all n-channel transistors and a second averaged value of interconnection capacitances between the all n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the all gate circuits, and a power current ratio of an averaged current value of the basic gate circuits to an averaged current value of the constituting gate circuits, and an averaged value of gate widths of the all p-channel transistors in the all of the constituting gate circuits is defined to be a gate width of a model p-channel transistor; a half of a product of the number of the all gate circuits, the power current ratio, and an averaged value of gate widths of all n-channel transistors in the all of the constituting gate circuits is defined to be a gate width of a model n-channel transistor; a half of a product of the number of the all gate circuits, the power current ratio, and a sum of both a first averaged value of gate capacitances of the all p-channel transistors and a second averaged value of interconnection capacitances between the all p-channel transistors and the first power is defined to be a model first load capacity; and a half of a product of the number of the all gate circuits, the power current ratio, and a sum of both a first averaged value of gate capacitances of the all n-channel transistors and a second averaged value of interconnection capacitances between the all n-channel transistors and the second power is defined to be a model second load capacity, whereby the logic gate circuit part comprising two pairs of p-channel and n-channel transistors and two pairs of first and second load capacities is designed.

It is also preferable that in the second sequential processes, informations about ON-resistances of non-operating-state transistors in the non-operating-state of the constituting gate circuits are utilized to decide an ON-resistance of an equivalent internal capacity; and informations about gate capacities of the non-operating-state transistors in the non-operating-state of the constituting gate circuits and about interconnection capacitances between the operating-state transistors and a power are utilized to decide the equivalent internal capacity, whereby the equivalent internal capacitive part comprising at least the equivalent internal capacity is designed.

It is also preferable that a double of a reciprocal of a sum of reciprocals of ON-resistances of non-operating p-channel transistors in the non-operating state is defined to be an ON-resistance of a third equivalent internal capacity; a double of a reciprocal of a sum of reciprocals of ON-resistances of non-operating n-channel transistors in the non-operating state is defined to be an ON-resistance of a second equivalent internal capacity; an arithmetic mean of a sum of gate capacities of the non-operating p-channel transistors and a sum of interconnection capacities between the non-operating p-channel transistors and a first power is defined to be the second equivalent internal capacity; and an arithmetic mean of a sum of gate capacities of the non-operating n-channel transistors and a sum of interconnection capacities between the non-operating n-channel transistors and a second power is defined to be the third equivalent internal capacity, whereby the equivalent internal capacitive part comprising at least the equivalent internal capacity is designed.

It is also preferable that a double of a product of an averaged value of ONresistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that in the second sequential processes, informations about an averaged value of ON-resistances of all transistors included in the constituting gate circuits and the number of non-operating gate circuits are utilized to decide an ON-resistance of an equivalent internal capacity; and informations about an averaged value of gate capacities of the non-operating-state transistors in the non-operating-state of the constituting gate circuits, and the number of non-operating gate circuits as well as informations about an averaged value of interconnection capacitances between the operating-state transistors and a power are utilized to decide the equivalent internal capacity, whereby the equivalent internal capacitive part comprising at least the equivalent internal capacity is designed.

It is also preferable that the number of non-operating gate circuits in the non-operating state is defined to be a product of a total number of the constituting logic gate included in the semiconductor integrated circuit and a remainder by subtracting an average operational rate from 1; a double of a product of an averaged value of ON-resistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that the number of non-operating gate circuits in the non-operating state is defined to be a product of a total number of the constituting logic gate included in the semiconductor integrated circuit and a remainder by subtracting a maximum operational rate from 1; a double of a product of an averaged value of ON-resistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that informations about an averaged value of ON-resistances of all transistors included in the constituting gate circuits and informations about currents of basic gate circuits and the constituting gate circuits are utilized to decide an ON-resistance of an equivalent internal capacity; and informations about an averaged value of gate capacities of the non-operating-state transistors in the non-operating-state of the constituting gate circuits, and informations about currents of basic gate circuits and the constituting gate circuits as well as informations about an averaged value of interconnection capacitances between the operating-state transistors and a power are utilized to decide the equivalent internal capacity, whereby the equivalent internal capacitive part comprising at least the equivalent internal capacity is designed.

It is also preferable that the number of non-operating gate circuits in the non-operating state is defined to be a product of the total number of the constituting gate circuits included in the semiconductor integrated circuit and a power current ratio which is defined to be a ratio of an averaged current value of all of basic gate circuits to an averaged current value of all of the constituting gate circuits; a double of a product of an averaged value of ON-resistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that the equivalent internal capacitive part is placed between the logic gate circuit part and a power system side.

It is also preferable that the power model is deigned for simulation to a current distribution over a circuit board on which the semiconductor integrated circuit is mounted.

It is also preferable that the power model is deigned for an electro-magnetic interference simulation to an electromagnetic field distribution over a circuit board on which the semiconductor integrated circuit is mounted.

The fourth present invention provides a supporting system for designing a power model for a semiconductor integrated circuit, and The power model comprises a logic gate circuit part and an equivalent internal capacitive part. The supporting system comprises: a data base storing informations of internal circuit configurations; a storage medium for storing informations about circuit elements and interconnections between the circuit elements of the power model as well as for storing a computer program for designing the power model; a processor being connected to the data base and the storage medium for executing the computer program to prepare the power model; and an output device being connected to the processor for outputting the power model prepared by the processor, wherein operating-related informations of all gate circuits constituting the semiconductor integrated circuit are utilized in first sequential processes to prepare the logic gate circuit part of the power model, and wherein non-operating-related informations of the all gate circuits constituting the semiconductor integrated circuit are utilized in second sequential processes separated from the first sequential processes to prepare the equivalent internal capacitive part of the power model.

It is also preferable that in the first sequential processes, informations about gate widths of operating-state p-channel transistors in the operating-state of the constituting gate circuits are utilized to decide a gate width of a model p-channel transistor; informations about gate widths of operating-state n-channel transistors in the operating-state of the constituting gate circuits are utilized to decide a gate width of a model n-channel transistor; informations about gate capacities of the operating-state p-channel transistors in the operating-state of the constituting gate circuits and about interconnection capacitances between the operating-state p-channel transistors and a first power are utilized to decide a model first load capacity; and informations about gate capacities of the operating-state n-channel transistors in the operating-state of the constituting gate circuits and about interconnection capacitances between the operating-state n-channel transistors and a second power are utilized to decide a model second load capacity, whereby the logic gate circuit part comprising at least a pair of p-channel and n-channel transistors and at least a pair of first and second load capacities is designed.

It is also preferable that a sum of gate widths of the operating-state p-channel transistors in the operating-state of the constituting gate circuits is defined to be a gate width of a model p-channel transistor; a sum of gate widths of operating-state n-channel transistors in the operating-state of the constituting gate circuits is defined to be a gate width of a model n-channel transistor; a sum of gate capacitances of the operating-state p-channel transistors and interconnection capacitances between the operating-state p-channel transistors and the first power is defined to be a model first load capacity; and a sum of gate capacitances of the operating-state n-channel transistors and interconnection capacitances between the operating-state n-channel transistors and the second power is defined to be a model second load capacity, whereby the logic gate circuit part comprising a single pair of p-channel and n-channel transistors and a single pair of first and second load capacities is designed.

It is also preferable that a half of a sum of gate widths of the operating-state p-channel transistors in the operating-state of the constituting gate circuits is defined to be a gate width of a model p-channel transistor; a half of a sum of gate widths of operating-state n-channel transistors in the operating-state of the constituting gate circuits is defined to be a gate width of a model n-channel transistor; a half of a sum of gate capacitances of the operating-state p-channel transistors and interconnection capacitances between the operating-state p-channel transistors and the first power is defined to be a model first load capacity; and a half of a sum of gate capacitances of the operating-state n-channel transistors and interconnection capacitances between the operating-state n-channel transistors and the second power is defined to be a model second load capacity, whereby the logic gate circuit part comprising two pairs of p-channel and n-channel transistors and two pairs of first and second load capacities is designed.

It is also preferable that a product of the number of the operating-state gate circuits and an averaged value of gate widths of the operating-state p-channel transistors in the operating-state of the constituting gate circuits is defined to be a gate width of a model p-channel transistor; a product of the number of the operating-state gate circuits and an averaged value of gate widths of operating-state n-channel transistors in the operating-state of the constituting gate circuits is defined to be a gate width of a model n-channel transistor; a product of the number of the operating-state gate circuits and a sum of both a first averaged value of gate capacitances of the operating-state p-channel transistors and a second averaged value of interconnection capacitances between the operating-state p-channel transistors and the first power is defined to be a model first load capacity; and a product of the number of the operating-state gate circuits and a sum of both a first averaged value of gate capacitances of the operating-state n-channel transistors and a second averaged value of interconnection capacitances between the operating-state n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the operating-state gate circuits and an averaged value of gate widths of the operating-state p-channel transistors in the operating-state of the constituting gate circuits is defined to be a gate width of a model p-channel transistor; a half of a product of the number of the operating-state gate circuits and an averaged value of gate widths of operating-state n-channel transistors in the operating-state of the constituting gate circuits is defined to be a gate width of a model n-channel transistor; a half of a product of the number of the operating-state gate circuits and a sum of both a first averaged value of gate capacitances of the operating-state p-channel transistors and a second averaged value of interconnection capacitances between the operating-state p-channel transistors and the first power is defined to be a model first load capacity; and a half of a product of the number of the operating-state gate circuits and a sum of both a first averaged value of gate capacitances of the operating-state n-channel transistors and a second averaged value of interconnection capacitances between the operating-state n-channel transistors and the second power is defined to be a model second load capacity, whereby the logic gate circuit part comprising two pairs of p-channel and n-channel transistors and two pairs of first and second load capacities is designed.

It is also preferable that in the first sequential processes, informations about gate widths of all p-channel transistors of the constituting gate circuits and an information about operational rate of operating-state p-channel transistors in the operating-state are utilized to decide a gate width of a model p-channel transistor; informations about gate widths of all n-channel transistors of the constituting gate circuits and an information about operational rate of operating-state n-channel transistors in the operating-state are utilized to decide a gate width of a model n-channel transistor; informations about gate capacities of the all p-channel transistors of the constituting gate circuits and informations about interconnection capacitances between the all p-channel transistors and a first power and informations about the operational rate are utilized to decide a model first load capacity; and informations about gate capacities of the all n-channel transistors of the constituting gate circuits and informations about interconnection capacitances between the all n-channel transistors and a second power and informations about the operational rate are utilized to decide a model second load capacity, whereby the logic gate circuit part comprising at least a pair of p-channel and n-channel transistors and at least a pair of first and second load capacities is designed.

It is also preferable that a product of the number of the all gate circuits, an average operational rate of the gate circuits, and an averaged value of gate widths of the all p-channel transistors in the all of the constituting gate circuits is defined to be a gate width of a model p-channel transistor; a product of the number of the all gate circuits, an average operational rate of the gate circuits, and an averaged value of gate widths of all n-channel transistors in the all of the constituting gate circuits is defined to be a gate width of a model n-channel transistor; a product of the number of the all gate circuits, an average operational rate of the gate circuits, and a sum of both a first averaged value of gate capacitances of the all p-channel transistors and a second averaged value of interconnection capacitances between the all p-channel transistors and the first power is defined to be a model first load capacity; and a product of the number of the all gate circuits, an average operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the all gate circuits, an average operational rate of the gate circuits, and an averaged value of gate widths of the all p-channel transistors in the all of the constituting gate circuits is defined to be a gate width of a model p-channel transistor; a half of a product of the number of the all gate circuits, an average operational rate of the gate circuits, and an averaged value of gate widths of all n-channel transistors in the all of the constituting gate circuits is defined to be a gate width of a model n-channel transistor; a half of a product of the number of the all gate circuits, an average operational rate of the gate circuits, and a sum of both a first averaged value of gate capacitances of the all p-channel transistors and a second averaged value of interconnection capacitances between the all p-channel transistors and the first power is defined to be a model first load capacity; and a half of a product of the number of the all gate circuits, an average operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising two pairs of p-channel and n-channel transistors and two pairs of first and second load capacities is designed.

It is also preferable that a product of the number of the all gate circuits, a maximum operational rate of the gate circuits, and an averaged value of gate widths of the all p-channel transistors in the all of the constituting gate circuits is defined to be a gate width of a model p-channel transistor; a product of the number of the all gate circuits, the maximum operational rate of the gate circuits, and an averaged value of gate widths of all n-channel transistors in the all of the constituting gate circuits is defined to be a gate width of a model n-channel transistor; a product of the number of the all gate circuits, the maximum operational rate of the gate circuits, and a sum of both a first averaged value of gate capacitances of the all p-channel transistors and a second averaged value of interconnection capacitances between the all p-channel transistors and the first power is defined to be a model first load capacity; and a product of the number of the all gate circuits, the maximum operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the all gate circuits, a maximum operational rate of the gate circuits, and an averaged value of gate widths of the all p-channel transistors in the all of the constituting gate circuits is defined to be a gate width of a model p-channel transistor; a half of a product of the number of the all gate circuits, the maximum operational rate of the gate circuits, and an averaged value of gate widths of all n-channel transistors in the all of the constituting gate circuits is defined to be a gate width of a model n-channel transistor; a half of a product of the number of the all gate circuits, the maximum operational rate of the gate circuits, and a sum of both a first averaged value of gate capacitances of the all p-channel transistors and a second averaged value of interconnection capacitances between the all p-channel transistors and the first power is defined to be a model first load capacity; and a half of a product of the number of the all gate circuits, the maximum operational rate of the gate circuits, and a sum of both a first averaged value of gate capacitances of the all n-channel transistors and a second averaged value of interconnection capacitances between the all n-channel transistors and the second power is defined to be a model second load capacity, whereby the logic gate circuit part comprising two pairs of p-channel and n-channel transistors and two pairs of first and second load capacities is designed.

It is also preferable that in the first sequential processes, informations about gate widths of all p-channel transistors of the constituting gate circuits and informations about currents of basic gate circuits and the constituting gate circuits are utilized to decide a gate width of a model p-channel transistor; informations about gate widths of all n-channel transistors of the constituting gate circuits and informations about currents of basic gate circuits and the constituting gate circuits are utilized to decide a gate width of a model n-channel transistor; informations about gate capacities of the all p-channel transistors of the constituting gate circuits and informations about interconnection capacitances between the all p-channel transistors and a first power and informations about currents of basic gate circuits and the constituting gate circuits are utilized to decide a model first load capacity; and informations about gate capacities of the all n-channel transistors of the constituting gate circuits and informations about interconnection capacitances between the all n-channel transistors and a second power and informations about currents of basic gate circuits and the constituting gate circuits are utilized to decide a model second load capacity, whereby the logic gate circuit part comprising at least a pair of p-channel and n-channel transistors and at least a pair of first and second load capacities is designed.

It is also preferable that a product of the number of the all gate circuits, and a power current ratio of an averaged current value of the basic gate circuits to an averaged current value of the constituting gate circuits, and an averaged value of gate widths of the all p-channel transistors in the all of the constituting gate circuits is defined to be a gate width of a model p-channel transistor; a product of the number of the all gate circuits, the power current ratio, and an averaged value of gate widths of all n-channel transistors in the all of the constituting gate circuits is defined to be a gate width of a model n-channel transistor; a product of the number of the all gate circuits, the power current ratio, and a sum of both a first averaged value of gate capacitances of the all p-channel transistors and a second averaged value of interconnection capacitances between the all p-channel transistors and the first power is defined to be a model first load capacity; and a product of the number of the all gate circuits, the power current ratio, and a sum of both a first averaged value of gate capacitances of the all n-channel transistors and a second averaged value of interconnection capacitances between the all n-channel transistors and the second power is defined to be a model second load capacity, whereby the logic gate circuit part comprising a single pair of p-channel and n-channel transistors and a single pair of first and second load capacities is designed.

It is also preferable that a half of a product of the number of the all gate circuits, and a power current ratio of an averaged current value of the basic gate circuits to an averaged current value of the constituting gate circuits, and an averaged value of gate widths of the all p-channel transistors in the all of the constituting gate circuits is defined to be a gate width of a model p-channel transistor; a half of a product of the number of the all gate circuits, the power current ratio, and an averaged value of gate widths of all n-channel transistors in the all of the constituting gate circuits is defined to be a gate width of a model n-channel transistor; a half of a product of the number of the all gate circuits, the power current ratio, and a sum of both a first averaged value of gate capacitances of the all p-channel transistors and a second averaged value of interconnection capacitances between the all p-channel transistors and the first power is defined to be a model first load capacity; and a half of a product of the number of the all gate circuits, the power current ratio, and a sum of both a first averaged value of gate capacitances of the all n-channel transistors and a second averaged value of interconnection capacitances between the all n-channel transistors and the second power is defined to be a model second load capacity, whereby the logic gate circuit part comprising two pairs of p-channel and n-channel transistors and two pairs of first and second load capacities is designed.

It is also preferable that in the second sequential processes, informations about ON-resistances of non-operating-state transistors in the non-operating-state of the constituting gate circuits are utilized to decide an ON-resistance of an equivalent internal capacity; and informations about gate capacities of the non-operating-state transistors in the non-operating-state of the constituting gate circuits and about interconnection capacitances between the operating-state transistors and a power are utilized to decide the equivalent internal capacity, whereby the equivalent internal capacitive part comprising at least the equivalent internal capacity is designed.

It is also preferable that a double of a reciprocal of a sum of reciprocals of ON-resistances of non-operating p-channel transistors in the non-operating state is defined to be an ON-resistance of a third equivalent internal capacity; a double of a reciprocal of a sum of reciprocals of ON-resistances of non-operating n-channel transistors in the non-operating state is defined to be an ON-resistance of a second equivalent internal capacity; an arithmetic mean of a sum of gate capacities of the non-operating p-channel transistors and a sum of interconnection capacities between the non-operating p-channel transistors and a first power is defined to be the second equivalent internal capacity; and an arithmetic mean of a sum of gate capacities of the non-operating n-channel transistors and a sum of interconnection capacities between the non-operating n-channel transistors and a second power is defined to be the third equivalent internal capacity, whereby the equivalent internal capacitive part comprising at least the equivalent internal capacity is designed.

It is also preferable that a double of a product of an averaged value of ON-resistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that in the second sequential processes, informations about an averaged value of ON-resistances of all transistors included in the constituting gate circuits and the number of non-operating gate circuits are utilized to decide an ON-resistance of an equivalent internal capacity; and informations about an averaged value of gate capacities of the non-operating-state transistors in the non-operating-state of the constituting gate circuits, and the number of non-operating gate circuits as well as informations about an averaged value of interconnection capacitances between the operating-state transistors and a power are utilized to decide the equivalent internal capacity, whereby the equivalent internal capacitive part comprising at least the equivalent internal capacity is designed.

It is also preferable that the number of non-operating gate circuits in the non-operating state is defined to be a product of a total number of the constituting logic gate included in the semiconductor integrated circuit and a remainder by subtracting an average operational rate from 1; a double of a product of an averaged value of ON-resistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that the number of non-operating gate circuits in the non-operating state is defined to be a product of a total number of the constituting logic gate included in the semiconductor integrated circuit and a remainder by subtracting a maximum operational rate from 1; a double of a product of an averaged value of ON-resistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that informations about an averaged value of ON-resistances of all transistors included in the constituting gate circuits and informations about currents of basic gate circuits and the constituting gate circuits are utilized to decide an ON-resistance of an equivalent internal capacity; and informations about an averaged value of gate capacities of the non-operating-state transistors in the non-operating-state of the constituting gate circuits, and informations about currents of basic gate circuits and the constituting gate circuits as well as informations about an averaged value of interconnection capacitances between the operating-state transistors and a power are utilized to decide the equivalent internal capacity, whereby the equivalent internal capacitive part comprising at least the equivalent internal capacity is designed.

It is also preferable that the number of non-operating gate circuits in the non-operating state is defined to be a product of the total number of the constituting gate circuits included in the semiconductor integrated circuit and a power current ratio which is defined to be a ratio of an averaged current value of all of basic gate circuits to an averaged current value of all of the constituting gate circuits; a double of a product of an averaged value of ON-resistances of non-operating p-channel transistors in the non-operating state and a reciprocal of the number of non-operating gate circuits is defined to be an ON-resistance of a third equivalent internal capacity; a double of a product of an averaged value of ON-resistances of non-operating n-channel transistors in the non-operating state and a reciprocal of the number of the non-operating gate circuit is defined to be an ON-resistance of a second equivalent internal capacity; a product of the number of the non-operating gate circuit and an arithmetic mean of an averaged value of gate capacities of the non-operating p-channel transistors and an averaged value of interconnection capacities between the non-operating p-channel transistors and a first power is defined to be the second equivalent internal capacity; and a product of the number of the non-operating gate circuit and an arithmetic mean of an averaged value of gate capacities of the non-operating n-channel transistors and an averaged value of interconnection capacities between the non-operating n-channel transistors and a second power is defined to be the third equivalent internal capacity, whereby the equivalent internal capacitive part comprising at least the equivalent internal capacity is designed.

It is also preferable that the equivalent internal capacitive part is placed between the logic gate circuit part and a power system side.

It is also preferable that the power model is deigned for simulation to a current distribution over a circuit board on which the semiconductor integrated circuit is mounted.

It is also preferable that the power model is deigned for an electro-magnetic interference simulation to an electromagnetic field distribution over a circuit board on which the semiconductor integrated circuit is mounted.

It is also preferable that the computer program further includes a first simulation program for analysis to circuits.

It is also preferable that the first simulation program is to obtain a current distribution over a circuit board on which the semiconductor integrated circuit is mounted.

It is also preferable that the computer program further more includes a second simulation program for analysis to electromagnetic field to obtain a distribution of electromagnetic field over the circuit board on which the semiconductor integrated circuit is mounted.

The fifth present invention provides a simulator for simulating an electro-magnetic interference. The simulator comprises: a circuit analyzing simulator being accessible to a first storage medium for receiving a power model for a semiconductor integrated circuit, and also being connected to a second storage medium for receiving informations about a circuit board on which the semiconductor integrated circuit is mounted, so that the circuit analyzing simulator analyzes the power model to obtain a current distribution over a circuit board on which the semiconductor integrated circuit is mounted; an electromagnetic field analyzing simulator being accessible to the circuit analyzing simulator for receiving the current distribution, so that the electromagnetic field analyzing simulator analyzes an electromagnetic field distribution over the circuit board on which the semiconductor integrated circuit is mounted, wherein the power model comprises a logic gate circuit part representing an operating part of the semiconductor integrated circuit and an equivalent internal capacitive part representing a non-operating part of the semiconductor integrated circuit.

It is also preferable that the power model is independently provided for each of plural power systems which are independent from each other and included in the semiconductor integrated circuit.

It is also preferable that internal circuit configurations of the semiconductor integrated circuit are divided into plural blocks on the basis of arrangement informations, and the power model is provided for each of the plural blocks.

It is also preferable that internal circuit configurations of the semiconductor integrated circuit are divided into plural groups, each of the plural groups comprises a same timing group which includes logic gate circuits having individual signal transmission delay times fallen in a group-belonging predetermined time range which belongs to each of the plural groups, and the power model is provided for each of the plural groups.

It is also preferable that the power model further comprises a signal source connected to the logic gate circuit part for supplying a frequency-fixed signal to the logic gate circuit part, so that the logic gate circuit part represents operating state parts of the semiconductor integrated circuit in accordance with the frequency-fixed signal, and the equivalent internal capacitive part represents non-operating state parts of the semiconductor integrated circuit.

It is also preferable that the equivalent internal capacitive part further represents operating-irrelevant fixed parts of the semiconductor integrated circuit.

It is also preferable that the logic gate circuit part is connected between first and second powers, and the equivalent internal capacitive part is also connected between the first and second powers.

It is also preferable that the logic gate circuit part further comprises a single pair of an inverter circuit and a load capacitive element, and the inverter circuit is connected between the first and second powers and the load capacitive element is also connected between the first and second powers, and the load capacitive element is placed between the inverter circuit and the equivalent internal capacitive part.

It is also preferable that the load capacitive element comprises a series connection of a first load capacitance and a second load capacitance between the first and second powers, and an intermediate point between the first and second load capacitances is connected to an output terminal of the inverter circuit.

It is also preferable that the equivalent internal capacitive part further comprises at least an equivalent internal capacitive element connected between the first and second powers.

It is also preferable that a plurality of the equivalent internal capacitive element is connected between the first and second powers, and the equivalent internal capacitive element comprises a series connection of a capacitance and a resistance between the first and second powers.

It is also preferable that the inverter circuit comprises a series connection of a p-channel MOS field effect transistor and an n-channel MOS field effect transistor, and gate electrodes of the p-channel and n-channel MOS field effect transistors are connected to a clock signal source for applying a clock signal to the gate electrodes of the p-channel and n-channel MOS field effect transistors.

It is also preferable that the logic gate circuit part further comprises plural pairs of an inverter circuit and a load capacitive element, and the inverter circuit is connected between the first and second powers and the load capacitive element is also connected between the first and second powers, and in each pair, the load capacitive element is placed closer to the equivalent internal capacitive part than the inverter circuit.

It is also preferable that the load capacitive element comprises a series connection of a first load capacitance and a second load capacitance between the first and second powers, and an intermediate point between the first and second load capacitances is connected to an output terminal of the inverter circuit.

It is also preferable that the equivalent internal capacitive part further comprises at least an equivalent internal capacitive element connected between the first and second powers.

It is also preferable that a plurality of the equivalent internal capacitive element is connected between the first and second powers, and the equivalent internal capacitive element comprises a series connection of a capacitance and a resistance between the first and second powers.

It is also preferable that the inverter circuit comprises a series connection of a p-channel MOS field effect transistor and an n-channel MOS field effect transistor, and gate electrodes of the p-channel and n-channel MOS field effect transistors are connected to a clock signal source for applying a clock signal to the gate electrodes of the p-channel and n-channel MOS field effect transistors.

It is also preferable that the equivalent internal capacitive part is placed between the logic gate circuit part and a power system side.

Accordingly, the present invention also provides a novel power model for an electro-magnetic interference simulation to a semiconductor integrated circuit free from the above problems.

The present invention also provides a novel power model for an electro-magnetic interference simulation to a semiconductor integrated circuit, wherein the power model allows an extremely accurate electro-magnetic interference simulation from a power system of a printed board.

The present invention also provides a novel power model for an electro-magnetic interference simulation to a semiconductor integrated circuit, wherein the power model makes it easy to conduct an extremely accurate electro-magnetic interference simulation from a power system of a printed board.

The present invention also provides a novel power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

The present invention also provides a novel power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

The present invention also provides a novel method of designing a power model for an electro-magnetic interference simulation to a semiconductor integrated circuit free from the above problems.

The present invention also provides a novel method of designing a power model for an electro-magnetic interference simulation to a semiconductor integrated circuit, wherein the method allows an extremely accurate electro-magnetic interference simulation from a power system of a printed board.

The present invention also provides a novel method of designing a power model for an electro-magnetic interference simulation to a semiconductor integrated circuit, wherein the method makes it easy to conduct an extremely accurate electro-magnetic interference simulation from a power system of a printed board.

The present invention also provides a novel method of designing a power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

The present invention also provides a novel method of designing a power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

The present invention also provides a novel electro-magnetic interference simulator using a power model for an electro-magnetic interference simulation to a semiconductor integrated circuit free from the above problems.

The present invention also provides a novel electro-magnetic interference simulator using a power model for an electro-magnetic interference simulation to a semiconductor integrated circuit, wherein the electro-magnetic interference simulator allows an extremely accurate electro-magnetic interference simulation from a power system of a printed board.

The present invention also provides a novel electro-magnetic interference simulator using a power model for an electro-magnetic interference simulation to a semiconductor integrated circuit, wherein the electro-magnetic interference simulator makes it easy to conduct an extremely accurate electro-magnetic interference simulation from a power system of a printed board.

The present invention also provides a novel electro-magnetic interference simulator using a power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

The present invention also provides a novel electro-magnetic interference simulator using a power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

The present invention also provides a novel power model preparation computer program for preparing a power model for an electro-magnetic interference simulation to a semiconductor integrated circuit free from the above problems.

The present invention also provides a novel power model preparation computer program for preparing a power model for an electro-magnetic interference simulation to a semiconductor integrated circuit, wherein the power model preparation computer program allows an extremely accurate electro-magnetic interference simulation from a power system of a printed board.

The present invention also provides a novel power model preparation computer program for preparing a power model for an electro-magnetic interference simulation to a semiconductor integrated circuit, wherein the power model preparation computer program makes it easy to conduct an extremely accurate electro-magnetic interference simulation from a power system of a printed board.

The present invention also provides a novel power model preparation computer program for preparing a power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

The present invention also provides a novel power model preparation computer program for preparing a power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

The present invention also provides a novel storage medium for storing a power model preparation computer program for preparing a power model for an electro-magnetic interference simulation to a semiconductor integrated circuit free from the above problems.

The present invention also provides a novel storage medium for storing a power model preparation computer program for preparing a power model for an electro-magnetic interference simulation to a semiconductor integrated circuit, wherein the power model preparation computer program allows an extremely accurate electro-magnetic interference simulation from a power system of a printed board.

The present invention also provides a novel storage medium for storing a power model preparation computer program for preparing a power model for an electro-magnetic interference simulation to a semiconductor integrated circuit, wherein the power model preparation computer program makes it easy to conduct an extremely accurate electro-magnetic interference simulation from a power system of a printed board.

The present invention also provides a novel storage medium for storing a power model preparation computer program for preparing a power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

The present invention also provides a novel storage medium for storing a power model preparation computer program for preparing a power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

The present invention also provides a novel power model design support system for supporting a design for a power model for an electro-magnetic interference simulation to a semiconductor integrated circuit free from the above problems.

The present invention also provides a novel power model design support system for supporting a design for a power model for an electro-magnetic interference simulation to a semiconductor integrated circuit, wherein the power model allows an extremely accurate electro-magnetic interference simulation from a power system of a printed board.

The present invention also provides a novel power model design support system for supporting a design for a power model for an electro-magnetic interference simulation to a semiconductor integrated circuit, wherein the power model makes it easy to conduct an extremely accurate electro-magnetic interference simulation from a power system of a printed board.

The present invention also provides a novel power model design support system for supporting a design for a power model for an electro-magnetic interference simulation to a semiconductor integrated circuit, wherein the power model is designed on the basis of all informations about connections and interconnections of the circuits to allow an extremely accurate electro-magnetic interference simulation from a power system of a printed board.

The present invention also provides a novel power model design support system for supporting a design for a power model for an electro-magnetic interference simulation to a semiconductor integrated circuit, wherein the power model is designed on the basis of all informations about connections and interconnections of the circuits to make it easy to conduct an extremely accurate electro-magnetic interference simulation from a power system of a printed board.

### FIRST EMBODIMENT:

A first embodiment according to the present invention will be described in detail with reference to the drawings. FIG. 3 is a circuit diagram illustrative of a first novel power model for an electro-magnetic interference simulation to a semiconductor integrated circuit in a first embodiment in accordance with the present invention. The first novel power model 18 has a first power 7 and a second power 8. The first novel power model 18 also has the following elements. An operational signal source (a clock signal source) 1 is provided which is connected to the second power 8. An inverter circuit 2 is also provided which is connected between the first and second powers 7 and 8. The inverter circuit 2 is further connected to the operational signal source (a clock signal source) 1 for receiving a lock signal from the operational signal source (a clock signal source) 1. First and second load capacities 5 and 6 are also provided which are connected in series between the first and second powers 7 and 8, wherein the first load capacity 5 is directly connected to the first power 7, whilst the second load capacity 6 is directly connected to the first power 8. The inverter circuit 2 comprises a series connection of a p-channel MOS field effect transistor 3 and an n-channel MOS field effect transistor 4 between the first and second powers 7 and 8. A gate of the p-channel MOS field effect transistor 3 is connected to the operational signal source (a clock signal source) 1 for receiving a lock signal from the operational signal source (a clock signal source) 1. A gate of the n-channel MOS field effect transistor 4 is also connected to the operational signal source (a clock signal source) 1 for receiving a lock signal from the operational signal source (a clock signal source) 1. The p-channel MOS field effect transistor 3 is connected between the first power 7 and an output terminal 71 of the inverter circuit 2. The n-channel MOS field effect transistor 4 is connected between the second power 8 and the output terminal 71 of the inverter circuit 2. The output terminal 71 of the inverter circuit 2 is connected to an intermediate point between the first and second load capacities 5 and 6. A first equivalent internal capacitive element 9 is provided which is connected between the first and second powers 7 and 8. The series connection of the first and second load capacities 5 and 6 is placed between the inverter circuit 2 and the first equivalent internal capacitive element 9. The first equivalent internal capacitive element 9 further comprises a series connection of a first equivalent internal capacity 12 and a first equivalent internal series resistance 13. The first equivalent internal capacity 12 is directly connected to the first power 7, whilst the first equivalent internal series resistance 13 is directly connected to the second power 8. A second equivalent internal capacitive element 10 is provided which is connected between the first and second powers 7 and 8. The first equivalent internal capacitive element 9 is placed between the series connection of the first and second load capacities 5 and 6 and the second equivalent internal capacitive element 10. The second equivalent internal capacitive element 10 further comprises a series connection of a second equivalent internal capacity 15 and a second equivalent internal series resistance 14. The second equivalent internal capacity 15 is directly connected to the second power 8, whilst the second equivalent internal series resistance 14 is directly connected to the first power 7. A third equivalent internal capacitive element 11 is provided which is connected between the first and second powers 7 and 8. The second equivalent internal capacitive element 10 is placed between the first equivalent internal capacitive element 9 and the third equivalent internal capacitive element 11. The third equivalent internal capacitive element 11 further comprises a series connection of a third equivalent internal capacity 17 and a third equivalent internal series resistance 16. The third equivalent internal capacity 17 is directly connected to the second power 8, whilst the third equivalent internal series resistance 16 is directly connected to the first power 7. An equivalent internal capacitive part comprising the first, second and third equivalent internal capacitive elements 9, 10 and 11 is placed between the inverter circuit 2 and the power side having the first and second powers 7 and 8. The gate circuit comprises the inverter circuit 2 and the series connection of the first and second load capacities 5 and 6. Namely, the equivalent internal capacitive part is placed between the gate circuit and the power side having the first and second powers 7 and 8. The operational signal source (a clock signal source) 1 generates a frequency-fixed signal such as a clock signal.

The logic gate circuit having the inverter circuit represents operating state parts of the semiconductor integrated circuit in accordance with the frequency-fixed signal such as the clock signal. The equivalent internal capacitive part represents non-operating state parts of the semiconductor integrated circuits, wherein the non-operating state parts are in the rest state, even the non-operating state parts are potentially operable in accordance with the frequency-fixed signal such as the clock signal. The equivalent internal capacitive part also represents an operating-irrelevant fixed part of the semiconductor integrated circuit, wherein the operating-irrelevant fixed part of the semiconductor integrated circuit corresponds to a constant capacitance value, and the operating-irrelevant fixed part of the semiconductor integrated circuit is previously decided in the design process and independent from the operating and non-operating states. The logic gate circuit having the inverter circuit 2 and the first and second load capacitances 5 and 6 corresponds to the operating state parts of the semiconductor integrated circuit. The first equivalent internal capacitive element 9 corresponds to the operating-irrelevant fixed part of the semiconductor integrated circuit. The second and third equivalent internal capacitive elements 10 and 11 correspond to the non-operating state parts of the semiconductor integrated circuit.

The first novel electro-magnetic interference (EMI) simulation power mode is represented in the transistor description format for conducting the simulation to the radiation electro-magnetic field generated on the printed board. This transistor description format large scale integrated circuit power model is largely reduced in the number of transistors constituting this model. The electro-magnetic interference (EMI) simulator utilizes this transistor description format large scale integrated circuit power model to find a power current which flows on an interconnection of a printed board. This transistor description format large scale integrated circuit power model is prepared by extracting operating parts from a net-list for the large scale integrated circuit to reduce the number of transistors constituting this model. Non-operating state parts of the large scale integrated circuit are simplified to be incorporated into the power model. Namely, the transistor description format large scale integrated circuit power model includes the operating state parts extracted from the net-list and the simplified non-operating state parts, so that all of the parts of the large scale integrated circuit are utilized to prepare the transistor description format large scale integrated circuit power model.

The power system of the large scale integrated circuit is modeled into the logic gate part and the equivalent internal capacitive part. As compared to the conventional transistor description format large scale integrated circuit power model, a calculation load to the electro-magnetic interference (EMI) simulator is reduced, thereby making it easy to conduct the power current analysis. The non-operating state parts of the large scale integrated circuit are considered on the electro-magnetic interference (EMI) simulation, whereby the large scale integrated circuit model shows similar operations or behaviors to the actual operations or behaviors of the actual large scale integrated circuit. This makes it possible to find a highly accurate power current of the large scale integrated circuit. Since the confidential detailed informations about the internal circuit configurations of the large scale integrated circuit and the device structures are not included in this transistor description format large scale integrated circuit power model, the maker who manufactures the large scale integrated circuit is likely to show this transistor description format large scale integrated circuit power model to the user with keeping the detailed informations to be confidential.

### SECOND EMBODIMENT:

A second embodiment according to the present invention will be described in detail with reference to the drawings. FIG. 4 is a circuit diagram illustrative of a second novel power model for an electro-magnetic interference simulation to a semiconductor integrated circuit in a second embodiment in accordance with the present invention. The second novel power model 29 has a first power 7 and a second power 8. The second novel power model 29 also has the following elements. An operational signal source (a clock signal source) 1 is provided which is connected to the second power 8. A logic gate circuit part comprises two stages. A first stage has a first stage inverter circuit 19 and a first series connection of first and second first-stage load capacities 22 and 23. The first stage inverter circuit 19 is connected between the first and second powers 7 and 8. The first stage inverter circuit 19 is further connected to the operational signal source (a clock signal source) 1 for receiving a lock signal from the operational signal source (a clock signal source) 1. The first and second first-stage load capacities 22 and 23 are connected in series between the first and second powers 7 and 8, wherein the first first-stage load capacity 22 is directly connected to the first power 7, whilst the second first-stage load capacity 23 is directly connected to the first power 8. The first stage inverter circuit 19 comprises a series connection of a p-channel MOS field effect transistor 20 and an n-channel MOS field effect transistor 21 between the first and second powers 7 and 8. A gate of the p-channel MOS field effect transistor 20 is connected to the operational signal source (a clock signal source) 1 for receiving a lock signal from the operational signal source (a clock signal source) 1. A gate of the n-channel MOS field effect transistor 21 is also connected to the operational signal source (a clock signal source) 1 for receiving a lock signal from the operational signal source (a clock signal source) 1. The p-channel MOS field effect transistor 20 is connected between the first power 7 and an output terminal 71 of the first stage inverter circuit 19. The n-channel MOS field effect transistor 21 is connected between the second power 8 and the output terminal 71 of the first stage inverter circuit 19. The output terminal 71 of the first stage inverter circuit 19 is connected to an intermediate point between the first and second first-stage load capacities 22 and 23. A second-stage has a second-stage inverter circuit 24 and a second series connection of first and second second-stage load capacities 27 and 28. The second-stage inverter circuit 24 is connected between the first and second powers 7 and 8. The second-stage inverter circuit 24 is further connected to the output terminal 71 of the first-stage inverter circuit 19 for receiving an output signal from the first-stage inverter circuit 19. The first and second second-stage load capacities 27 and 28 are connected in series between the first and second powers 7 and 8, wherein the first second-stage load capacity 27 is directly connected to the first power 7, whilst the second second-stage load capacity 28 is directly connected to the first power 8. The second-stage inverter circuit 24 comprises a series connection of a p-channel MOS field effect transistor 25 and an n-channel MOS field effect transistor 26 between the first and second powers 7 and 8. A gate of the p-channel MOS field effect transistor 25 is connected to the output terminal 71 of the first-stage inverter circuit 19 for receiving an output signal from the first-stage inverter circuit 19. A gate of the n-channel MOS field effect transistor 26 is also connected to the output terminal 71 of the first-stage inverter circuit 19 for receiving an output signal from the first-stage inverter circuit 19. The p-channel MOS field effect transistor 25 is connected between the first power 7 and an output terminal 72 of the second-stage inverter circuit 24. The n-channel MOS field effect transistor 26 is connected between the second power 8 and the output terminal 72 of the second-stage inverter circuit 24. The output terminal 72 of the second-stage inverter circuit 24 is connected to an intermediate point between the first and second second-stage load capacities 27 and 28. A first equivalent internal capacitive element 9 is provided which is connected between the first and second powers 7 and 8. The first equivalent internal capacitive element 9 further comprises a series connection of a first equivalent internal capacity 12 and a first equivalent internal series resistance 13. The first equivalent internal capacity 12 is directly connected to the first power 7, whilst the first equivalent internal series resistance 13 is directly connected to the second power 8. A second equivalent internal capacitive element 10 is provided which is connected between the first and second powers 7 and 8. The first equivalent internal capacitive element 9 is placed between the series connection of the first and second second-stage load capacities 27 and 28 and the second equivalent internal capacitive element 10. The second equivalent internal capacitive element 10 further comprises a series connection of a second equivalent internal capacity 15 and a second equivalent internal series resistance 14.

The second equivalent internal capacity 15 is directly connected to the second power 8, whilst the second equivalent internal series resistance 14 is directly connected to the first power 7. A third equivalent internal capacitive element 11 is provided which is connected between the first and second powers 7 and 8. The second equivalent internal capacitive element 10 is placed between the first equivalent internal capacitive element 9 and the third equivalent internal capacitive element 11. The third equivalent internal capacitive element 11 further comprises a series connection of a third equivalent internal capacity 17 and a third equivalent internal series resistance 16. The third equivalent internal capacity 17 is directly connected to the second power 8, whilst the third equivalent internal series resistance 16 is directly connected to the first power 7. An equivalent internal capacitive part comprising the first, second and third equivalent internal capacitive elements 9, 10 and 11 is placed between the second-stage inverter circuit 24 and the power side having the first and second powers 7 and 8. The gate circuit comprises the first-stage inverter circuit 19 and the first series connection of the first and second first-stage load capacities 22 and 23, and further the second-stage inverter circuit 24 and the second series connection of the first and second second-stage load capacities 27 and 28. Namely, the equivalent internal capacitive part is placed between the logic gate circuit and the power side having the first and second powers 7 and 8. The operational signal source (a clock signal source) 1 generates a frequency-fixed signal such as a clock signal.

The two stage logic gate circuit represents operating state parts of the semiconductor integrated circuit in accordance with the frequency-fixed signal such as the clock signal. The equivalent internal capacitive part represents non-operating state parts of the semiconductor integrated circuits, wherein the non-operating state parts are in the rest state, even the non-operating state parts are potentially operable in accordance with the frequency-fixed signal such as the clock signal. The equivalent internal capacitive part also represents an operating-irrelevant fixed part of the semiconductor integrated circuit, wherein the operating-irrelevant fixed part of the semiconductor integrated circuit corresponds to a constant capacitance value, and the operating-irrelevant fixed part of the semiconductor integrated circuit is previously decided in the design process and independent from the operating and non-operating states. The logic gate circuit having the first-stage inverter circuit 19 and the first and second first-stage load capacitances 22 and 23 and also having the second-stage inverter circuit 24 and the first and second second-stage load capacitances 27 and 28 corresponds to the operating state parts of the semiconductor integrated circuit. The first equivalent internal capacitive element 9 corresponds to the operating-irrelevant fixed part of the semiconductor integrated circuit. The second and third equivalent internal capacitive elements 10 and 11 correspond to the non-operating state parts of the semiconductor integrated circuit.

In order to make the second novel power model equivalent in time-mean current to the first novel power model, respective gate electrode widths of the p-channel and n-channel MOS field effect transistors 20, 21, 25 and 26 of the second novel power model are reduced to one half of respective gate electrode widths of the p-channel and n-channel MOS field effect transistors 3 and 4 of the first power model. Further, respective gate electrode capacitances of the p-channel and n-channel MOS field effect transistors 20, 21, 25 and 26 of the second novel power model are reduced to one half of respective gate electrode capacitances of the p-channel and n-channel MOS field effect transistors 3 and 4 of the first power model. Further more, respective interconnection capacitances of the second novel power model are reduced to one half of respective interconnection capacitances of the first power model. Moreover, respective ON-resistances of the p-channel and n-channel MOS field effect transistors 20, 21, 25 and 26 of the second novel power model are increased to two times of respective ON-resistances of the p-channel and n-channel MOS field effect transistors 3 and 4 of the first power model.

The second novel electro-magnetic interference (EMI) simulation power mode is represented in the transistor description format for conducting the simulation to the radiation electro-magnetic field generated on the printed board. This transistor description format large scale integrated circuit power model is largely reduced in the number of transistors constituting this model. The electro-magnetic interference (EMI) simulator utilizes this transistor description format large scale integrated circuit power model to find a power current which flows on an interconnection of a printed board. This transistor description format large scale integrated circuit power model is prepared by extracting operating parts from a net-list for the large scale integrated circuit to reduce the number of transistors constituting this model. Non-operating state parts of the large scale integrated circuit are simplified to be incorporated into the power model. Namely, the transistor description format large scale integrated circuit power model includes the operating state parts extracted from the net-list and the simplified non-operating state parts, so that all of the parts of the large scale integrated circuit are utilized to prepare the transistor description format large scale integrated circuit power model.

The power system of the large scale integrated circuit is modeled into the logic gate part and the equivalent internal capacitive part. As compared to the conventional transistor description format large scale integrated circuit power model, a calculation load to the electro-magnetic interference (EMI) simulator is reduced, thereby making it easy to conduct the power current analysis. The non-operating state parts of the large scale integrated circuit are considered on the electro-magnetic interference (EMI) simulation, whereby the large scale integrated circuit model shows similar operations or behaviors to the actual operations or behaviors of the actual large scale integrated circuit. This makes it possible to find a highly accurate power current of the large scale integrated circuit. Since the confidential detailed informations about the internal circuit configurations of the large scale integrated circuit and the device structures are not included in this transistor description format large scale integrated circuit power model, the maker who manufactures the large scale integrated circuit is likely to show this transistor description format large scale integrated circuit power model to the user with keeping the detailed informations to be confidential.

### THIRD EMBODIMENT:

A third embodiment according to the present invention will be described in detail with reference to the drawings. FIG. 5 is a circuit diagram illustrative of a third novel power model for an electro-magnetic interference simulation to a semiconductor integrated circuit in a third embodiment in accordance with the present invention. The third novel power model 30 has two sets of a power system, for example, a first set of a first power and a second power 33 and 34 and a second set of a third power and a fourth power 35 and 36, wherein the first set of the first and second powers 33 and 34 is independent from the second set of the third and fourth powers 35 and 36. In this case, a power model 31 is provided for the first set of the first and second powers 33 and 34 as well as a power model 32 is also provided for the second set of the third and fourth powers 35 and 36. Each of the power models 31 and 32 may comprise either the above described first or second novel power model described in the above first and second embodiments. Namely, the novel power model in accordance with the present invention is provided for each of the plural power systems which are independent from each other.

### FOURTH EMBODIMENT:

A fourth embodiment according to the present invention will be described in detail with reference to the drawings. FIG. 6 is a circuit diagram illustrative of a fourth novel power model for an electro-magnetic interference simulation to a semiconductor integrated circuit in a fourth embodiment in accordance with the present invention. The fourth novel power model 30 has first and second powers 7 and 8. In this embodiment, internal circuit configurations of the semiconductor integrated circuit are divided into plural blocks on the basis of arrangement informations, and the power model 37 is provided for each of the plural blocks. Namely, the plural power models 37 are individually provided for the plural blocks of the semiconductor integrated circuit. Each of the plural power models 37 is connected between the first and second powers 7 and 8. Namely, the plural power models 37 are connected in parallel to each other between the first and second powers 7 and 8. Each of the power models 37 may comprise either the above described first or second novel power model described in the above first and second embodiments. Namely, the novel power model in accordance with the present invention is provided for each of the plural blocks which are divided from the internal circuit configurations of the semiconductor integrated circuit on the basis of the arrangement or replacement informations of the circuit elements.

### FIFTH EMBODIMENT:

A fifth embodiment according to the present invention will be described in detail with reference to the drawings. FIG. 7 is a circuit diagram illustrative of a fifth novel power model for an electro-magnetic interference simulation to a semiconductor integrated circuit in a fifth embodiment in accordance with the present invention. The fifth novel power model 30 has first and second powers 7 and 8. In this embodiment, internal circuit configurations of the semiconductor integrated circuit are divided into plural groups. Each of the plural groups comprises the same timing group which includes logic gate circuits having individual signal transmission delay times fallen in a group-belonging predetermined time range which belongs to each of the plural groups. Namely, the internal circuit configurations of the semiconductor integrated circuit are divided into plural groups on the basis of the signal transmission delay time of the logic gate circuits. The power model is provided for each of the plural groups. Namely, the plural power models 37 are individually provided for the plural blocks of the semiconductor integrated circuit. Each of the plural power models 37 is connected between the first and second powers 7 and 8. Namely, the plural power models 37 are connected in parallel to each other between the first and second powers 7 and 8. Each of the power models 37 may comprise either the above described first or second novel power model described in the above first and second embodiments. Namely, the novel power model in accordance with the present invention is provided for each of the plural blocks which are divided from the internal circuit configurations of the semiconductor integrated circuit on the basis of the signal transmission delay time of the logic gate circuits.

### SIXTH EMBODIMENT:

A sixth embodiment according to the present invention will be described in detail with reference to the drawings. FIG. 8 is flow chart illustrative of novel processes for modeling internal circuit configurations of a semiconductor integrated circuit into a single gate circuit, wherein the novel processes are involved in a first novel method of designing a power model for an electro-magnetic interference simulation to a semiconductor integrated circuit in a sixth embodiment in accordance with the present invention. All of the circuit configuration informations of the semiconductor integrated circuit are stored in a data base or a net list.

In a step S1, all of the gate circuits in an operating state in accordance with an operational frequency or a clock frequency are extracted from the data base. In second, third and fourth steps S2, S3 and S4, the all of the gate circuits in the operating state are modeled into a single gate circuit in order to prepare the above first power model described in the first embodiment in accordance with the present invention.

Namely, in the second step S2, the number "m" of the p-channel MOS field effect transistors in the operating state is confirmed. The sum "WP" of gate widths "WPn" of all of the p-channel MOS field effect transistors in the operating state is calculated. The sum "CP" of gate capacities "CPn" of all of the p-channel MOS field effect transistors in the operating state is calculated. The sum "CL1" of interconnection capacities "CL1n" between drains and the first power of all of the p-channel MOS field effect transistors in the operating state is calculated.

In the third step S3, the number "m" of the n-channel MOS field effect transistors in the operating state is confirmed. The sum "WN" of gate widths "WNn" of all of the n-channel MOS field effect transistors in the operating state is calculated. The sum "CN" of gate capacities "CNn" of all of the n-channel MOS field effect transistors in the operating state is calculated. The sum "CL2" of interconnection capacities "CL2n" between drains and the second power of all of the n-channel MOS field effect transistors in the operating state is calculated.

In the fourth step S4, the above logic gate circuit part of the above first novel power model shown in FIG. 3 is prepared. As described above, the logic gate circuit part of the above first novel power model comprises the single inverter circuit 2 and a single pair of the first and second load capacities 5 and 6. The inverter circuit 2 further comprises a single pair of the p-channel MOS field effect transistor 3 and the n-channel MOS field effect transistor 4. The sum "WP" is defined to be the gate width of the p-channel MOS field effect transistor 3. The sum "WN" is defined to be the gate width of the n-channel MOS field effect transistor 4. The sum ("CP" + "CL1") is defined to be the first load capacity 5. The sum ("CN" + "CL2") is defined to be the second load capacity 6. As a result, the logic gate circuit part of the first power model of the first embodiment is prepared.

### SEVENTH EMBODIMENT:

A seventh embodiment according to the present invention will be described in detail with reference to the drawings. FIG. 9 is flow chart illustrative of novel processes for modeling internal circuit configurations of a semiconductor integrated circuit into two-stage gate circuits, wherein the novel processes are involved in the first novel method of designing a power model for an electro-magnetic interference simulation to a semiconductor integrated circuit in a seventh embodiment in accordance with the present invention. All of the circuit configuration informations of the semiconductor integrated circuit are stored in a data base or a net list.

In a step S26, all of the gate circuits in an operating state in accordance with an operational frequency or a clock frequency are extracted from the data base. In second, third and fourth steps S27, S28 and S29, the all of the gate circuits in the operating state are modeled into two-stage gate circuits in order to prepare the above second power model described in the second embodiment in accordance with the present invention.

Namely, in the second step S27, the number "m" of the p-channel MOS field effect transistors in the operating state is confirmed. The sum "WP" of gate widths "WPn" of all of the p-channel MOS field effect transistors in the operating state is calculated. The sum "CP" of gate capacities "CPn" of all of the p-channel MOS field effect transistors in the operating state is calculated. The sum "CL1" of interconnection capacities "CL1n" between drains and the first power of all of the p-channel MOS field effect transistors in the operating state is calculated.

In the third step S28, the number "m" of the n-channel MOS field effect transistors in the operating state is confirmed. The sum "WN" of gate widths "WNn" of all of the n-channel MOS field effect transistors in the operating state is calculated. The sum "CN" of gate capacities "CNn" of all of the n-channel MOS field effect transistors in the operating state is calculated. The sum "CL2" of interconnection capacities "CL2n" between drains and the second power of all of the n-channel MOS field effect transistors in the operating state is calculated.

In the fourth step S29, the above logic gate circuit part of the above second novel power model shown in FIG. 4 is prepared. As described above, the logic gate circuit part of the above second novel power model comprises the first and second inverter circuits 19 and 24 and a first pair of the first and second load capacities 22 and 23 and a second pair of the third and fourth load capacities 27 and 28. The first inverter circuit 19 further comprises a single pair of the p-channel MOS field effect transistor 20 and the n-channel MOS field effect transistor 21. The second inverter circuit 24 further comprises another single pair of the p-channel MOS field effect transistor 25 and the n-channel MOS field effect transistor 26. The "WP/2" is defined to be the gate width of each of the p-channel MOS field effect transistors 20 and 25. The "WN/2" is defined to be the gate width of each of the n-channel MOS field effect transistors 21 and 26. The ("CP" + "CL1")/2 is defined to be each of the first and third load capacities 22 and 27. The ("CN" + "CL2")/2 is defined to be each of the second and fourth load capacities 23 and 28. As a result, the logic gate circuit part of the second power model of the second embodiment is prepared.

### EIGHTH EMBODIMENT:

An eighth embodiment according to the present invention will be described in detail with reference to the drawings. FIG. 10 is flow chart illustrative of novel processes for modeling internal circuit configurations of a semiconductor integrated circuit into a single gate circuit, wherein the novel processes are involved in a second novel method of designing a power model for an electro-magnetic interference simulation to a semiconductor integrated circuit in an eighth embodiment in accordance with the present invention. All of the circuit configuration informations of the semiconductor integrated circuit are stored in a data base or a net list.

In a step S5, a total number "NgateOP" of the gate circuits in an operating state in accordance with an operational frequency or a clock frequency is counted from all of the circuit configuration informations stored in the data base. In second, third and fourth steps S6, S7 and S8, on the basis of the averaged values of the gate widths and gate capacities of the n-channel and p-channel transistors and the averaged values of the interconnection capacities between the drains and the powers of the n-channel and p-channel transistors, all of the gate circuits in the operating state are modeled into a single gate circuit in order to prepare the above first power model described in the first embodiment in accordance with the present invention.

Namely, in the second step S6, the averaged value "WPave" of gate widths "WPn" of all of the p-channel MOS field effect transistors in the operating state is calculated. The averaged value "CPave" of gate capacities "CPn" of all of the p-channel MOS field effect transistors in the operating state is calculated. The averaged value "CL1ave" of interconnection capacities "CL1n" between drains and the first power of all of the p-channel MOS field effect transistors in the operating state is calculated.

In the third step S7, the averaged value "WNave" of gate widths "WNn" of all of the n-channel MOS field effect transistors in the operating state is calculated. The averaged value "CNave" of gate capacities "CNn" of all of the n-channel MOS field effect transistors in the operating state is calculated. The averaged value "CL2ave" of interconnection capacities "CL2n" between drains and the second power of all of the n-channel MOS field effect transistors in the operating state is calculated.

In the fourth step S8, the above logic gate circuit part of the above first novel power model shown in FIG. 3 is prepared. As described above, the logic gate circuit part of the above first novel power model comprises the single inverter circuit 2 and a single pair of the first and second load capacities 5 and 6. The inverter circuit 2 further comprises a single pair of the p-channel MOS field effect transistor 3 and the n-channel MOS field effect transistor 4. The product "NgateOP x WPave" of the total number "NgateOP" of the gate circuits in the operating state and the averaged value "WPave" is calculated, so that the product "NgateOP X WPave" is defined to be the gate width of the p-channel MOS field effect transistor 3. The product "NgateOP X WNave" of the total number "NgateOP" of the gate circuits in the operating state and the averaged value "WNave" is calculated, so that the product "NgateOP X WNave" is defined to be the gate width of the n-channel MOS field effect transistor 4. The product "NgateOP x ("CPave" + "CL1ave")" of total number "NgateOP" of the gate circuits in the operating state and the averaged value ("CPave" + "CL1ave") is calculated, so that the product "NgateOP X ("CPave" + "CL1ave")" is defined to be the first load capacity 5. The product "NgateOP X ("CNave" + "CL2ave")" of total number "NgateOP" of the gate circuits in the operating state and the averaged value ("CNave" + "CL2ave") is calculated, so that the product "NgateOP x ("CNave" + "CL2ave")" is defined to be the second load capacity 6. As a result, the logic gate circuit part of the first power model of the first embodiment is prepared.

### NINTH EMBODIMENT:

A ninth embodiment according to the present invention will be described in detail with reference to the drawings. FIG. 11 is flow chart illustrative of novel processes for modeling internal circuit configurations of a semiconductor integrated circuit into two-stage gate circuits, wherein the novel processes are involved in a second novel method of designing a power model for an electro-magnetic interference simulation to a semiconductor integrated circuit in a ninth embodiment in accordance with the present invention. All of the circuit configuration informations of the semiconductor integrated circuit are stored in a data base or a net list.

In a step S30, a total number "NgateOP" of the gate circuits in an operating state in accordance with an operational frequency or a clock frequency is counted from all of the circuit configuration informations stored in the data base. In second, third and fourth steps S31, S32 and S33, on the basis of the averaged values of the gate widths and gate capacities of the n-channel and p-channel transistors and the averaged values of the interconnection capacities between the drains and the powers of the n-channel and p-channel transistors, all of the gate circuits in the operating state are modeled into two-stage gate circuits in order to prepare the above second power model described in the second embodiment in accordance with the present invention.

Namely, in the second step S31, the averaged value "WPave" of gate widths "WPn" of all of the p-channel MOS field effect transistors in the operating state is calculated. The averaged value "CPave" of gate capacities "CPn" of all of the p-channel MOS field effect transistors in the operating state is calculated. The averaged value "CL 1 ave" of interconnection capacities "CL1n" between drains and the first power of all of the p-channel MOS field effect transistors in the operating state is calculated.

In the third step S32, the averaged value "WNave" of gate widths "WNn" of all of the n-channel MOS field effect transistors in the operating state is calculated. The averaged value "CNave" of gate capacities "CNn" of all of the n-channel MOS field effect transistors in the operating state is calculated. The averaged value "CL2ave" of interconnection capacities "CL2n" between drains and the second power of all of the n-channel MOS field effect transistors in the operating state is calculated.

In the fourth step S33, the above logic gate circuit part of the above second novel power model shown in FIG. 4 is prepared. As described above, the logic gate circuit part of the above second novel power model comprises the first and second inverter circuits 19 and 24 and a first pair of the first and second load capacities 22 and 23 and a second pair of the third and fourth load capacities 27 and 28. The first inverter circuit 19 further comprises a single pair of the p-channel MOS field effect transistor 20 and the n-channel MOS field effect transistor 21. The second inverter circuit 24 further comprises another single pair of the p-channel MOS field effect transistor 25 and the n-channel MOS field effect transistor 26. The product "NgateOP X WPave" of the total number "NgateOP" of the gate circuits in the operating state and the averaged value "WPave" is calculated, so that a half "(NgateOP x WPave)/2" of the product "NgateOP x WPave" is defined to be the gate width of each of the p-channel MOS field effect transistors 20 and 25. The product "NgateOP X WNave" of the total number "NgateOP" of the gate circuits in the operating state and the averaged value "WNave" is calculated, so that a half "(NgateOP X WNave)/2" of the product "NgateOP x WNave" is defined to be the gate width of each of the n-channel MOS field effect transistors 21 and 26. The product "NgateOP X ("CPave" + "CL1ave")" of total number "NgateOP" of the gate circuits in the operating state and the averaged value ("CPave" + "CL1ave") is calculated, so that a half "{NgateOP X ("CPave" + "CLlave")}/2" of the product "NgateOP x ("CPave" + "CL1ave")" is defined to be each of the first and third load capacities 22 and 27. The product "NgateOP X ("CNave" + "CL2ave")" of total number "NgateOP" of the gate circuits in the operating state and the averaged value ("CNave" + "CL2ave") is calculated, so that a half "{NgateOP X ("CNave" + "CL2ave")}/2" of the product "NgateOP x ("CNave" + "CL2ave")" is defined to be each of the second and fourth load capacities 23 and 28. As a result, the logic gate circuit part of the second power model of the second embodiment is prepared.

### TENTH EMBODIMENT:

A tenth embodiment according to the present invention will be described in detail with reference to the drawings. FIG. 12 is flow chart illustrative of novel processes for modeling internal circuit configurations of a semiconductor integrated circuit into a single gate circuit, wherein the novel processes are involved in a third novel method of designing a power model for an electro-magnetic interference simulation to a semiconductor integrated circuit in a tenth embodiment in accordance with the present invention. All of the circuit configuration informations of the semiconductor integrated circuit are stored in a data base or a net list.

In a step S9, a total number "Ngate" of the all gate circuits included in the semiconductor integrated circuit is counted from all of the circuit configuration informations stored in the data base. In second, third, fourth and fifth steps S10, S11, S12 and S13, on the basis of the averaged values of the gate widths and gate capacities of the n-channel and p-channel transistors and the averaged values of the interconnection capacities between the drains and the powers of the n-channel and p-channel transistors as well as an average operational rate, all of the gate circuits in the operating state are modeled into a single gate circuit in order to prepare the above first power model described in the first embodiment in accordance with the present invention.

Namely, in the second step S10, an average operational rate "ROPave" of the gate circuits is calculated, wherein the average operational rate is defined to be the averaged value of the rate of the operating gate circuits in the operating state in accordance with an operational frequency or a clock frequency to the total gate circuits included in the semiconductor integrated circuit.

In the third step S11, the averaged value "WPave" of gate widths "WPn" of all of the p-channel MOS field effect transistors included in the semiconductor integrated circuit is calculated. The averaged value "CPave" of gate capacities "CPn" of all of the p-channel MOS field effect transistors included in the semiconductor integrated circuit is calculated. The averaged value "CL1ave" of interconnection capacities "CL1n" between drains and the first power of all of the p-channel MOS field effect transistors included in the semiconductor integrated circuit is calculated.

In the fourth step S12, the averaged value "WNave" of gate widths "WNn" of all of the n-channel MOS field effect transistors included in the semiconductor integrated circuit is calculated. The averaged value "CNave" of gate capacities "CNn" of all of the n-channel MOS field effect transistors included in the semiconductor integrated circuit is calculated. The averaged value "CL2ave" of interconnection capacities "CL2n" between drains and the second power of all of the n-channel MOS field effect transistors included in the semiconductor integrated circuit is calculated.

In the fifth step S13, the above logic gate circuit part of the above first novel power model shown in FIG. 3 is prepared. As described above, the logic gate circuit part of the above first novel power model comprises the single inverter circuit 2 and a single pair of the first and second load capacities 5 and 6. The inverter circuit 2 further comprises a single pair of the p-channel MOS field effect transistor 3 and the n-channel MOS field effect transistor 4. The product "Ngate x ROPave x WPave" of the total number "Ngate" of the all gate circuits, and the average operational rate "ROPave", and the averaged value "WPave" is calculated, so that the product "Ngate X ROPave x WPave" is defined to be the gate width of the p-channel MOS field effect transistor 3. The product "Ngate xROPave x WNave" of the total number "Ngate" of the all gate circuits, and the average operational rate "ROPave", and the averaged value "WNave" is calculated, so that the product "Ngate×RoPave×WNave" is defined to be the gate width of the n-channel MOS field effect transistor 4. The product "Ngate × ROPave X ("CPave" + "CL1ave")" of total number "Ngate" of the all gate circuits, and the average operational rate "ROPave", and the averaged value ("CPave" + "CL1ave") is calculated, so that the product "Ngate x ROPave X ("CPave" + "CL1ave")" is defined to be the first load capacity 5. The product "Ngate × ROPave × ("CNave" + "CL2ave")" of total number "Ngate" of the all gate circuits, and the average operational rate "ROPave", and the averaged value ("CNave" + "CL2ave") is calculated, so that the product "Ngate X ROPave X ("CNave" + "CL2ave")" is defined to be the second load capacity 6. As a result, the logic gate circuit part of the first power model of the first embodiment is prepared.

### ELEVENTH EMBODIMENT:

An eleventh embodiment according to the present invention will be described in detail with reference to the drawings. FIG. 13 is flow chart illustrative of novel processes for modeling internal circuit configurations of a semiconductor integrated circuit into two-stage gate circuits, wherein the novel processes are involved in a third novel method of designing a power model for an electro-magnetic interference simulation to a semiconductor integrated circuit in an eleventh embodiment in accordance with the present invention. All of the circuit configuration informations of the semiconductor integrated circuit are stored in a data base or a net list.

In a step S34, a total number "Ngate" of the all gate circuits included in the semiconductor integrated circuit is counted from all of the circuit configuration informations stored in the data base. In second, third, fourth and fifth steps S35, S36, S37 and S38, on the basis of the averaged values of the gate widths and gate capacities of the n-channel and p-channel transistors and the averaged values of the interconnection capacities between the drains and the powers of the n-channel and p-channel transistors as well as an average operational rate, all of the gate circuits in the operating state are modeled into two stage gate circuits in order to prepare the above second power model described in the second embodiment in accordance with the present invention.

Namely, in the second step S35, an average operational rate "ROPave" of the gate circuits is calculated, wherein the average operational rate is defined to be the averaged value of the rate of the operating gate circuits in the operating state in accordance with an operational frequency or a clock frequency to the total gate circuits included in the semiconductor integrated circuit.

In the third step S36, the averaged value "WPave" of gate widths "WPn" of all of the p-channel MOS field effect transistors included in the semiconductor integrated circuit is calculated. The averaged value "CPave" of gate capacities "CPn" of all of the p-channel MOS field effect transistors included in the semiconductor integrated circuit is calculated. The averaged value "CL1ave" of interconnection capacities "CL1n" between drains and the first power of all of the p-channel MOS field effect transistors included in the semiconductor integrated circuit is calculated.

In the fourth step S37, the averaged value "WNave" of gate widths "WNn" of all of the n-channel MOS field effect transistors included in the semiconductor integrated circuit is calculated. The averaged value "CNave" of gate capacities "CNn" of all of the n-channel MOS field effect transistors included in the semiconductor integrated circuit is calculated. The averaged value "CL2ave" of interconnection capacities "CL2n" between drains and the second power of all of the n-channel MOS field effect transistors included in the semiconductor integrated circuit is calculated.

In the fifth step S38, the above logic gate circuit part of the above second novel power model shown in FIG. 4 is prepared. As described above, the logic gate circuit part of the above second novel power model comprises the first and second inverter circuits 19 and 24 and a first pair of the first and second load capacities 22 and 23 and a second pair of the third and fourth load capacities 27 and 28. The first inverter circuit 19 further comprises a single pair of the p-channel MOS field effect transistor 20 and the n-channel MOS field effect transistor 21. The second inverter circuit 24 further comprises another single pair of the p-channel MOS field effect transistor 25 and the n-channel MOS field effect transistor 26. The product "Ngate x ROPave X WPave" of the total number "Ngate" of the all gate circuits, and the average operational rate "ROPave", and the averaged value "WPave" is calculated, so that a half "{Ngate X ROPave X WPave}/2" of the product "Ngate X ROPave X WPave" is defined to be the gate width of each of the p-channel MOS field effect transistors 20 and 25. The product "Ngate × ROPave × WNave" of the total number "Ngate" of the all gate circuits, and the average operational rate "ROPave", and the averaged value "WNave" is calculated, so that a half "{Ngate X ROPave × WNave}/2" of the product "Ngate X ROPave x WNave" is defined to be the gate width of each of the n-channel MOS field effect transistors 21 and 26. The product "Ngate x ROPave x ("CPave" + "CL 1 ave")" of total number "Ngate" of the all gate circuits, and the average operational rate "ROPave", and the averaged value ("CPave" + "CL1ave") is calculated, so that a half "{Ngate × ROPave x ("CPave" + "CL1ave")}/2" of the product "Ngate X ROPave X ("CPave" + "CL1ave")" is defined to be each of the first and third load capacities 22 and 27. The product "Ngate × ROPave X ("CNave" + "CL2ave")" of total number "Ngate" of the all gate circuits in the operating state, and the average operational rate "ROPave", and the averaged value ("CNave" + "CL2ave") is calculated, so that a half "{Ngate X ROPave X ("CNave" + "CL2ave")}/2" of the product "Ngate X ROPave X ("CNave" + "CL2ave")" is defined to be each of the second and fourth load capacities 23 and 28. As a result, the logic gate circuit part of the second power model of the second embodiment is prepared.

### TWELFTH EMBODIMENT:

A twelfth embodiment according to the present invention will be described in detail with reference to the drawings. FIG. 14 is flow chart illustrative of novel processes for modeling internal circuit configurations of a semiconductor integrated circuit into a single gate circuit, wherein the novel processes are involved in a fourth novel method of designing a power model for an electro-magnetic interference simulation to a semiconductor integrated circuit in a twelfth embodiment in accordance with the present invention. All of the circuit configuration informations of the semiconductor integrated circuit are stored in a data base or a net list.

In a step S14, a total number "Ngate" of the all gate circuits included in the semiconductor integrated circuit is counted from all of the circuit configuration informations stored in the data base. In second, third, fourth and fifth steps S15, S16, S17 and S18, on the basis of the averaged values of the gate widths and gate capacities of the n-channel and p-channel transistors and the averaged values of the interconnection capacities between the drains and the powers of the n-channel and p-channel transistors as well as a maximum operational rate, all of the gate circuits in the operating state are modeled into a single gate circuit in order to prepare the above first power model described in the first embodiment in accordance with the present invention.

Namely, in the second step S15, a maximum operational rate "ROPmax" of the gate circuits is calculated, wherein the maximum operational rate is defined to be the maximum value of the rate of the operating gate circuits in the operating state in accordance with an operational frequency or a clock frequency to the total gate circuits included in the semiconductor integrated circuit.

In the third step S16, the averaged value "WPave" of gate widths "WPn" of all of the p-channel MOS field effect transistors included in the semiconductor integrated circuit is calculated. The averaged value "CPave" of gate capacities "CPn" of all of the p-channel MOS field effect transistors included in the semiconductor integrated circuit is calculated. The averaged value "CL1ave" of interconnection capacities "CL1n" between drains and the first power of all of the p-channel MOS field effect transistors included in the semiconductor integrated circuit is calculated.

In the fourth step S17, the averaged value "WNave" of gate widths "WNn" of all of the n-channel MOS field effect transistors included in the semiconductor integrated circuit is calculated. The averaged value "CNave" of gate capacities "CNn" of all of the n-channel MOS field effect transistors included in the semiconductor integrated circuit is calculated. The averaged value "CL2ave" of interconnection capacities "CL2n" between drains and the second power of all of the n-channel MOS field effect transistors included in the semiconductor integrated circuit is calculated.

In the fifth step S18, the above logic gate circuit part of the above first novel power model shown in FIG. 3 is prepared. As described above, the logic gate circuit part of the above first novel power model comprises the single inverter circuit 2 and a single pair of the first and second load capacities 5 and 6. The inverter circuit 2 further comprises a single pair of the p-channel MOS field effect transistor 3 and the n-channel MOS field effect transistor 4. The product "Ngate × ROPmax x WPave" of the total number "Ngate" of the all gate circuits, and the maximum operational rate "ROPmax", and the averaged value "WPave" is calculated, so that the product "Ngate X ROPmax x WPave" is defined to be the gate width of the p-channel MOS field effect transistor 3. The product "Ngate x ROPmax X WNave" of the total number "Ngate" of the all gate circuits in the operating state, and the maximum operational rate "ROPmax", and the averaged value "WNave" is calculated, so that the product "Ngate X ROPmax X WNave" is defined to be the gate width of the n-channel MOS field effect transistor 4. The product "Ngate x ROPmax X ("CPave" + "CL1ave")" of total number "Ngate" of the all gate circuits, and the maximum operational rate "ROPmax", and the averaged value ("CPave" + "CL1ave") is calculated, so that the product "Ngate X ROPmax x ("CPave" + "CL1ave")" is defined to be the first load capacity 5. The product "Ngate X ROPmax X ("CNave" + "CL2ave")" of total number "Ngate" of the all gate circuits, and the maximum operational rate "ROPmax", and the averaged value ("CNave" + "CL2ave") is calculated, so that the product "Ngate x ROPmax x ("CNave" + "CL2ave")" is defined to be the second load capacity 6. As a result, the logic gate circuit part of the first power model of the first embodiment is prepared.

### THIRTEENTH EMBODIMENT:

A thirteenth embodiment according to the present invention will be described in detail with reference to the drawings. FIG. 15 is flow chart illustrative of novel processes for modeling internal circuit configurations of a semiconductor integrated circuit into two-stage gate circuits, wherein the novel processes are involved in a fourth novel method of designing a power model for an electro-magnetic interference simulation to a semiconductor integrated circuit in a thirteenth embodiment in accordance with the present invention. All of the circuit configuration informations of the semiconductor integrated circuit are stored in a data base or a net list.

In a step S39, a total number "Ngate" of the all gate circuits included in the semiconductor integrated circuit is counted from all of the circuit configuration informations stored in the data base. In second, third, fourth and fifth steps S40, S41, S42 and S43, on the basis of the averaged values of the gate widths and gate capacities of the n-channel and p-channel transistors and the averaged values of the interconnection capacities between the drains and the powers of the n-channel and p-channel transistors as well as a maximum operational rate, all of the gate circuits in the operating state are modeled into two stage gate circuits in order to prepare the above second power model described in the second embodiment in accordance with the present invention.

Namely, in the second step S40, a maximum operational rate "ROPmax" of the gate circuits is calculated, wherein the maximum operational rate is defined to be the maximum value of the rate of the operating gate circuits in the operating state in accordance with an operational frequency or a clock frequency to the total gate circuits included in the semiconductor integrated circuit.

In the third step S41, the averaged value "WPave" of gate widths "WPn" of all of the p-channel MOS field effect transistors included in the semiconductor integrated circuit is calculated. The averaged value "CPave" of gate capacities "CPn" of all of the p-channel MOS field effect transistors included in the semiconductor integrated circuit is calculated. The averaged value "CL1ave" of interconnection capacities "CL1n" between drains and the first power of all of the p-channel MOS field effect transistors included in the semiconductor integrated circuit is calculated.

In the fourth step S42, the averaged value "WNave" of gate widths "WNn" of all of the n-channel MOS field effect transistors included in the semiconductor integrated circuit is calculated. The averaged value "CNave" of gate capacities "CNn" of all of the n-channel MOS field effect transistors included in the semiconductor integrated circuit is calculated. The averaged value "CL2ave" of interconnection capacities "CL2n" between drains and the second power of all of the n-channel MOS field effect transistors included in the semiconductor integrated circuit is calculated.

In the fifth step S43, the above logic gate circuit part of the above second novel power model shown in FIG. 4 is prepared. As described above, the logic gate circuit part of the above second novel power model comprises the first and second inverter circuits 19 and 24 and a first pair of the first and second load capacities 22 and 23 and a second pair of the third and fourth load capacities 27 and 28. The first inverter circuit 19 further comprises a single pair of the p-channel MOS field effect transistor 20 and the n-channel MOS field effect transistor 21. The second inverter circuit 24 further comprises another single pair of the p-channel MOS field effect transistor 25 and the n-channel MOS field effect transistor 26. The product "Ngate × ROPmax × WPave" of the total number "Ngate" of the all gate circuits, and the maximum operational rate "ROPmax", and the averaged value "WPave" is calculated, so that a half "{Ngate X ROPmax X WPave}/2" of the product "Ngate x ROPmax x WPave" is defined to be the gate width of each of the p-channel MOS field effect transistors 20 and 25. The product "Ngate X ROPmax X WNave" of the total number "Ngate" of the all gate circuits, and the maximum operational rate "ROPmax", and the averaged value "WNave" is calculated, so that a half "{Ngate x ROPmax X WNave}/2" of the product "Ngate X ROPmax X WNave" is defined to be the gate width of each of the n-channel MOS field effect transistors 21 and 26. The product "Ngate x ROPmax x ("CPave" + "CL 1 ave")" of total number "Ngate" of the all gate circuits, and the maximum operational rate "ROPmax", and the averaged value ("CPave" + "CL1ave") is calculated, so that a half "{Ngate x ROPmax X ("CPave" + "CL1ave")}/2" of the product "Ngate x ROPmax X ("CPave" + "CL1ave")" is defined to be each of the first and third load capacities 22 and 27. The product "Ngate x ROPmax × ("CNave" + "CL2ave")" of total number "Ngate" of the all gate circuits, and the maximum operational rate "ROPmax", and the averaged value ("CNave" + "CL2ave") is calculated, so that a half "{Ngate X ROPmax × ("CNave" + "CL2ave")}/2" of the product "Ngate x ROPmax X ("CNave" + "CL2ave")" is defined to be each of the second and fourth load capacities 23 and 28. As a result, the logic gate circuit part of the second power model of the second embodiment is prepared.

### FOURTEENTH EMBODIMENT:

A fourteenth embodiment according to the present invention will be described in detail with reference to the drawings. FIG. 16 is flow chart illustrative of novel processes for modeling internal circuit configurations of a semiconductor integrated circuit into a single gate circuit, wherein the novel processes are involved in a fifth novel method of designing a power model for an electro-magnetic interference simulation to a semiconductor integrated circuit in a fourteenth embodiment in accordance with the present invention. All of the circuit configuration informations of the semiconductor integrated circuit are stored in a data base or a net list.

In a step S19, a total number "Ngate" of the gate circuits in an operating state in accordance with an operational frequency or a clock frequency is counted from all of the circuit configuration informations stored in the data base. In second, third, fourth, fifth, sixth and seventh steps S20, S21, S22, S23, S24 and S25, on the basis of the averaged values of the gate widths and gate capacities of the n-channel and p-channel transistors and the averaged values of the interconnection capacities between the drains and the powers of the n-channel and p-channel transistors as well as an averaged current value of the entire circuit configuration of the semiconductor integrated circuit and further an averaged current value of a basic gate circuit prepared from the transistors and capacities having the above averaged values, all of the gate circuits in the operating state are modeled into a single gate circuit in order to prepare the above first power model described in the first embodiment in accordance with the present invention.

Namely, in the second step S20, an average current value "Iave" of entire circuit configurations of the semiconductor integrated circuits is calculated from all of the circuit configuration informations of the semiconductor integrated circuit stored in the data base.

In the third step S21, the averaged value "WPave" of gate widths "WPn" of all of the p-channel MOS field effect transistors included in the semiconductor integrated circuit is calculated. The averaged value "CPave" of gate capacities "CPn" of all of the p-channel MOS field effect transistors included in the semiconductor integrated circuit is calculated. The averaged value "CL1ave" of interconnection capacities "CL1n" between drains and the first power of all of the p-channel MOS field effect transistors included in the semiconductor integrated circuit is calculated.

In the fourth step S22, the averaged value "WNave" of gate widths "WNn" of all of the n-channel MOS field effect transistors included in the semiconductor integrated circuit is calculated. The averaged value "CNave" of gate capacities "CNn" of all of the n-channel MOS field effect transistors included in the semiconductor integrated circuit is calculated. The averaged value "CL2ave" of interconnection capacities "CL2n" between drains and the second power of all of the n-channel MOS field effect transistors included in the semiconductor integrated circuit is calculated.

In the fifth step S23, basic gate circuits are prepared in respective correspondence with the actual gate circuits included in the semiconductor integrated circuits, wherein informations about the actual gate circuits are stored in the data base. The corresponding basic gate circuit is identical with the actual gate circuit in the circuit configurations, for example, the circuit elements and the number of the circuit elements and placements and interconnection relationships between the circuit elements. However, the corresponding basic gate circuit is different from the actual gate circuit in the followings. All of the constitutional p-channel MOS field effect transistors of the basic gate circuit have the above averaged gate width "WPave". All of the constitutional p-channel MOS field effect transistors of the basic gate circuit have the above averaged gate capacity "CPave". All of the constitutional n-channel MOS field effect transistors of the basic gate circuit has the above averaged gate width "WNave". All of the constitutional n-channel MOS field effect transistors of the basic gate circuit have the above averaged gate capacity "CNave". An average current value "IPRIave" of the above basic gate circuits in correspondence with the actual gate circuits included in the semiconductor device is calculated.

In the sixth step S24, a power current ratio "CI" is calculated, wherein the power current ratio "CI" is defined to be "IPRIave/Iave", or the ratio of the average current value "IPRIave" of the above basic gate circuits to the average current value "Iave" of the above actual gate circuits.

In the seventh step S25, the above logic gate circuit part of the above first novel power model shown in FIG. 3 is prepared. As described above, the logic gate circuit part of the above first novel power model comprises the single inverter circuit 2 and a single pair of the first and second load capacities 5 and 6. The inverter circuit 2 further comprises a single pair of the p-channel MOS field effect transistor 3 and the n-channel MOS field effect transistor 4. The product "Ngate X CI x WPave" of the total number "Ngate" of the all gate circuits, and the power current ratio "CI", and the averaged value "WPave" is calculated, so that the product "Ngate X ROPmax × WPave" is defined to be the gate width of the p-channel MOS field effect transistor 3. The product "Ngate x CI x WNave" of the total number "Ngate" of the all gate circuits, and the power current ratio "CI", and the averaged value "WNave" is calculated, so that the product "Ngate x CI x WNave" is defined to be the gate width of the n-channel MOS field effect transistor 4. The product "Ngate x CI x ("CPave" + "CL1ave")" of total number "Ngate" of the all gate circuits, and the power current ratio "CI", and the averaged value ("CPave" + "CL1ave") is calculated, so that the product "Ngate x CI x ("CPave" + "CL1ave")" is defined to be the first load capacity 5. The product "Ngate x CI x ("CNave" + "CL2ave")" of total number "Ngate" of the all gate circuits, and the power current ratio "CI", and the averaged value ("CNave" + "CL2ave") is calculated, so that the product "Ngate x CI x ("CNave" + "CL2ave")" is defined to be the second load capacity 6. As a result, the logic gate circuit part of the first power model of the first embodiment is prepared.

### FIFTEENTH EMBODIMENT:

A fifteenth embodiment according to the present invention will be described in detail with reference to the drawings. FIG. 17 is flow chart illustrative of novel processes for modeling internal circuit configurations of a semiconductor integrated circuit into two stage gate circuits, wherein the novel processes are involved in a fifth novel method of designing a power model for an electro-magnetic interference simulation to a semiconductor integrated circuit in a fifteenth embodiment in accordance with the present invention. All of the circuit configuration informations of the semiconductor integrated circuit are stored in a data base or a net list.

In a step S44, a total number "Ngate" of the all gate circuits included in the semiconductor integrated circuit is counted from all of the circuit configuration informations stored in the data base. In second, third, fourth, fifth, sixth and seventh steps S45, S46, S47, S48, S49 and S50, on the basis of the averaged values of the gate widths and gate capacities of the n-channel and p-channel transistors and the averaged values of the interconnection capacities between the drains and the powers of the n-channel and p-channel transistors as well as an averaged current value of the entire circuit configuration of the semiconductor integrated circuit and further an averaged current value of a basic gate circuit prepared from the transistors and capacities having the above averaged values, all of the gate circuits in the operating state are modeled into a single gate circuit in order to prepare the above second power model described in the second embodiment in accordance with the present invention.

Namely, in the second step S45, an average current value "Iave" of entire circuit configurations of the semiconductor integrated circuits is calculated from all of the circuit configuration informations of the semiconductor integrated circuit stored in the data base.

In the third step S46, the averaged value "WPave" of gate widths "WPn" of all of the p-channel MOS field effect transistors included in the semiconductor integrated circuit is calculated. The averaged value "CPave" of gate capacities "CPn" of all of the p-channel MOS field effect transistors included in the semiconductor integrated circuit is calculated. The averaged value "CL1ave" of interconnection capacities "CL1n" between drains and the first power of all of the p-channel MOS field effect transistors included in the semiconductor integrated circuit is calculated.

In the fourth step S47, the averaged value "WNave" of gate widths "WNn" of all of the n-channel MOS field effect transistors included in the semiconductor integrated circuit is calculated. The averaged value "CNave" of gate capacities "CNn" of all of the n-channel MOS field effect transistors included in the semiconductor integrated circuit is calculated. The averaged value "CL2ave" of interconnection capacities "CL2n" between drains and the second power of all of the n-channel MOS field effect transistors included in the semiconductor integrated circuit is calculated.

In the fifth step S48, basic gate circuits are prepared in respective correspondence with the actual gate circuits included in the semiconductor integrated circuits, wherein informations about the actual gate circuits are stored in the data base. The corresponding basic gate circuit is identical with the actual gate circuit in the circuit configurations, for example, the circuit elements and the number of the circuit elements and placements and interconnection relationships between the circuit elements. However, the corresponding basic gate circuit is different from the actual gate circuit in the followings. All of the constitutional p-channel MOS field effect transistors of the basic gate circuit have the above averaged gate width "WPave". All of the constitutional p-channel MOS field effect transistors of the basic gate circuit have the above averaged gate capacity "CPave". All of the constitutional n-channel MOS field effect transistors of the basic gate circuit has the above averaged gate width "WNave". All of the constitutional n-channel MOS field effect transistors of the basic gate circuit have the above averaged gate capacity "CNave". An average current value "IPRIave" of the above basic gate circuits in correspondence with the actual gate circuits included in the semiconductor device is calculated.

In the sixth step S49, a power current ratio "CI" is calculated, wherein the power current ratio "CI" is defined to be "IPRIave/Iave", or the ratio of the average current value "IPRIave" of the above basic gate circuits to the average current value "Iave" of the above actual gate circuits.

In the seventh step S50, the above logic gate circuit part of the above second novel power model shown in FIG. 4 is prepared. As described above, the logic gate circuit part of the above second novel power model comprises the first and second inverter circuits 19 and 24 and a first pair of the first and second load capacities 22 and 23 and a second pair of the third and fourth load capacities 27 and 28. The first inverter circuit 19 further comprises a single pair of the p-channel MOS field effect transistor 20 and the n-channel MOS field effect transistor 21. The second inverter circuit 24 further comprises another single pair of the p-channel MOS field effect transistor 25 and the n-channel MOS field effect transistor 26. The product "Ngate x CI x WPave" of the total number "Ngate" of the all gate circuits, and the power current ratio "CI", and the averaged value "WPave" is calculated, so that a half "{Ngate × CI × WPave}/2" of the product "Ngate × CI X WPave" is defined to be the gate width of each of the p-channel MOS field effect transistors 20 and 25. The product "Ngate x CI X WNave" of the total number "Ngate" of the all gate circuits, and the power current ratio "CI", and the averaged value "WNave" is calculated, so that a half "{Ngate × CI × WNave}/2" of the product "Ngate X CI X WNave" is defined to be the gate width of each of the n-channel MOS field effect transistors 21 and 26. The product "Ngate × CI × ("CPave" + "CL1ave")" of total number "Ngate" of the all gate circuits, and the power current ratio "CI", and the averaged value ("CPave" + "CL1ave") is calculated, so that a half "{Ngate × CI x ("CPave" + "CL1ave")}/2" of the product "Ngate X CI X ("CPave" + "CL1ave")" is defined to be each of the first and third load capacities 22 and 27. The product "Ngate X CI x ("CNave" + "CL2ave")" of total number "Ngate" of the all gate circuits, and the power current ratio "CI", and the averaged value ("CNave" + "CL2ave") is calculated, so that a half "{Ngate × CI × ("CNave" + "CL2ave")}/2" of the product "Ngate x CI x ("CNave" + "CL2ave")" is defined to be each of the second and fourth load capacities 23 and 28. As a result, the logic gate circuit part of the second power model of the second embodiment is prepared.

### SIXTEENTH EMBODIMENT:

A sixteenth embodiment according to the present invention will be described in detail with reference to the drawings. FIG. 18 is flow chart illustrative of novel processes for modeling internal circuit configurations of a semiconductor integrated circuit into an equivalent internal capacitive part, wherein the novel processes are involved in the first novel method of designing a power model for an electro-magnetic interference simulation to a semiconductor integrated circuit in a sixteenth embodiment in accordance with the present invention.

The above sixth embodiment in accordance with the present invention does provide the logic gate circuit part of the first power model shown in FIG. 3 described in the above first embodiment in accordance with the present invention. Namely, the logic gate circuit part of the first power model shown in FIG. 3 described in the above first embodiment is prepared in accordance with the novel processes shown in FIG. 8 described in the sixth embodiment. The remaining part, for example, the equivalent internal capacitive part of the first power model shown in FIG. 3 described in the above first embodiment is prepared in accordance with novel processes to be hereinafter described in this embodiment. Accordingly, a combination of the above described novel processes of the above sixth embodiment with the hereinafter described novel processes of this embodiment completes the first novel method of designing the first power model shown in FIG. 3 described in the first embodiment.

The above seventh embodiment in accordance with the present invention does provide the logic gate circuit part of the second power model shown in FIG. 4 described in the above second embodiment in accordance with the present invention. Namely, the logic gate circuit part of the second power model shown in FIG. 4 described in the above second embodiment is prepared in accordance with the novel processes shown in FIG. 9 described in the seventh embodiment. The remaining part, for example, the equivalent internal capacitive part of the second power model shown in FIG. 4 described in the above second embodiment is prepared in accordance with novel processes to be hereinafter described in this embodiment. Accordingly, a combination of the above described novel processes of the above seventh embodiment with the hereinafter described novel processes of this embodiment completes the second novel method of designing the second power model shown in FIG. 4 described in the second embodiment.

All of the circuit configuration informations of the semiconductor integrated circuit are stored in a data base or a net list.

In a step S51, all of the gate circuits in a non-operating state in accordance with an operational frequency or a clock frequency are extracted from the data base. In second, third and fourth steps S52, S53 and S54, the all of the gate circuits in the non-operating state are modeled into the equivalent internal capacitive part comprising the first, second and third equivalent internal capacities 9, 10 and 11 shown in FIGS. 3 and 4 in the first and second embodiments in order to prepare the above first and second power models described in the first and second embodiments in accordance with the present invention.

Namely, in the second step S52, the number "k" of the p-channel MOS field effect transistors in the non-operating state is confirmed. The reciprocal of the sum of the individual reciprocals of the ON-resistances "RONPn" of all of the p-channel MOS field effect transistors in the non-operating state is calculated. The sum "CP" of gate capacities "CPn" of all of the p-channel MOS field effect transistors in the non-operating state is calculated. The sum "CL1" of interconnection capacities "CL1n" between drains and the first power of all of the p-channel MOS field effect transistors in the non-operating state is calculated.

In the third step S53, the number "k" of the n-channel MOS field effect transistors in the non-operating state is confirmed. The reciprocal of the sum of the individual reciprocals of the ON-resistances "RONNn" of all of the n-channel MOS field effect transistors in the non-operating state is calculated. The sum "CN" of gate capacities "CNn" of all of the n-channel MOS field effect transistors in the non-operating state is calculated. The sum "CL2" of interconnection capacities "CL2n" between drains and the second power of all of the n-channel MOS field effect transistors in the non-operating state is calculated.

In the fourth step S54, the above equivalent internal capacitive part of each of the above first and second novel power models shown in FIGS. 3 and 4 is prepared. As described above, the above equivalent internal capacitive part of each of the above first and second novel power models comprises the first, second and third equivalent internal capacities 9, 10 and 11 shown in FIGS. 3 and 4 described in the first and second embodiments. As described in the first and second embodiments, the logic gate circuit having the inverter circuit represents operating state parts of the semiconductor integrated circuit in accordance with the frequency-fixed signal such as the clock signal. The equivalent internal capacitive part represents non-operating state parts of the semiconductor integrated circuits, wherein the non-operating state parts are in the rest state, even the non-operating state parts are potentially operable in accordance with the frequency-fixed signal such as the clock signal. The equivalent internal capacitive part also represents an operating-irrelevant fixed part of the semiconductor integrated circuit, wherein the operating-irrelevant fixed part of the semiconductor integrated circuit corresponds to a constant capacitance value, and the operating-irrelevant fixed part of the semiconductor integrated circuit is previously decided in the design process and independent from the operating and non-operating states. The first equivalent internal capacitive element 9 corresponds to the operating-irrelevant fixed part of the semiconductor integrated circuit. The second and third equivalent internal capacitive elements 10 and 11 correspond to the non-operating state parts of the semiconductor integrated circuit. The product "2RONPn" of "2" and the ON-resistances "RONPn" of all of the p-channel MOS field effect transistors in the non-operating state is defined to be the series resistance of the third equivalent internal capacitive element 11. The product "2RONNn" of "2" and the ON-resistances "RONNn" of all of the n-channel MOS field effect transistors in the non-operating state is defined to be the series resistance of the second equivalent internal capacitive element 10. The arithmetic mean "(CP+CL1)/2" of the sum "CP" of gate capacities "CPn" of all of the p-channel MOS field effect transistors in the non-operating state and the sum "CL1" of interconnection capacities "CL1n" between drains and the first power of all of the p-channel MOS field effect transistors in the non-operating state is defined to be the second equivalent internal capacity 10. The arithmetic mean "(CN+CL2)/2" of the sum "CN" of gate capacities "CNn" of all of the n-channel MOS field effect transistors in the non-operating state and the sum "CL2" of interconnection capacities "CL2n" between drains and the second power of all of the n-channel MOS field effect transistors in the non-operating state is defined to be the third equivalent internal capacity 11. The first equivalent internal capacity 9 is the operating-irrelevant fixed part of the semiconductor integrated circuit and is previously decided in the design process and independent from the operating and non-operating states, for which reason the first equivalent internal capacity 9 is not modeled. As a result, the equivalent internal capacitive part of each of the first and second power models of the first and second embodiments is prepared.

### SEVENTEENTH EMBODIMENT:

A seventeenth embodiment according to the present invention will be described in detail with reference to the drawings. FIG. 19 is flow chart illustrative of novel processes for modeling internal circuit configurations of a semiconductor integrated circuit into an equivalent internal capacitive part, wherein the novel processes are involved in the second novel method of designing a power model for an electro-magnetic interference simulation to a semiconductor integrated circuit in a seventeenth embodiment in accordance with the present invention.

The above eighth embodiment in accordance with the present invention does provide the logic gate circuit part of the first power model shown in FIG. 3 described in the above first embodiment in accordance with the present invention. Namely, the logic gate circuit part of the first power model shown in FIG. 3 described in the above first embodiment is prepared in accordance with the novel processes shown in FIG. 10 described in the eighth embodiment. The remaining part, for example, the equivalent internal capacitive part of the first power model shown in FIG. 3 described in the above first embodiment is prepared in accordance with novel processes to be hereinafter described in this embodiment. Accordingly, a combination of the above described novel processes of the above eighth embodiment with the hereinafter described novel processes of this embodiment completes the second novel method of designing the first power model shown in FIG. 3 described in the first embodiment.

The above ninth embodiment in accordance with the present invention does provide the logic gate circuit part of the second power model shown in FIG. 4 described in the above second embodiment in accordance with the present invention. Namely, the logic gate circuit part of the second power model shown in FIG. 4 described in the above second embodiment is prepared in accordance with the novel processes shown in FIG. 11 described in the ninth embodiment. The remaining part, for example, the equivalent internal capacitive part of the second power model shown in FIG. 4 described in the above second embodiment is prepared in accordance with novel processes to be hereinafter described in this embodiment. Accordingly, a combination of the above described novel processes of the above ninth embodiment with the hereinafter described novel processes of this embodiment completes the second novel method of designing the second power model shown in FIG. 4 described in the second embodiment.

All of the circuit configuration informations of the semiconductor integrated circuit are stored in a data base or a net list.

In a step S55, all of the gate circuits in a non-operating state in accordance with an operational frequency or a clock frequency are extracted from the data base and a total number "NgateNOP" of the gate circuits in the non-operating state is counted. In second, third and fourth steps S56, S57 and S58, the all of the gate circuits in the non-operating state are modeled into the equivalent internal capacitive part comprising the first, second and third equivalent internal capacities 9, 10 and 11 shown in FIGS. 3 and 4 in the first and second embodiments in order to prepare the above first and second power models described in the first and second embodiments in accordance with the present invention.

Namely, in the second step S56, the ON-resistance average value "RONPave" of the ON-resistances "RONPn" of all of the p-channel MOS field effect transistors in the non-operating state is calculated. The gate capacity average value "CPave" of gate capacities "CPn" of all of the p-channel MOS field effect transistors in the non-operating state is calculated. The interconnection capacity average value "CL1ave" of the interconnection capacities "CL1n" between drains and the first power of all of the p-channel MOS field effect transistors in the non-operating state is calculated.

In the third step S57, the ON-resistance average value "RONNn" of the ON-resistances "RONNn" of all of the n-channel MOS field effect transistors in the non-operating state is calculated. The gate capacity average value "CNave" of gate capacities "CNn" of all of the n-channel MOS field effect transistors in the non-operating state is calculated. The interconnection capacity average value "CL2ave" of the interconnection capacities "CL2n" between drains and the second power of all of the n-channel MOS field effect transistors in the non-operating state is calculated.

In the fourth step S58, the above equivalent internal capacitive part of each of the above first and second novel power models shown in FIGS. 3 and 4 is prepared. As described above, the above equivalent internal capacitive part of each of the above first and second novel power models comprises the first, second and third equivalent internal capacities 9, 10 and 11 shown in FIGS. 3 and 4 described in the first and second embodiments. As described in the first and second embodiments, the logic gate circuit having the inverter circuit represents operating state parts of the semiconductor integrated circuit in accordance with the frequency-fixed signal such as the clock signal. The equivalent internal capacitive part represents non-operating state parts of the semiconductor integrated circuits, wherein the non-operating state parts are in the rest state, even the non-operating state parts are potentially operable in accordance with the frequency-fixed signal such as the clock signal. The equivalent internal capacitive part also represents an operating-irrelevant fixed part of the semiconductor integrated circuit, wherein the operating-irrelevant fixed part of the semiconductor integrated circuit corresponds to a constant capacitance value, and the operating-irrelevant fixed part of the semiconductor integrated circuit is previously decided in the design process and independent from the operating and non-operating states. The first equivalent internal capacitive element 9 corresponds to the operating-irrelevant fixed part of the semiconductor integrated circuit. The second and third equivalent internal capacitive elements 10 and 11 correspond to the non-operating state parts of the semiconductor integrated circuit. The "2RONPave/NgateNOP" is defined to be the series resistance of the third equivalent internal capacitive element 11. The "2RONNave/NgateNOP" is defined to be the series resistance of the second equivalent internal capacitive element 10. The product "NgateNOP X (CPave+CL1ave)/2" of the total number "NgateNOP" of the logic gate circuits in the non-operating state and the arithmetic mean "(CPave+CL1ave)/2" of the average gate capacities "CPave" of all of the p-channel MOS field effect transistors in the non-operating state and the average interconnection capacities "CL1ave" between drains and the first power of all of the p-channel MOS field effect transistors in the non-operating state is defined to be the second equivalent internal capacity 10. The product "NgateNOP × (CNave+CL2ave)/2" of the total number "NgateNOP" of the logic gate circuits in the non-operating state and the arithmetic mean "(CNave+CL2ave)/2" of the average gate capacities "CNave" of all of the n-channel MOS field effect transistors in the non-operating state and the average interconnection capacities "CL2ave" between drains and the second power of all of the n-channel MOS field effect transistors in the non-operating state is defined to be the third equivalent internal capacity 11. The first equivalent internal capacity 9 is the operating-irrelevant fixed part of the semiconductor integrated circuit and is previously decided in the design process and independent from the operating and non-operating states, for which reason the first equivalent internal capacity 9 is not modeled. As a result, the equivalent internal capacitive part of each of the first and second power models of the first and second embodiments is prepared.

### EIGHTEENTH EMBODIMENT:

An eighteenth embodiment according to the present invention will be described in detail with reference to the drawings. FIG. 20 is flow chart illustrative of novel processes for modeling internal circuit configurations of a semiconductor integrated circuit into an equivalent internal capacitive part, wherein the novel processes are involved in the third novel method of designing a power model for an electro-magnetic interference simulation to a semiconductor integrated circuit in an eighteenth embodiment in accordance with the present invention.

The above tenth embodiment in accordance with the present invention does provide the logic gate circuit part of the first power model shown in FIG. 3 described in the above first embodiment in accordance with the present invention. Namely, the logic gate circuit part of the first power model shown in FIG. 3 described in the above first embodiment is prepared in accordance with the novel processes shown in FIG. 12 described in the tenth embodiment. The remaining part, for example, the equivalent internal capacitive part of the first power model shown in FIG. 3 described in the above first embodiment is prepared in accordance with novel processes to be hereinafter described in this embodiment. Accordingly, a combination of the above described novel processes of the above tenth embodiment with the hereinafter described novel processes of this embodiment completes the third novel method of designing the first power model shown in FIG. 3 described in the first embodiment.

The above eleventh embodiment in accordance with the present invention does provide the logic gate circuit part of the second power model shown in FIG. 4 described in the above second embodiment in accordance with the present invention. Namely, the logic gate circuit part of the second power model shown in FIG. 4 described in the above second embodiment is prepared in accordance with the novel processes shown in FIG. 13 described in the eleventh embodiment. The remaining part, for example, the equivalent internal capacitive part of the second power model shown in FIG. 4 described in the above second embodiment is prepared in accordance with novel processes to be hereinafter described in this embodiment. Accordingly, a combination of the above described novel processes of the above eleventh embodiment with the hereinafter described novel processes of this embodiment completes the third novel method of designing the second power model shown in FIG. 4 described in the second embodiment.

All of the circuit configuration informations of the semiconductor integrated circuit are stored in a data base or a net list.

In a step S59, all of the gate circuits both in the operating and non-operating states in accordance with an operational frequency or a clock frequency are extracted from the data base and a total number "Ngate" of the gate circuits included in the semiconductor integrated circuit is counted. In second, third, fourth, fifth and sixth steps S60, S61, S62, S63 and S64, the all of the gate circuits in the non-operating state are modeled into the equivalent internal capacitive part comprising the first, second and third equivalent internal capacities 9, 10 and 11 shown in FIGS. 3 and 4 in the first and second embodiments in order to prepare the above first and second power models described in the first and second embodiments in accordance with the present invention.

Namely, in the second step S60, an average operational rate "ROPave" of the gate circuits is calculated, wherein the average operational rate is defined to be the averaged value of the rate of the operating gate circuits in the operating state in accordance with an operational frequency or a clock frequency to the total gate circuits included in the semiconductor integrated circuit.

In the third step S61, a total number "NgateNOP" of the gate circuits in the non-operating state is calculated, wherein the total number "NgateNOP" of the gate circuits in the non-operating state is defined to be the product "Ngate X (1 - ROPave)" of the total number "Ngate" of the gate circuits included in the semiconductor integrated circuit and the value "(1 - ROPave)".

In the fourth step S62, the ON-resistance average value "RONPave" of the ON-resistances "RONPn" of all of the p-channel MOS field effect transistors included in the semiconductor integrated circuit is calculated. The gate capacity average value "CPave" of gate capacities "CPn" of all of the p-channel MOS field effect transistors included in the semiconductor integrated circuit is calculated. The interconnection capacity average value "CL1ave" of the interconnection capacities "CL1n" between drains and the first power of all of the p-channel MOS field effect transistors included in the semiconductor integrated circuit is calculated.

In the fifth step S63, the ON-resistance average value "RONNn" of the ON-resistances "RONNn" of all of the n-channel MOS field effect transistors included in the semiconductor integrated circuit is calculated. The gate capacity average value "CNave" of gate capacities "CNn" of all of the n-channel MOS field effect transistors included in the semiconductor integrated circuit is calculated. The interconnection capacity average value "CL2ave" of the interconnection capacities "CL2n" between drains and the second power of all of the n-channel MOS field effect transistors included in the semiconductor integrated circuit is calculated.

In the sixth step S64, the above equivalent internal capacitive part of each of the above first and second novel power models shown in FIGS. 3 and 4 is prepared. As described above, the above equivalent internal capacitive part of each of the above first and second novel power models comprises the first, second and third equivalent internal capacities 9, 10 and 11 shown in FIGS. 3 and 4 described in the first and second embodiments. As described in the first and second embodiments, the logic gate circuit having the inverter circuit represents operating state parts of the semiconductor integrated circuit in accordance with the frequency-fixed signal such as the clock signal. The equivalent internal capacitive part represents non-operating state parts of the semiconductor integrated circuits, wherein the non-operating state parts are in the rest state, even the non-operating state parts are potentially operable in accordance with the frequency-fixed signal such as the clock signal. The equivalent internal capacitive part also represents an operating-irrelevant fixed part of the semiconductor integrated circuit, wherein the operating-irrelevant fixed part of the semiconductor integrated circuit corresponds to a constant capacitance value, and the operating-irrelevant fixed part of the semiconductor integrated circuit is previously decided in the design process and independent from the operating and non-operating states. The first equivalent internal capacitive element 9 corresponds to the operating-irrelevant fixed part of the semiconductor integrated circuit. The second and third equivalent internal capacitive elements 10 and 11 correspond to the non-operating state parts of the semiconductor integrated circuit. The "2RONPave/NgateNOP" is defined to be the series resistance of the third equivalent internal capacitive element 11. The "2RONNave/NgateNOP" is defined to be the series resistance of the second equivalent internal capacitive element 10. The product "NgateNOP X (CPave+CL1ave)/2" of the total number "NgateNOP" of the logic gate circuits in the non-operating state and the arithmetic mean "(CPave+CL1ave)/2" of the average gate capacities "CPave" of all of the p-channel MOS field effect transistors in the non-operating state and the average interconnection capacities "CL1ave" between drains and the first power of all of the p-channel MOS field effect transistors in the non-operating state is defined to be the second equivalent internal capacity 10. The product "NgateNOP × (CNave+CL2ave)/2" of the total number "NgateNOP" of the logic gate circuits in the non-operating state and the arithmetic mean "(CNave+CL2ave)/2" of the average gate capacities "CNave" of all of the n-channel MOS field effect transistors in the non-operating state and the average interconnection capacities "CL2ave" between drains and the second power of all of the n-channel MOS field effect transistors in the non-operating state is defined to be the third equivalent internal capacity 11. The first equivalent internal capacity 9 is the operating-irrelevant fixed part of the semiconductor integrated circuit and is previously decided in the design process and independent from the operating and non-operating states, for which reason the first equivalent internal capacity 9 is not modeled. As a result, the equivalent internal capacitive part of each of the first and second power models of the first and second embodiments is prepared.

### NINETEENTH EMBODIMENT:

A nineteenth embodiment according to the present invention will be described in detail with reference to the drawings. FIG. 21 is flow chart illustrative of novel processes for modeling internal circuit configurations of a semiconductor integrated circuit into an equivalent internal capacitive part, wherein the novel processes are involved in the fourth novel method of designing a power model for an electro-magnetic interference simulation to a semiconductor integrated circuit in a nineteenth embodiment in accordance with the present invention.

The above twelfth embodiment in accordance with the present invention does provide the logic gate circuit part of the first power model shown in FIG. 3 described in the above first embodiment in accordance with the present invention. Namely, the logic gate circuit part of the first power model shown in FIG. 3 described in the above first embodiment is prepared in accordance with the novel processes shown in FIG. 14 described in the twelfth embodiment. The remaining part, for example, the equivalent internal capacitive part of the first power model shown in FIG. 3 described in the above first embodiment is prepared in accordance with novel processes to be hereinafter described in this embodiment. Accordingly, a combination of the above described novel processes of the above twelfth embodiment with the hereinafter described novel processes of this embodiment completes the fourth novel method of designing the first power model shown in FIG. 3 described in the first embodiment.

The above thirteenth embodiment in accordance with the present invention does provide the logic gate circuit part of the second power model shown in FIG. 4 described in the above second embodiment in accordance with the present invention. Namely, the logic gate circuit part of the second power model shown in FIG. 4 described in the above second embodiment is prepared in accordance with the novel processes shown in FIG. 15 described in the thirteenth embodiment. The remaining part, for example, the equivalent internal capacitive part of the second power model shown in FIG. 4 described in the above second embodiment is prepared in accordance with novel processes to be hereinafter described in this embodiment. Accordingly, a combination of the above described novel processes of the above thirteenth embodiment with the hereinafter described novel processes of this embodiment completes the fourth novel method of designing the second power model shown in FIG. 4 described in the second embodiment.

All of the circuit configuration informations of the semiconductor integrated circuit are stored in a data base or a net list.

In a step S65, all of the gate circuits both in the operating and non-operating states in accordance with an operational frequency or a clock frequency are extracted from the data base and a total number "Ngate" of the gate circuits included in the semiconductor integrated circuit is counted. In second, third, fourth, fifth and sixth steps S66, S67, S68, S69 and S70, the all of the gate circuits in the non-operating state are modeled into the equivalent internal capacitive part comprising the first, second and third equivalent internal capacities 9, 10 and 11 shown in FIGS. 3 and 4 in the first and second embodiments in order to prepare the above first and second power models described in the first and second embodiments in accordance with the present invention.

Namely, in the second step S66, an maximum operational rate "ROPmax" of the gate circuits is calculated, wherein the maximum operational rate is defined to be the maximum value of the rate of the operating gate circuits in the operating state in accordance with an operational frequency or a clock frequency to the total gate circuits included in the semiconductor integrated circuit.

In the third step S67, a total number "NgateNOP" of the gate circuits in the non-operating state is calculated, wherein the total number "NgateNOP" of the gate circuits in the non-operating state is defined to be the product "Ngate X (1 - ROPmax)" of the total number "Ngate" of the gate circuits included in the semiconductor integrated circuit and the value "(1 - ROPmax)".

In the fourth step S68, the ON-resistance average value "RONPave" of the ON-resistances "RONPn" of all of the p-channel MOS field effect transistors included in the semiconductor integrated circuit is calculated. The gate capacity average value "CPave" of gate capacities "CPn" of all of the p-channel MOS field effect transistors included in the semiconductor integrated circuit is calculated. The interconnection capacity average value "CL1ave" of the interconnection capacities "CL1n" between drains and the first power of all of the p-channel MOS field effect transistors included in the semiconductor integrated circuit is calculated.

In the fifth step S69, the ON-resistance average value "RONNn" of the ON-resistances "RONNn" of all of the n-channel MOS field effect transistors included in the semiconductor integrated circuit is calculated. The gate capacity average value "CNave" of gate capacities "CNn" of all of the n-channel MOS field effect transistors included in the semiconductor integrated circuit is calculated. The interconnection capacity average value "CL2ave" of the interconnection capacities "CL2n" between drains and the second power of all of the n-channel MOS field effect transistors included in the semiconductor integrated circuit is calculated.

In the sixth step S70, the above equivalent internal capacitive part of each of the above first and second novel power models shown in FIGS. 3 and 4 is prepared. As described above, the above equivalent internal capacitive part of each of the above first and second novel power models comprises the first, second and third equivalent internal capacities 9, 10 and 11 shown in FIGS. 3 and 4 described in the first and second embodiments. As described in the first and second embodiments, the logic gate circuit having the inverter circuit represents operating state parts of the semiconductor integrated circuit in accordance with the frequency-fixed signal such as the clock signal. The equivalent internal capacitive part represents non-operating state parts of the semiconductor integrated circuits, wherein the non-operating state parts are in the rest state, even the non-operating state parts are potentially operable in accordance with the frequency-fixed signal such as the clock signal. The equivalent internal capacitive part also represents an operating-irrelevant fixed part of the semiconductor integrated circuit, wherein the operating-irrelevant fixed part of the semiconductor integrated circuit corresponds to a constant capacitance value, and the operating-irrelevant fixed part of the semiconductor integrated circuit is previously decided in the design process and independent from the operating and non-operating states. The first equivalent internal capacitive element 9 corresponds to the operating-irrelevant fixed part of the semiconductor integrated circuit. The second and third equivalent internal capacitive elements 10 and 11 correspond to the non-operating state parts of the semiconductor integrated circuit. The "2RONPave/NgateNOP" is defined to be the series resistance of the third equivalent internal capacitive element 11. The "2RONNave/NgateNOP" is defined to be the series resistance of the second equivalent internal capacitive element 10. The product "NgateNOP X (CPave+CL1ave)/2" of the total number "NgateNOP" of the logic gate circuits in the non-operating state and the arithmetic mean "(CPave+CL1ave)/2" of the average gate capacities "CPave" of all of the p-channel MOS field effect transistors in the non-operating state and the average interconnection capacities "CLlave" between drains and the first power of all of the p-channel MOS field effect transistors in the non-operating state is defined to be the second equivalent internal capacity 10. The product "NgateNOP × (CNave+CL2ave)/2" of the total number "NgateNOP" of the logic gate circuits in the non-operating state and the arithmetic mean "(CNave+CL2ave)/2" of the average gate capacities "CNave" of all of the n-channel MOS field effect transistors in the non-operating state and the average interconnection capacities "CL2ave" between drains and the second power of all of the n-channel MOS field effect transistors in the non-operating state is defined to be the third equivalent internal capacity 11. The first equivalent internal capacity 9 is the operating-irrelevant fixed part of the semiconductor integrated circuit and is previously decided in the design process and independent from the operating and non-operating states, for which reason the first equivalent internal capacity 9 is not modeled. As a result, the equivalent internal capacitive part of each of the first and second power models of the first and second embodiments is prepared.

### TWENTIETH EMBODIMENT:

A twentieth embodiment according to the present invention will be described in detail with reference to the drawings. FIG. 22 is flow chart illustrative of novel processes for modeling internal circuit configurations of a semiconductor integrated circuit into an equivalent internal capacitive part, wherein the novel processes are involved in the fifth novel method of designing a power model for an electro-magnetic interference simulation to a semiconductor integrated circuit in a twentieth embodiment in accordance with the present invention.

The above fourteenth embodiment in accordance with the present invention does provide the logic gate circuit part of the first power model shown in FIG. 3 described in the above first embodiment in accordance with the present invention. Namely, the logic gate circuit part of the first power model shown in FIG. 3 described in the above first embodiment is prepared in accordance with the novel processes shown in FIG. 16 described in the fourteenth embodiment. The remaining part, for example, the equivalent internal capacitive part of the first power model shown in FIG. 3 described in the above first embodiment is prepared in accordance with novel processes to be hereinafter described in this embodiment. Accordingly, a combination of the above described novel processes of the above fourteenth embodiment with the hereinafter described novel processes of this embodiment completes the fifth novel method of designing the first power model shown in FIG. 3 described in the first embodiment.

The above fifteenth embodiment in accordance with the present invention does provide the logic gate circuit part of the second power model shown in FIG. 4 described in the above second embodiment in accordance with the present invention. Namely, the logic gate circuit part of the second power model shown in FIG. 4 described in the above second embodiment is prepared in accordance with the novel processes shown in FIG. 17 described in the fifteenth embodiment. The remaining part, for example, the equivalent internal capacitive part of the second power model shown in FIG. 4 described in the above second embodiment is prepared in accordance with novel processes to be hereinafter described in this embodiment. Accordingly, a combination of the above described novel processes of the above fifteenth embodiment with the hereinafter described novel processes of this embodiment completes the fifth novel method of designing the second power model shown in FIG. 4 described in the second embodiment.

All of the circuit configuration informations of the semiconductor integrated circuit are stored in a data base or a net list.

In a step S71, all of the gate circuits both in the operating and non-operating states in accordance with an operational frequency or a clock frequency are extracted from the data base and a total number "Ngate" of the gate circuits included in the semiconductor integrated circuit is counted. In second, third, fourth, fifth and sixth steps S72, S73, S74, S75 and S76, the all of the gate circuits in the non-operating state are modeled into the equivalent internal capacitive part comprising the first, second and third equivalent internal capacities 9, 10 and 11 shown in FIGS. 3 and 4 in the first and second embodiments in order to prepare the above first and second power models described in the first and second embodiments in accordance with the present invention.

Namely, in the second step S72, an average current value "Iave" of entire circuit configurations of the semiconductor integrated circuits is calculated from all of the circuit configuration informations of the semiconductor integrated circuit stored in the data base.

In the third step S73, a gate width average value "WPave" of the gate widths of the p-channel MOS field effect transistors included in the semiconductor integrated circuit is calculated. The ON-resistance average value "RONPave" of the ON-resistances "RONPn" of all of the p-channel MOS field effect transistors included in the semiconductor integrated circuit is calculated. The gate capacity average value "CPave" of gate capacities "CPn" of all of the p-channel MOS field effect transistors included in the semiconductor integrated circuit is calculated. The interconnection capacity average value "CLlave" of the interconnection capacities "CL1n" between drains and the first power of all of the p-channel MOS field effect transistors included in the semiconductor integrated circuit is calculated.

In the fifth step S74, a gate width average value "WNave" of the gate widths of the n-channel MOS field effect transistors included in the semiconductor integrated circuit is calculated. The ON-resistance average value "RONNn" of the ON-resistances "RONNn" of all of the n-channel MOS field effect transistors included in the semiconductor integrated circuit is calculated. The gate capacity average value "CNave" of gate capacities "CNn" of all of the n-channel MOS field effect transistors included in the semiconductor integrated circuit is calculated. The interconnection capacity average value "CL2ave" of the interconnection capacities "CL2n" between drains and the second power of all of the n-channel MOS field effect transistors included in the semiconductor integrated circuit is calculated.

In the fifth step S75, basic gate circuits are prepared in respective correspondence with the actual gate circuits included in the semiconductor integrated circuits, wherein informations about the actual gate circuits are stored in the data base. The corresponding basic gate circuit is identical with the actual gate circuit in the circuit configurations, for example, the circuit elements and the number of the circuit elements and placements and interconnection relationships between the circuit elements. However, the corresponding basic gate circuit is different from the actual gate circuit in the followings. All of the constitutional p-channel MOS field effect transistors of the basic gate circuit have the above averaged gate width "WPave". All of the constitutional p-channel MOS field effect transistors of the basic gate circuit have the above averaged gate capacity "CPave". All of the constitutional n-channel MOS field effect transistors of the basic gate circuit has the above averaged gate width "WNave". All of the constitutional n-channel MOS field effect transistors of the basic gate circuit have the above averaged gate capacity "CNave". An average current value "IPRIave" of the above basic gate circuits in correspondence with the actual gate circuits included in the semiconductor device is calculated.

In the sixth step S76, a power current ratio "CI" is calculated, wherein the power current ratio is defined to be a ratio of the above averaged current value "IPRIave" of all of the basic gate circuits to an averaged current value "Iave" of all of the constituting gate circuits. A total number "NgateNOP" of the gate circuits in the non-operating state is calculated, wherein the total number "NgateNOP" of the gate circuits in the non-operating state is defined to be the product "Ngate X (1 - IPRIave/Iave)" of the total number "Ngate" of the gate circuits included in the semiconductor integrated circuit and the power current ratio "IPRIave/Iave".

In the sixth step S77, the above equivalent internal capacitive part of each of the above first and second novel power models shown in FIGS. 3 and 4 is prepared. As described above, the above equivalent internal capacitive part of each of the above first and second novel power models comprises the first, second and third equivalent internal capacities 9, 10 and 11 shown in FIGS. 3 and 4 described in the first and second embodiments. As described in the first and second embodiments, the logic gate circuit having the inverter circuit represents operating state parts of the semiconductor integrated circuit in accordance with the frequency-fixed signal such as the clock signal. The equivalent internal capacitive part represents non-operating state parts of the semiconductor integrated circuits, wherein the non-operating state parts are in the rest state, even the non-operating state parts are potentially operable in accordance with the frequency-fixed signal such as the clock signal. The equivalent internal capacitive part also represents an operating-irrelevant fixed part of the semiconductor integrated circuit, wherein the operating-irrelevant fixed part of the semiconductor integrated circuit corresponds to a constant capacitance value, and the operating-irrelevant fixed part of the semiconductor integrated circuit is previously decided in the design process and independent from the operating and non-operating states. The first equivalent internal capacitive element 9 corresponds to the operating-irrelevant fixed part of the semiconductor integrated circuit. The second and third equivalent internal capacitive elements 10 and 11 correspond to the non-operating state parts of the semiconductor integrated circuit. The "2RONPave/NgateNOP" is defined to be the series resistance of the third equivalent internal capacitive element 11. The "2RONNave/NgateNOP" is defined to be the series resistance of the second equivalent internal capacitive element 10. The product "NgateNOP X (CPave+CL1ave)/2" of the total number "NgateNOP" of the logic gate circuits in the non-operating state and the arithmetic mean "(CPave+CL1ave)/2" of the average gate capacities "CPave" of all of the p-channel MOS field effect transistors in the non-operating state and the average interconnection capacities "CL1ave" between drains and the first power of all of the p-channel MOS field effect transistors in the non-operating state is defined to be the second equivalent internal capacity 10. The product "NgateNOP × (CNave+CL2ave)/2" of the total number "NgateNOP" of the logic gate circuits in the non-operating state and the arithmetic mean "(CNave+CL2ave)/2" of the average gate capacities "CNave" of all of the n-channel MOS field effect transistors in the non-operating state and the average interconnection capacities "CL2ave" between drains and the second power of all of the n-channel MOS field effect transistors in the non-operating state is defined to be the third equivalent internal capacity 11. The first equivalent internal capacity 9 is the operating-irrelevant fixed part of the semiconductor integrated circuit and is previously decided in the design process and independent from the operating and non-operating states, for which reason the first equivalent internal capacity 9 is not modeled. As a result, the equivalent internal capacitive part of each of the first and second power models of the first and second embodiments is prepared.

### TWENTY FIRST EMBODIMENT:

A twenty first embodiment according to the present invention will be described in detail with reference to the drawings. FIG. 23 is a block diagram illustrative of a support system for designing a power model in a twenty first embodiment according to the present invention. The support system is to realize the above described first and second novel power models of the first and second embodiments in accordance with the above described first, second, third, fourth and fifth novel power model design methods of the above sixth through twentieth embodiments.

The support system has the following elements. A data base 63 is provided for storing informations of internal circuit configurations of the semiconductor integrated circuit, and if any the circuit board on which the semiconductor integrated circuit is mounted. A storage medium 67 is also provided for storing informations 68 about power model circuit elements and interconnections between the circuit elements of the power model as well as for storing a computer program 69 for designing the power model. A processor 64 is provided which is connected to the data base 63 and the storage medium 65 for executing the computer program 69 to prepare the power model. An output device 70 is provided which is connected to the processor 64 for outputting the power model prepared by the processor 64. The processor 64 further comprises a central processing unit 65 and a memory 66 connected to the central processing unit 65. The central processing unit 65 is connected to the data base 63 for receiving the circuit informations stored therein. The central processing unit 65 is also connected to the storage medium 67 for receiving both the informations 68 about the power model circuit elements and interconnections between the circuit elements of the power model as well as the computer program 69 for designing the power model. The central processing unit 65 executes the computer program 69 to prepare the power model. The central processing unit 65 is also connected to the output device 70 for enabling the output device 70 to output the power model. The power model may be either the first or second novel power models shown in FIGS. 3 and 4. The computer program 69 accords to the above described first, second, third, fourth and fifth novel power model design methods of the above sixth through twentieth embodiments. The storage medium 67 may be realized by any available mediums such as a magnetic disk, a semiconductor memory, and a CD-ROM. The data base 63 stores all of the informations about the semiconductor integrated circuit. All of the necessary informations for the novel power model are obtained from the output device 70. The computer program 69 includes both the first program for designing the logic gate circuit part of the power model and the second program for designing the equivalent internal capacitive part, wherein the logic gate circuit part represents the operating parts of the semiconductor integrated circuits, whilst the equivalent internal capacitive part represents the non-operating parts of the semiconductor integrated circuits. There is no limitation to the sequence in execution of the first and second programs. The first equivalent internal capacity 9 in the first and second power models shown in FIGS. 3 and 4 may be obtained from the informations bout placement of the well regions but not from the circuit informations of the semiconductor integrated circuit. The power model is deigned for the electro-magnetic interference simulation to an electromagnetic field distribution over a circuit board on which the semiconductor integrated circuit is mounted. For this reason, a simulation program may be included in the above computer program 69 for designing the power model or may be excluded therefrom so that the simulation program is stored in another storage medium of a simulator separately from the above supporting system. If the above computer program 69 includes the simulation program, then the computer program 69 includes a first simulation program for analysis to circuits to obtain a current distribution over a circuit board on which the semiconductor integrated circuit is mounted. The computer program 69 further includes a second simulation program for analysis to electromagnetic field to obtain a distribution of electromagnetic field over the circuit board on which the semiconductor integrated circuit is mounted.

FIG. 24 is a flow chart illustrative of the electromagnetic interference simulation to the semiconductor integrated circuit by use of a simulator on the basis of the first and second novel power models shown in FIGS. 3 and 4 and prepared by the first, second, third, fourth and fifth design methods executed by the supporting system shown in FIG. 23. The simulator may comprise a circuit analyzing simulator 73 and an electromagnetic field analyzing simulator 75. The circuit analyzing simulator 73 is accessible to a first storage medium 71 for receiving a power model for a semiconductor integrated circuit, and also being connected to a second storage medium 72 for receiving informations about a circuit board on which the semiconductor integrated circuit is mounted, so that the circuit analyzing simulator 73 analyzes the power model to obtain a current distribution 74 over a circuit board on which the semiconductor integrated circuit is mounted. The electromagnetic field analyzing simulator 75 is accessible to the circuit analyzing simulator 73 for receiving the current distribution 74, so that the electromagnetic field analyzing simulator 75 analyzes an electromagnetic field distribution 76 over the circuit board on which the semiconductor integrated circuit is mounted. The circuit analyzing simulator 73 may, for example comprise "Simulation Program with Integrated Circuit Emphasis (SPICE)". The above circuit analyzing simulator 73 and the electromagnetic field analyzing simulator 75 may be realized by a single package software such as "RADIA-WB PACKAGE" which is commercially available from Applied Simulation Technology. This package software has a circuit analyzing tool "ApsimSPICE" which corresponds to the circuit analyzing simulator 73, and an electromagnetic field analyzing tool "RADIA" which corresponds to the electromagnetic field analyzing simulator 75.

FIG. 25 is a circuit diagram illustrative of a modeled circuit board connected to the novel power model for the electromagnetic interference simulation in accordance with the present invention. In accordance with the foregoing descriptions, the power model for the semiconductor integrated circuit has been described. Hereinafter, the power model for the circuit board on which the semiconductor integrated circuit will be described. The modeled circuit board has the following circuit elements. A de-coupling capacitor 55 is connected between the first ands second powers. The de-coupling capacitor 55 further comprises a series connection of an equivalent series inductance 56, an equivalent capacity 57 and an equivalent series resistance 58. A power model 46 is also connected between the first and second powers 7 and 8. A first lead frame 47 and a first transmission line 53 are connected between the power model 46 and the first power 7. The first lead frame 47 further comprises a series connection of a first lead frame inductance 48 and a first lead frame resistance 49. A second lead frame 50 and a second transmission line 54 are connected between the power model 46 and the second power 8. The second lead frame 50 further comprises a series connection of a second lead frame inductance 51 and a second lead frame resistance 52. The de-coupling capacitor 55 contributes to suppress the electromagnetic interference. The above circuit board model allows more accurate electromagnetic interference simulation.

FIG. 26 is a circuit diagram illustrative of a modeled semiconductor integrated circuit for the electromagnetic interference simulation in accordance with the present invention. The modeled semiconductor integrated circuit has the following circuit elements. A power model 46 is also connected between the first and second powers 7 and 8. A de-coupling capacitor 59 is connected between the first ands second powers 7 and 8. The de-coupling capacitor 59 further comprises a series connection of an equivalent series inductance 60, an equivalent capacity 61 and an equivalent series resistance 62. The de-coupling capacitor 59 contributes to suppress the electromagnetic interference. The above semiconductor integrated circuit model allows more accurate electromagnetic interference simulation.

FIG. 27 is a diagram illustrative of variations in currents over frequency to show frequency spectrums which has been transformed by Fouriertransform from a current waveform which represents variation in current over time at a fixed point of a circuit board, wherein ● represents an actually measured value, whilst ○ represents an analyzed value. The analysis was made by use of the design support system shown in FIG. 23 and the simulator shown in FIG. 24. The actual measurement was made by use of a magnetic probe positioned at the same point as the analysis. From FIG. 27, it is understood that the analyzed values are close to the actually measured value and the above novel power model of the present invention is usable in the light of the accuracy in the analysis.

Whereas modifications of the present invention will be apparent to a person having ordinary skill in the art, to which the invention pertains, it is to be understood that embodiments as shown and described by way of illustrations are by no means intended to be considered in a limiting sense. Accordingly, it is to be intended to cover by claims all modifications which fall within the spirit and scope of the present invention.

## Claims

1. A power model for a semiconductor integrated circuit,
characterized in that said power model comprises a logic gate circuit part representing an operating part of said semiconductor integrated circuit and an equivalent internal capacitive part representing a non-operating part of said semiconductor integrated circuit.

2. The power model as claimed in claim 1, characterized in that said power model is independently provided for each of plural power systems which are independent from each other and included in said semiconductor integrated circuit.

3. The power model as claimed in claim 1, characterized in that internal circuit configurations of said semiconductor integrated circuit are divided into plural blocks on the basis of arrangement informations, and said power model is provided for each of said plural blocks.

4. The power model as claimed in claim 1, characterized in that internal circuit configurations of said semiconductor integrated circuit are divided into plural groups, each of said plural groups comprises a same timing group which includes logic gate circuits having individual signal transmission delay times fallen in a group-belonging predetermined time range which belongs to each of said plural groups, and said power model is provided for each of said plural groups.

5. The power model as claimed in claim 1, characterized in that said power model further comprises a signal source connected to said logic gate circuit part for supplying a frequency-fixed signal to said logic gate circuit part, so that said logic gate circuit part represents operating state parts of said semiconductor integrated circuit in accordance with said frequency-fixed signal, and said equivalent internal capacitive part represents non-operating state parts of said semiconductor integrated circuit.

6. The power model as claimed in claim 5, characterized in that said equivalent internal capacitive part further represents operating-irrelevant fixed parts of said semiconductor integrated circuit.

7. The power model as claimed in claim 6, characterized in that said logic gate circuit part is connected between first and second powers, and said equivalent internal capacitive part is also connected between said first and second powers.

8. The power model as claimed in claim 7, characterized in that said logic gate circuit part further comprises a single pair of an inverter circuit and a load capacitive element, and said inverter circuit is connected between said first and second powers and said load capacitive element is also connected between said first and second powers, and said load capacitive element is placed between said inverter circuit and said equivalent internal capacitive part.

9. The power model as claimed in claim 8, characterized in that said load capacitive element comprises a series connection of a first load capacitance and a second load capacitance between said first and second powers, and an intermediate point between said first and second load capacitances is connected to an output terminal of said inverter circuit.

10. The power model as claimed in claim 9, characterized in that said equivalent internal capacitive part further comprises at least an equivalent internal capacitive element connected between said first and second powers.

11. The power model as claimed in claim 10, characterized in that a plurality of said equivalent internal capacitive element is connected between said first and second powers, and said equivalent internal capacitive element comprises a series connection of a capacitance and a resistance between said first and second powers.

12. The power model as claimed in claim 11, characterized in that said inverter circuit comprises a series connection of a p-channel MOS field effect transistor and an n-channel MOS field effect transistor, and gate electrodes of said p-channel and n-channel MOS field effect transistors are connected to a clock signal source for applying a clock signal to said gate electrodes of said p-channel and n-channel MOS field effect transistors.

13. The power model as claimed in claim 7, characterized in that said logic gate circuit part further comprises plural pairs of an inverter circuit and a load capacitive element, and said inverter circuit is connected between said first and second powers and said load capacitive element is also connected between said first and second powers, and in each pair, said load capacitive element is placed closer to said equivalent internal capacitive part than said inverter circuit.

14. The power model as claimed in claim 13, characterized in that said load capacitive element comprises a series connection of a first load capacitance and a second load capacitance between said first and second powers, and an intermediate point between said first and second load capacitances is connected to an output terminal of said inverter circuit.

15. The power model as claimed in claim 14, characterized in that said equivalent internal capacitive part further comprises at least an equivalent internal capacitive element connected between said first and second powers.

16. The power model as claimed in claim 15, characterized in that a plurality of said equivalent internal capacitive element is connected between said first and second powers, and said equivalent internal capacitive element comprises a series connection of a capacitance and a resistance between said first and second powers.

17. The power model as claimed in claim 16, characterized in that said inverter circuit comprises a series connection of a p-channel MOS field effect transistor and an n-channel MOS field effect transistor, and gate electrodes of said p-channel and n-channel MOS field effect transistors are connected to a clock signal source for applying a clock signal to said gate electrodes of said p-channel and n-channel MOS field effect transistors.

18. The power model as claimed in claim 1, characterized in that said equivalent internal capacitive part is placed between said logic gate circuit part and a power system side.

19. The power model as claimed in claim 1, characterized in that said power model is deigned for simulation to a current distribution over a circuit board on which said semiconductor integrated circuit is mounted.

20. The power model as claimed in claim 19, characterized in that said power model is deigned for an electro-magnetic interference simulation to an electromagnetic field distribution over a circuit board on which said semiconductor integrated circuit is mounted.

21. A method of designing a power model for a semiconductor integrated circuit, and said power model comprising a logic gate circuit part and an equivalent internal capacitive part,
characterized in that operating-related informations of all gate circuits constituting said semiconductor integrated circuit are utilized in first sequential processes to prepare said logic gate circuit part of said power model, and
characterized in that non-operating-related informations of said all gate circuits constituting said semiconductor integrated circuit are utilized in second sequential processes separated from said first sequential processes to prepare said equivalent internal capacitive part of said power model.

22. The method as claimed in claim 21, characterized in that, in said first sequential processes, informations about gate widths of operating-state p-channel transistors in said operating-state of said constituting gate circuits are utilized to decide a gate width of a model p-channel transistor;
informations about gate widths of operating-state n-channel transistors in said operating-state of said constituting gate circuits are utilized to decide a gate width of a model n-channel transistor;
informations about gate capacities of said operating-state p-channel transistors in said operating-state of said constituting gate circuits and about interconnection capacitances between said operating-state p-channel transistors and a first power are utilized to decide a model first load capacity; and
informations about gate capacities of said operating-state n-channel transistors in said operating-state of said constituting gate circuits and about interconnection capacitances between said operating-state n-channel transistors and a second power are utilized to decide a model second load capacity,
whereby said logic gate circuit part comprising at least a pair of p-channel and n-channel transistors and at least a pair of first and second load capacities is designed.

23. The method as claimed in claim 22, characterized in that a sum of gate widths of said operating-state p-channel transistors in said operating-state of said constituting gate circuits is defined to be a gate width of a model p-channel transistor;
a sum of gate widths of operating-state n-channel transistors in said operating-state of said constituting gate circuits is defined to be a gate width of a model n-channel transistor;
a sum of gate capacitances of said operating-state p-channel transistors and interconnection capacitances between said operating-state p-channel transistors and said first power is defined to be a model first load capacity; and
a sum of gate capacitances of said operating-state n-channel transistors and interconnection capacitances between said operating-state n-channel transistors and said second power is defined to be a model second load capacity,
whereby said logic gate circuit part comprising a single pair of pchannel and n-channel transistors and a single pair of first and second load capacities is designed.

24. The method as claimed in claim 22, characterized in that a half of a sum of gate widths of said operating-state p-channel transistors in said operating-state of said constituting gate circuits is defined to be a gate width of a model p-channel transistor;
a half of a sum of gate widths of operating-state n-channel transistors in said operating-state of said constituting gate circuits is defined to be a gate width of a model n-channel transistor;
a half of a sum of gate capacitances of said operating-state p-channel transistors and interconnection capacitances between said operating-state p-channel transistors and said first power is defined to be a model first load capacity; and
a half of a sum of gate capacitances of said operating-state n-channel transistors and interconnection capacitances between said operating-state n-channel transistors and said second power is defined to be a model second load capacity,
whereby said logic gate circuit part comprising two pairs of p-channel and n-channel transistors and two pairs of first and second load capacities is designed.

25. The method as claimed in claim 22, characterized in that a product of the number of said operating-state gate circuits and an averaged value of gate widths of said operating-state p-channel transistors in said operating-state of said constituting gate circuits is defined to be a gate width of a model p-channel transistor;
a product of the number of said operating-state gate circuits and an averaged value of gate widths of operating-state n-channel transistors in said operating-state of said constituting gate circuits is defined to be a gate width of a model n-channel transistor;
a product of the number of said operating-state gate circuits and a sum of both a first averaged value of gate capacitances of said operating-state p-channel transistors and a second averaged value of interconnection capacitances between said operating-state p-channel transistors and said first power is defined to be a model first load capacity; and
a product of the number of said operating-state gate circuits and a sum of both a first averaged value of gate capacitances of said operating-state n-channel transistors and a second averaged value of interconnection capacitances between said operating-state n-channel transistors and said second power is defined to be a model second load capacity,
whereby said logic gate circuit part comprising a single pair of pchannel and n-channel transistors and a single pair of first and second load capacities is designed.

26. The method as claimed in claim 22, characterized in that a half of a product of the number of said operating-state gate circuits and an averaged value of gate widths of said operating-state p-channel transistors in said operating-state of said constituting gate circuits is defined to be a gate width of a model p-channel transistor;
a half of a product of the number of said operating-state gate circuits and an averaged value of gate widths of operating-state n-channel transistors in said operating-state of said constituting gate circuits is defined to be a gate width of a model n-channel transistor;
a half of a product of the number of said operating-state gate circuits and a sum of both a first averaged value of gate capacitances of said operating-state p-channel transistors and a second averaged value of interconnection capacitances between said operating-state p-channel transistors and said first power is defined to be a model first load capacity; and
a half of a product of the number of said operating-state gate circuits and a sum of both a first averaged value of gate capacitances of said operating-state n-channel transistors and a second averaged value of interconnection capacitances between said operating-state n-channel transistors and said second power is defined to be a model second load capacity,
whereby said logic gate circuit part comprising two pairs of p-channel and n-channel transistors and two pairs of first and second load capacities is designed.

27. The method as claimed in claim 21, characterized in that, in said first sequential processes, informations about gate widths of all p-channel transistors of said constituting gate circuits and an information about operational rate of operating-state p-channel transistors in said operating-state are utilized to decide a gate width of a model p-channel transistor;
informations about gate widths of all n-channel transistors of said constituting gate circuits and an information about operational rate of operating-state n-channel transistors in said operating-state are utilized to decide a gate width of a model n-channel transistor;
informations about gate capacities of said all p-channel transistors of said constituting gate circuits and informations about interconnection capacitances between said all p-channel transistors and a first power and informations about said operational rate are utilized to decide a model first load capacity; and
informations about gate capacities of said all n-channel transistors of said constituting gate circuits and informations about interconnection capacitances between said all n-channel transistors and a second power and informations about said operational rate are utilized to decide a model second load capacity,
whereby said logic gate circuit part comprising at least a pair of p-channel and n-channel transistors and at least a pair of first and second load capacities is designed.

28. The method as claimed in claim 27, characterized in that a product of the number of said all gate circuits, an average operational rate of said gate circuits, and an averaged value of gate widths of said all p-channel transistors in said all of said constituting gate circuits is defined to be a gate width of a model p-channel transistor;
a product of the number of said all gate circuits, an average operational rate of said gate circuits, and an averaged value of gate widths of all n-channel transistors in said all of said constituting gate circuits is defined to be a gate width of a model n-channel transistor;
a product of the number of said all gate circuits, an average operational rate of said gate circuits, and a sum of both a first averaged value of gate capacitances of said all p-channel transistors and a second averaged value of interconnection capacitances between said all p-channel transistors and said first power is defined to be a model first load capacity; and
a product of the number of said all gate circuits, an average operational rate of said gate circuits, and a sum of both a first averaged value of gate capacitances of said all n-channel transistors and a second averaged value of interconnection capacitances between said all n-channel transistors and said second power is defined to be a model second load capacity,
whereby said logic gate circuit part comprising a single pair of pchannel and n-channel transistors and a single pair of first and second load capacities is designed.

29. The method as claimed in claim 27, characterized in that a half of a product of the number of said all gate circuits, an average operational rate of said gate circuits, and an averaged value of gate widths of said all p-channel transistors in said all of said constituting gate circuits is defined to be a gate width of a model p-channel transistor;
a half of a product of the number of said all gate circuits, an average operational rate of said gate circuits, and an averaged value of gate widths of all n-channel transistors in said all of said constituting gate circuits is defined to be a gate width of a model n-channel transistor;
a half of a product of the number of said all gate circuits, an average operational rate of said gate circuits, and a sum of both a first averaged value of gate capacitances of said all p-channel transistors and a second averaged value of interconnection capacitances between said all p-channel transistors and said first power is defined to be a model first load capacity; and
a half of a product of the number of said all gate circuits, an average operational rate of said gate circuits, and a sum of both a first averaged value of gate capacitances of said all n-channel transistors and a second averaged value of interconnection capacitances between said all n-channel transistors and said second power is defined to be a model second load capacity,
whereby said logic gate circuit part comprising two pairs of p-channel and n-channel transistors and two pairs of first and second load capacities is designed.

30. The method as claimed in claim 27, characterized in that a product of the number of said all gate circuits, a maximum operational rate of said gate circuits, and an averaged value of gate widths of said all p-channel transistors in said all of said constituting gate circuits is defined to be a gate width of a model p-channel transistor;
a product of the number of said all gate circuits, said maximum operational rate of said gate circuits, and an averaged value of gate widths of all n-channel transistors in said all of said constituting gate circuits is defined to be a gate width of a model n-channel transistor;
a product of the number of said all gate circuits, said maximum operational rate of said gate circuits, and a sum of both a first averaged value of gate capacitances of said all p-channel transistors and a second averaged value of interconnection capacitances between said all p-channel transistors and said first power is defined to be a model first load capacity; and
a product of the number of said all gate circuits, said maximum operational rate of said gate circuits, and a sum of both a first averaged value of gate capacitances of said all n-channel transistors and a second averaged value of interconnection capacitances between said all n-channel transistors and said second power is defined to be a model second load capacity,
whereby said logic gate circuit part comprising a single pair of pchannel and n-channel transistors and a single pair of first and second load capacities is designed.

31. The method as claimed in claim 27, characterized in that a half of a product of the number of said all gate circuits, a maximum operational rate of said gate circuits, and an averaged value of gate widths of said all p-channel transistors in said all of said constituting gate circuits is defined to be a gate width of a model p-channel transistor;
a half of a product of the number of said all gate circuits, said maximum operational rate of said gate circuits, and an averaged value of gate widths of all n-channel transistors in said all of said constituting gate circuits is defined to be a gate width of a model n-channel transistor;
a half of a product of the number of said all gate circuits, said maximum operational rate of said gate circuits, and a sum of both a first averaged value of gate capacitances of said all p-channel transistors and a second averaged value of interconnection capacitances between said all p-channel transistors and said first power is defined to be a model first load capacity; and
a half of a product of the number of said all gate circuits, said maximum operational rate of said gate circuits, and a sum of both a first averaged value of gate capacitances of said all n-channel transistors and a second averaged value of interconnection capacitances between said all n-channel transistors and said second power is defined to be a model second load capacity,
whereby said logic gate circuit part comprising two pairs of p-channel and n-channel transistors and two pairs of first and second load capacities is designed.

32. The method as claimed in claim 21, characterized in that, in said first sequential processes, informations about gate widths of all p-channel transistors of said constituting gate circuits and informations about currents of basic gate circuits and said constituting gate circuits are utilized to decide a gate width of a model p-channel transistor;
informations about gate widths of all n-channel transistors of said constituting gate circuits and informations about currents of basic gate circuits and said constituting gate circuits are utilized to decide a gate width of a model n-channel transistor;
informations about gate capacities of said all p-channel transistors of said constituting gate circuits and informations about interconnection capacitances between said all p-channel transistors and a first power and informations about currents of basic gate circuits and said constituting gate circuits are utilized to decide a model first load capacity; and
informations about gate capacities of said all n-channel transistors of said constituting gate circuits and informations about interconnection capacitances between said all n-channel transistors and a second power and informations about currents of basic gate circuits and said constituting gate circuits are utilized to decide a model second load capacity,
whereby said logic gate circuit part comprising at least a pair of p-channel and n-channel transistors and at least a pair of first and second load capacities is designed.

33. The method as claimed in claim 32, characterized in that a product of the number of said all gate circuits, and a power current ratio of an averaged current value of said basic gate circuits to an averaged current value of said constituting gate circuits, and an averaged value of gate widths of said all p-channel transistors in said all of said constituting gate circuits is defined to be a gate width of a model p-channel transistor;
a product of the number of said all gate circuits, said power current ratio, and an averaged value of gate widths of all n-channel transistors in said all of said constituting gate circuits is defined to be a gate width of a model n-channel transistor;
a product of the number of said all gate circuits, said power current ratio, and a sum of both a first averaged value of gate capacitances of said all p-channel transistors and a second averaged value of interconnection capacitances between said all p-channel transistors and said first power is defined to be a model first load capacity; and
a product of the number of said all gate circuits, said power current ratio, and a sum of both a first averaged value of gate capacitances of said all n-channel transistors and a second averaged value of interconnection capacitances between said all n-channel transistors and said second power is defined to be a model second load capacity,
whereby said logic gate circuit part comprising a single pair of pchannel and n-channel transistors and a single pair of first and second load capacities is designed.

34. The method as claimed in claim 32, characterized in that a half of a product of the number of said all gate circuits, and a power current ratio of an averaged current value of said basic gate circuits to an averaged current value of said constituting gate circuits, and an averaged value of gate widths of said all p-channel transistors in said all of said constituting gate circuits is defined to be a gate width of a model p-channel transistor;
a half of a product of the number of said all gate circuits, said power current ratio, and an averaged value of gate widths of all n-channel transistors in said all of said constituting gate circuits is defined to be a gate width of a model n-channel transistor;
a half of a product of the number of said all gate circuits, said power current ratio, and a sum of both a first averaged value of gate capacitances of said all p-channel transistors and a second averaged value of interconnection capacitances between said all p-channel transistors and said first power is defined to be a model first load capacity; and
a half of a product of the number of said all gate circuits, said power current ratio, and a sum of both a first averaged value of gate capacitances of said all n-channel transistors and a second averaged value of interconnection capacitances between said all n-channel transistors and said second power is defined to be a model second load capacity,
whereby said logic gate circuit part comprising two pairs of p-channel and n-channel transistors and two pairs of first and second load capacities is designed.

35. The method as claimed in claim 21, characterized in that, in said second sequential processes, informations about ON-resistances of non-operating-state transistors in said non-operating-state of said constituting gate circuits are utilized to decide an ON-resistance of an equivalent internal capacity; and
informations about gate capacities of said non-operating-state transistors in said non-operating-state of said constituting gate circuits and about interconnection capacitances between said operating-state transistors and a power are utilized to decide said equivalent internal capacity,
whereby said equivalent internal capacitive part comprising at least said equivalent internal capacity is designed.

36. The method as claimed in claim 35, characterized in that a double of a reciprocal of a sum of reciprocals of ON-resistances of non-operating p-channel transistors in said non-operating state is defined to be an ON-resistance of a third equivalent internal capacity;
a double of a reciprocal of a sum of reciprocals of ON-resistances of non-operating n-channel transistors in said non-operating state is defined to be an ON-resistance of a second equivalent internal capacity;
an arithmetic mean of a sum of gate capacities of said non-operating p-channel transistors and a sum of interconnection capacities between said non-operating p-channel transistors and a first power is defined to be said second equivalent internal capacity; and
an arithmetic mean of a sum of gate capacities of said non-operating n-channel transistors and a sum of interconnection capacities between said non-operating n-channel transistors and a second power is defined to be said third equivalent internal capacity,
whereby said equivalent internal capacitive part comprising at least said equivalent internal capacity is designed.

37. The method as claimed in claim 35, characterized in that a double of a product of an averaged value of ON-resistances of non-operating p-channel transistors in said non-operating state and a reciprocal of the number of non-operating gate circuits is defined to be an ON-resistance of a third equivalent internal capacity;
a double of a product of an averaged value of ON-resistances of non-operating n-channel transistors in said non-operating state and a reciprocal of the number of said non-operating gate circuit is defined to be an ON-resistance of a second equivalent internal capacity;
a product of said number of said non-operating gate circuit and an arithmetic mean of an averaged value of gate capacities of said non-operating p-channel transistors and an averaged value of interconnection capacities between said non-operating p-channel transistors and a first power is defined to be said second equivalent internal capacity; and
a product of said number of said non-operating gate circuit and an arithmetic mean of an averaged value of gate capacities of said non-operating n-channel transistors and an averaged value of interconnection capacities between said non-operating n-channel transistors and a second power is defined to be said third equivalent internal capacity,
whereby said equivalent internal capacitive part comprising at least said equivalent internal capacity is designed.

38. The method as claimed in claim 21, characterized in that, in said second sequential processes, informations about an averaged value of ON-resistances of all transistors included in said constituting gate circuits and the number of non-operating gate circuits are utilized to decide an ON-resistance of an equivalent internal capacity; and
informations about an averaged value of gate capacities of said non-operating-state transistors in said non-operating-state of said constituting gate circuits, and the number of non-operating gate circuits as well as informations about an averaged value of interconnection capacitances between said operating-state transistors and a power are utilized to decide said equivalent internal capacity,
whereby said equivalent internal capacitive part comprising at least said equivalent internal capacity is designed.

39. The method as claimed in claim 38, characterized in that the number of non-operating gate circuits in said non-operating state is defined to be a product of a total number of said constituting logic gate included in said semiconductor integrated circuit and a remainder by subtracting an average operational rate from 1;
a double of a product of an averaged value of ON-resistances of non-operating p-channel transistors in said non-operating state and a reciprocal of the number of non-operating gate circuits is defined to be an ON-resistance of a third equivalent internal capacity;
a double of a product of an averaged value of ON-resistances of non-operating n-channel transistors in said non-operating state and a reciprocal of the number of said non-operating gate circuit is defined to be an ON-resistance of a second equivalent internal capacity;
a product of said number of said non-operating gate circuit and an arithmetic mean of an averaged value of gate capacities of said non-operating p-channel transistors and an averaged value of interconnection capacities between said non-operating p-channel transistors and a first power is defined to be said second equivalent internal capacity; and
a product of said number of said non-operating gate circuit and an arithmetic mean of an averaged value of gate capacities of said non-operating n-channel transistors and an averaged value of interconnection capacities between said non-operating n-channel transistors and a second power is defined to be said third equivalent internal capacity,
whereby said equivalent internal capacitive part comprising at least said equivalent internal capacity is designed.

40. The method as claimed in claim 38, characterized in that the number of non-operating gate circuits in said non-operating state is defined to be a product of a total number of said constituting logic gate included in said semiconductor integrated circuit and a remainder by subtracting a maximum operational rate from 1;
a double of a product of an averaged value of ON-resistances of non-operating p-channel transistors in said non-operating state and a reciprocal of the number of non-operating gate circuits is defined to be an ON-resistance of a third equivalent internal capacity;
a double of a product of an averaged value of ON-resistances of non-operating n-channel transistors in said non-operating state and a reciprocal of the number of said non-operating gate circuit is defined to be an ON-resistance of a second equivalent internal capacity;
a product of said number of said non-operating gate circuit and an arithmetic mean of an averaged value of gate capacities of said non-operating p-channel transistors and an averaged value of interconnection capacities between said non-operating p-channel transistors and a first power is defined to be said second equivalent internal capacity; and
a product of said number of said non-operating gate circuit and an arithmetic mean of an averaged value of gate capacities of said non-operating n-channel transistors and an averaged value of interconnection capacities between said non-operating n-channel transistors and a second power is defined to be said third equivalent internal capacity,
whereby said equivalent internal capacitive part comprising at least said equivalent internal capacity is designed.

41. The method as claimed in claim 21, characterized in that informations about an averaged value of ON-resistances of all transistors included in said constituting gate circuits and informations about currents of basic gate circuits and said constituting gate circuits are utilized to decide an ON-resistance of an equivalent internal capacity; and
informations about an averaged value of gate capacities of said non-operating-state transistors in said non-operating-state of said constituting gate circuits, and informations about currents of basic gate circuits and said constituting gate circuits as well as informations about an averaged value of interconnection capacitances between said operating-state transistors and a power are utilized to decide said equivalent internal capacity,
whereby said equivalent internal capacitive part comprising at least said equivalent internal capacity is designed.

42. The method as claimed in claim 41, characterized in that the number of non-operating gate circuits in said non-operating state is defined to be a product of the total number of the constituting gate circuits included in the semiconductor integrated circuit and a power current ratio which is defined to be a ratio of an averaged current value of all of basic gate circuits to an averaged current value of all of the constituting gate circuits;
a double of a product of an averaged value of ON-resistances of non-operating p-channel transistors in said non-operating state and a reciprocal of the number of non-operating gate circuits is defined to be an ON-resistance of a third equivalent internal capacity;
a double of a product of an averaged value of ON-resistances of non-operating n-channel transistors in said non-operating state and a reciprocal of the number of said non-operating gate circuit is defined to be an ON-resistance of a second equivalent internal capacity;
a product of said number of said non-operating gate circuit and an arithmetic mean of an averaged value of gate capacities of said non-operating p-channel transistors and an averaged value of interconnection capacities between said non-operating p-channel transistors and a first power is defined to be said second equivalent internal capacity; and
a product of said number of said non-operating gate circuit and an arithmetic mean of an averaged value of gate capacities of said non-operating n-channel transistors and an averaged value of interconnection capacities between said non-operating n-channel transistors and a second power is defined to be said third equivalent internal capacity,
whereby said equivalent internal capacitive part comprising at least said equivalent internal capacity is designed.

43. The method as claimed in claim 21, characterized in that said equivalent internal capacitive part is placed between said logic gate circuit part and a power system side.

44. The method as claimed in claim 21, characterized in that said power model is deigned for simulation to a current distribution over a circuit board on which said semiconductor integrated circuit is mounted.

45. The method as claimed in claim 44, characterized in that said power model is deigned for an electro-magnetic interference simulation to an electromagnetic field distribution over a circuit board on which said semiconductor integrated circuit is mounted.

46. A storage medium for storing a computer program for carrying out a method according to claim 21.

47. A storage medium for storing a computer program for carrying out a method according to any of claims 22 to 45.

48. A supporting system for designing a power model for a semiconductor integrated circuit, and said power model comprising a logic gate circuit part and an equivalent internal capacitive part, and said supporting system comprising:
a data base storing informations of internal circuit configurations;
a storage medium for storing informations about circuit elements and interconnections between said circuit elements of said power model as well as for storing a computer program for designing said power model;
a processor being connected to said data base and said storage medium for executing said computer program to prepare said power model; and
an output device being connected to said processor for outputting said power model prepared by said processor,
characterized in that operating-related informations of all gate circuits constituting said semiconductor integrated circuit are utilized in first sequential processes to prepare said logic gate circuit part of said power model, and
characterized in that non-operating-related informations of said all gate circuits constituting said semiconductor integrated circuit are utilized in second sequential processes separated from said first sequential processes to prepare said equivalent internal capacitive part of said power model.

49. A supporting system as claimed in claim 48 for carrying out a method according to any of claims 22 to 45.

50. The supporting system as claimed in claim 49, characterized in that said computer program further includes a first simulation program for analysis to circuits.

51. The supporting system as claimed in claim 50, characterized in that said first simulation program is to obtain a current distribution over a circuit board on which said semiconductor integrated circuit is mounted.

52. The supporting system as claimed in claim 51, characterized in that said computer program further more includes a second simulation program for analysis to electromagnetic field to obtain a distribution of electromagnetic field over said circuit board on which said semiconductor integrated circuit is mounted.

53. A simulator for simulating an electro-magnetic interference, said simulator comprising:
a circuit analyzing simulator being accessible to a first storage medium for receiving a power model for a semiconductor integrated circuit, and also being connected to a second storage medium for receiving informations about a circuit board on which said semiconductor integrated circuit is mounted, so that said circuit analyzing simulator analyzes said power model to obtain a current distribution over a circuit board on which said semiconductor integrated circuit is mounted;
an electromagnetic field analyzing simulator being accessible to said circuit analyzing simulator for receiving said current distribution, so that said electromagnetic field analyzing simulator analyzes an electromagnetic field distribution over said circuit board on which said semiconductor integrated circuit is mounted,
characterized in that said power model comprises a logic gate circuit part representing an operating part of said semiconductor integrated circuit and an equivalent internal capacitive part representing a non-operating part of said semiconductor integrated circuit.

54. The simulator as claimed in claim 53, characterized in that said power model is independently provided for each of plural power systems which are independent from each other and included in said semiconductor integrated circuit.

55. The simulator as claimed in claim 53, characterized in that internal circuit configurations of said semiconductor integrated circuit are divided into plural blocks on the basis of arrangement informations, and said power model is provided for each of said plural blocks.

56. The simulator as claimed in claim 53, characterized in that internal circuit configurations of said semiconductor integrated circuit are divided into plural groups, each of said plural groups comprises a same timing group which includes logic gate circuits having individual signal transmission delay times fallen in a group-belonging predetermined time range which belongs to each of said plural groups, and said power model is provided for each of said plural groups.

57. The simulator as claimed in claim 53, characterized in that said power model further comprises a signal source connected to said logic gate circuit part for supplying a frequency-fixed signal to said logic gate circuit part, so that said logic gate circuit part represents operating state parts of said semiconductor integrated circuit in accordance with said frequency-fixed signal, and said equivalent internal capacitive part represents non-operating state parts of said semiconductor integrated circuit.

58. The simulator as claimed in claim 57, characterized in that said equivalent internal capacitive part further represents operating-irrelevant fixed parts of said semiconductor integrated circuit.

59. The simulator as claimed in claim 58, characterized in that said logic gate circuit part is connected between first and second powers, and said equivalent internal capacitive part is also connected between said first and second powers.

60. The simulator as claimed in claim 59, characterized in that said logic gate circuit part further comprises a single pair of an inverter circuit and a load capacitive element, and said inverter circuit is connected between said first and second powers and said load capacitive element is also connected between said first and second powers, and said load capacitive element is placed between said inverter circuit and said equivalent internal capacitive part.

61. The simulator as claimed in claim 60, characterized in that said load capacitive element comprises a series connection of a first load capacitance and a second load capacitance between said first and second powers, and an intermediate point between said first and second load capacitances is connected to an output terminal of said inverter circuit.

62. The simulator as claimed in claim 61, characterized in that said equivalent internal capacitive part further comprises at least an equivalent internal capacitive element connected between said first and second powers.

63. The simulator as claimed in claim 62, characterized in that a plurality of said equivalent internal capacitive element is connected between said first and second powers, and said equivalent internal capacitive element comprises a series connection of a capacitance and a resistance between said first and second powers.

64. The simulator as claimed in claim 63, characterized in that said inverter circuit comprises a series connection of a p-channel MOS field effect transistor and an n-channel MOS field effect transistor, and gate electrodes of said p-channel and n-channel MOS field effect transistors are connected to a clock signal source for applying a clock signal to said gate electrodes of said p-channel and n-channel MOS field effect transistors.

65. The simulator as claimed in claim 59, characterized in that said logic gate circuit part further comprises plural pairs of an inverter circuit and a load capacitive element, and said inverter circuit is connected between said first and second powers and said load capacitive element is also connected between said first and second powers, and in each pair, said load capacitive element is placed closer to said equivalent internal capacitive part than said inverter circuit.

66. The simulator as claimed in claim 65, characterized in that said load capacitive element comprises a series connection of a first load capacitance and a second load capacitance between said first and second powers, and an intermediate point between said first and second load capacitances is connected to an output terminal of said inverter circuit.

67. The simulator as claimed in claim 66, characterized in that said equivalent internal capacitive part further comprises at least an equivalent internal capacitive element connected between said first and second powers.

68. The simulator as claimed in claim 67, characterized in that a plurality of said equivalent internal capacitive element is connected between said first and second powers, and said equivalent internal capacitive element comprises a series connection of a capacitance and a resistance between said first and second powers.

69. The simulator as claimed in claim 68, characterized in that said inverter circuit comprises a series connection of a p-channel MOS field effect transistor and an n-channel MOS field effect transistor, and gate electrodes of said p-channel and n-channel MOS field effect transistors are connected to a clock signal source for applying a clock signal to said gate electrodes of said p-channel and n-channel MOS field effect transistors.

70. The simulator as claimed in claim 53, characterized in that said equivalent internal capacitive part is placed between said logic gate circuit part and a power system side.
